(19) Europäisches Patentamt / European Patent Office / Office européen des brevets

(11) **EP 4 421 788 A1**

(12) **EUROPEAN PATENT APPLICATION**
published in accordance with Art. 153(4) EPC

(43) Date of publication:
**28.08.2024 Bulletin 2024/35**

(21) Application number: **22960062.2**

(22) Date of filing: **29.09.2022**

(51) International Patent Classification (IPC):
**G09G 3/32** (2016.01)          **G09F 9/33** (2006.01)

(52) Cooperative Patent Classification (CPC):
**G09F 9/33; G09G 3/32**

(86) International application number:
**PCT/CN2022/122729**

(87) International publication number:
**WO 2024/065425 (04.04.2024 Gazette 2024/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **BOE Technology Group Co., Ltd.**
  **Chaoyang District,**
  **Beijing 100015 (CN)**
• **Chengdu BOE Optoelectronics Technology Co., Ltd.**
  **Chengdu, Sichuan 611731 (CN)**

(72) Inventors:
• **FANG, Fei**
  **Beijing 100176 (CN)**
• **LIU, Ke**
  **Beijing 100176 (CN)**
• **GUO, Dan**
  **Beijing 100176 (CN)**
• **JING, Yangzhong**
  **Beijing 100176 (CN)**
• **PENG, Bo**
  **Beijing 100176 (CN)**
• **HAN, Ting**
  **Beijing 100176 (CN)**
• **SHI, Ling**
  **Beijing 100176 (CN)**
• **ZENG, Jiayuan**
  **Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE AND DISPLAY DEVICE**

(57)     A display substrate and a display device. The display substrate comprises: a display area (AA), the display area (AA) comprising a light-transmitting display area (A1). The display substrate comprises: a plurality of light-emitting elements and a plurality of pixel circuits, wherein the plurality of light-emitting elements comprise a plurality of first-type light-emitting elements (L1) located in the light-transmitting display area (A1), the plurality of pixel circuits comprise a plurality of first-type pixel circuits (P1) located in the light-transmitting display area (A1), at least one first-type pixel circuit (P1) of the plurality of first-type pixel circuits (P1) is electrically connected to at least two first-type light-emitting elements (L1) that emit light of the same color, and the first-type pixel circuit (P1) is configured to drive the at least two first-type light-emitting elements (L1) to emit light; and the orthographic projection of the at least one first-type pixel circuit (P1) on a substrate overlaps with the orthographic projection of at least one first-type light-emitting element (L1) on the substrate.

FIG. 4

**Description**

Technical Field

The present disclosure relates to, but is not limited to, the field of display technologies, and more particularly, to a display substrate and a display apparatus.

Background

An Organic Light Emitting Diode (OLED) and a Quantum dot Light Emitting Diode (QLED) are active light emitting display devices and have advantages of self-luminescence, a wide viewing angle, a high contrast ratio, low power consumption, an extremely high response speed, lightness and thinness, bendability, and a low cost, etc. An under display camera technology is a brand-new technology proposed to increase a screen-to-body ratio of a display apparatus.

Summary

The following is a summary of subject matters described herein in detail. The summary is not intended to limit the scope of protection of claims.

In a first aspect, the present disclosure provides a display substrate, the display substrate includes a display region and a peripheral region at least partially surrounding the display region, the display region includes a light-transmitting display region and a conventional display region located on at least one side of the light-transmitting display region, and a light transmittance of the light-transmitting display region is greater than a light transmittance of the conventional display region; the display substrate includes a base substrate, and multiple light emitting elements and multiple pixel circuits located on one side of the base substrate, the multiple light emitting elements include multiple first type light emitting elements located in the light-transmitting display region, the multiple pixel circuits include multiple first type pixel circuits located in the light-transmitting display region, at least one first type pixel circuit among the multiple first type pixel circuits is electrically connected with at least two first type light emitting elements emitting light of a same color, and the first type pixel circuit is configured to drive the at least two first type light emitting elements to emit light; an orthographic projection of the at least one first type pixel circuit on the base substrate is overlapped with an orthographic projection of the at least one first type light emitting element on the base substrate.

In an exemplary implementation mode, the orthographic projection of the at least one first type pixel circuit on the base substrate is overlapped with an orthographic projection of at least partial first type light emitting element in at least two first type light emitting elements electrically connected with the at least one first type pixel circuit on the base substrate.

In an exemplary implementation mode, multiple first signal lines are further included, and the at least one first type pixel circuit is electrically connected with at least one first signal line; the multiple first signal lines include at least one of following: a scan signal line, a reset signal line, an initial signal line, and a light emitting signal line.

In an exemplary implementation mode, the multiple first signal lines include: multiple sub-signal lines; adjacent sub-signal lines of the first signal line are electrically connected through the first type pixel circuit electrically connected.

In an exemplary implementation mode, multiple second signal lines are further included, and the at least one first type pixel circuit is electrically connected with at least one second signal line; the multiple second signal lines include at least one of following: a data signal line and a first power supply line, the multiple data signal lines and the multiple first power supply lines extend along a first direction; a data signal line and a first power supply line electrically connected with the first type pixel circuit are located between adjacent sub-signal lines of the first signal line, and orthographic projections of the data signal line and the first power supply line electrically connected with the first type pixel circuit on the base substrate are overlapped with an orthographic projection of the first type pixel circuit on the base substrate.

In an exemplary implementation mode, an orthographic projection of at least one of the scan signal line, the reset signal line, the initial signal line, the light emitting signal line, the data signal line, and the first power supply line on the base substrate is partially overlapped with an orthographic projection of the first type light emitting element on the base substrate.

In an exemplary implementation mode, the multiple first type light emitting elements at least include multiple first light emitting elements emitting light of a first color, multiple second light emitting elements emitting light of a second color, and multiple third light emitting elements emitting light of a third color; an anode area of at least one first light emitting element among the multiple first light emitting elements is greater than an anode area of at least one third light emitting element among the multiple third light emitting elements, an anode area of at least one second light emitting element among the multiple second light emitting elements is greater than the anode area of the at least one third light emitting element, and an anode area of at least one second light emitting element among the multiple second light emitting elements is greater than an anode area of at least one first light emitting element among the multiple first light emitting elements; the light of the first color is red light, the light of the second color is blue light, and the light of the third color is green light.

In an exemplary implementation mode, the first type pixel circuit includes: multiple transistors and at least one capacitor; on a direction perpendicular to the display substrate, the light-transmitting display region at least includes a semiconductor layer, a first insulation layer, a first conductive layer, a second insulation layer, a second conductive layer, a third insulation layer, a third conductive layer, a fourth insulation layer, a transparent conductive layer, a first planarization layer, a fourth conductive layer, and a second planarization layer disposed on the base substrate; the semiconductor layer at least includes: active layers of the multiple transistors of the first type pixel circuit; the first conductive layer at least includes: control electrodes of the multiple transistors and a first electrode plate of the capacitor of the first type pixel circuit; the second conductive layer at least includes: a second electrode plate of the capacitor of the first type pixel circuit; the third conductive layer at least includes: first electrodes and second electrodes of the multiple transistors of the first type pixel circuit and multiple connection electrodes; the transparent conductive layer at least includes: multiple first signal lines, multiple second signal lines, and multiple anode connection lines; at least one anode connection line among the multiple anode connection lines is electrically connected with at least one first type pixel circuit and anodes of at least two first type light emitting elements emitting light of a same color; the at least one first type pixel circuit is electrically connected with at least one first signal line and at least one second signal line; the fourth conductive layer at least includes: multiple signal connection lines.

In an exemplary implementation mode, the multiple first type light emitting elements are arranged in a following manner: the multiple third light emitting elements are arranged in an i-th row at a certain interval, the second light emitting elements and the first light emitting elements are alternately arranged in an adjacent row of the i-th row, the first light emitting elements and the second light emitting elements are alternately arranged in a j-th column, the multiple third light emitting elements are arranged in an adjacent column of the j-th column at a certain interval, the first light emitting elements and the third light emitting elements are alternately arranged along a third direction, the second light emitting elements and the third light emitting elements are alternately arranged along a fourth direction, the third direction and the fourth direction intersects with the first direction and the second direction respectively, the first direction is a column direction, and the second direction is a row direction.

In an exemplary implementation mode, the multiple first type pixel circuits include: at least one first pixel circuit, at least one second pixel circuit, at least one third pixel circuit, and at least one fourth pixel circuit; the first pixel circuit is electrically connected with two of the first light emitting elements, the second pixel circuit is electrically connected with two of the second light emitting elements, the third pixel circuit is electrically connected with two of the third light emitting elements, the fourth pixel circuit is electrically connected with two of the third light emitting elements, and third light emitting elements electrically connected with the third pixel circuit and the fourth pixel circuit are different.

In an exemplary implementation mode, the two of the first light emitting elements electrically connected with the first pixel circuit are located in a same row, the two of the second light emitting elements electrically connected with the second pixel circuit are located in a same row, the two of the third light emitting elements electrically connected with the third pixel circuit are located in a same row, and the two of the third light emitting elements electrically connected with the fourth pixel circuit are located in a same row.

In an exemplary implementation mode, an orthographic projection of the first pixel circuit on the base substrate is partially overlapped with an orthographic projection of one of the first light emitting elements electrically connected on the base substrate; an orthographic projection of the second pixel circuit on the base substrate is partially overlapped with an orthographic projection of a first light emitting element located between two of the second light emitting elements electrically connected on the base substrate; an orthographic projection of the third pixel circuit on the base substrate is partially overlapped with an orthographic projection of a second light emitting element on the base substrate, the second light emitting element overlapped with the third pixel circuit is located in an adjacent row of a row where two of the third light emitting elements electrically connected with the third pixel circuit are located, and is located in a middle column of columns where two of the third light emitting elements electrically connected with the third pixel circuit are located; an orthographic projection of the fourth pixel circuit on the base substrate is partially overlapped with an orthographic projection of a second light emitting element on the base substrate, the second light emitting element overlapped with the fourth pixel circuit is located in an adjacent row of a row where two of the third light emitting elements electrically connected with the fourth pixel circuit are located, and is located in a middle column of columns where two of the third light emitting elements electrically connected with the fourth pixel circuit are located, and the second light emitting element overlapped with the third pixel circuit and the second light emitting element overlapped with the fourth pixel circuit are different light emitting elements.

In an exemplary implementation mode, the first signal line extends along the second direction.

The anode connection lines include: a first anode connection line, a second anode connection line, a third anode connection line, and a fourth anode connection line.

The first anode connection line is electrically connected with the first pixel circuit and the first light emitting element respectively, and at least part of the first anode connection line extends along the second direction; the second anode connection line is electrically connected with the second pixel circuit and the second light emitting element respectively, and at least part of the second anode connection line extends along the second direction; the third anode connection line is electrically connected with the third pixel circuit and the third light emitting element respectively, at least part of the third anode connection line extends along the second direction, and the third anode connection line is located between a data signal line and a first power supply line electrically connected with the third pixel circuit; the fourth anode connection line is electrically connected with the fourth pixel circuit and the third light emitting element respectively, at least part of the fourth anode connection line extends along the second direction, and the fourth anode connection line is located between a data signal line and a first power supply line electrically connected with the fourth pixel circuit.

In an exemplary implementation mode, first power supply lines electrically connected with at least two adjacent first type pixel circuits located in a same column are disposed at intervals, and the first power supply lines disposed at intervals located in the same column are electrically connected through at least one signal connection line located in the fourth conductive layer; data signal lines electrically connected with at least two adjacent first type pixel circuits located in a same column are disposed at intervals, and the data signal lines disposed at intervals located in the same column are electrically connected through at least one signal connection line located in the fourth conductive layer.

In an exemplary implementation mode, the two of the first light emitting elements electrically connected with the first pixel circuit are arranged along the third direction, the two of the second light emitting elements electrically connected with the second pixel circuit are arranged along the fourth direction, the two of the third light emitting elements electrically connected with the third pixel circuit are located in a same column, and the two of the third light emitting elements electrically connected with the fourth pixel circuit are located in a same column.

An orthographic projection of the first pixel circuit on the base substrate is partially overlapped with an orthographic projection of one of the first light emitting elements electrically connected on the base substrate.

An orthographic projection of the second pixel circuit on the base substrate is partially overlapped with an orthographic projection of one of the second light emitting elements electrically connected on the base substrate.

An orthographic projection of the third pixel circuit on the base substrate is partially overlapped with an orthographic projection of one of the third light emitting elements electrically connected on the base substrate.

An orthographic projection of the fourth pixel circuit on the base substrate is partially overlapped with an orthographic projection of one of the third light emitting elements electrically connected on the base substrate, and the third light emitting element overlapped with the third pixel circuit and the third light emitting element overlapped with the fourth pixel circuit are different light emitting elements.

In an exemplary implementation mode, the anode connection lines include: a first anode connection line, a second anode connection line, a third anode connection line, and a fourth anode connection line.

The first anode connection line is electrically connected with the first pixel circuit and the first light emitting element respectively, and at least part of the first anode connection line extends along the first direction; the second anode connection line is electrically connected with the second pixel circuit and the second light emitting element respectively, and at least part of the second anode connection line extends along the first direction; the third anode connection line is electrically connected with the third pixel circuit and the third light emitting element respectively, at least part of the third anode connection line extends along the first direction, and the third anode connection line is located on a side of a first power supply line that is electrically connected with the third pixel circuit away from a data signal line; the fourth anode connection line is electrically connected with the fourth pixel circuit and the third light emitting element respectively, at least part of the fourth anode connection line extends along the first direction, and the fourth anode connection line is located on a side of a first power supply line that is electrically connected with the fourth pixel circuit away from a data signal line.

In an exemplary implementation mode, data signal lines electrically connected with first type pixel circuits located in a same column are a same signal line, first power supply lines electrically connected with at least two adjacent first type pixel circuits located in a same column are disposed at intervals, and the first power supply lines disposed at intervals located in the same column are electrically connected through at least one signal connection line located in the fourth conductive layer.

In an exemplary implementation mode, the transparent conductive layer further includes: a power supply connection line, and at least part of the power supply connection line extends along the second direction; the power supply connection line is respectively electrically connected with first power supply lines electrically connected with two adjacent first type pixel circuits located in a same row, and the first power supply lines and the power supply connection line are electrically connected through a connection electrode located in the third conductive layer.

In an exemplary implementation mode, for a same first type pixel circuit, the first power supply line includes: a power supply main body portion extending along the first direction and a power supply connection portion extending along the second direction, the power supply connection portion is located on a side of the power supply main body portion away from the data signal line; the power supply connection line is electrically connected with a power supply connection portion of one first type pixel circuit and a power supply main body portion of the other first type pixel circuit in adjacent first type pixel circuits located in a same row respectively.

In an exemplary implementation mode, the multiple first type light emitting elements are arranged in a following manner: the multiple second light emitting elements are arranged in a j-th column, the first light emitting elements and the third light emitting elements are alternately arranged in an adjacent column of the j-th column, the multiple second light emitting elements are arranged in an i-th row, and the first light emitting elements and the third light emitting elements are disposed between adjacent second light emitting elements located in a same row.

In an exemplary implementation mode, the multiple first type pixel circuits include: at least one first pixel circuit, at least one second pixel circuit, and at least one third pixel circuit; wherein the first pixel circuit is electrically connected with two of the first light emitting elements, the second pixel circuit is electrically connected with two of the second light emitting elements, and the third pixel circuit is electrically connected with two of the third light emitting elements.

In an exemplary implementation mode, the two of the first light emitting elements electrically connected with the first pixel circuit are located in a same row, the two of the second light emitting elements electrically connected with the second pixel circuit are located in a same row, and the two of the third light emitting elements electrically connected with the third pixel circuit are located in a same row.

In an exemplary implementation mode, an orthographic projection of the first pixel circuit on the base substrate is partially overlapped with an orthographic projection of one of the first light emitting elements electrically connected on the base substrate; an orthographic projection of the second pixel circuit on the base substrate is partially overlapped with an orthographic projection of one of the second light emitting elements electrically connected on the base substrate; and an orthographic projection of the third pixel circuit on the base substrate is partially overlapped with an orthographic projection of one of the third light emitting elements electrically connected on the base substrate.

In an exemplary implementation mode, at least two of the first light emitting element overlapped with the first pixel circuit, the second light emitting element overlapped with the second pixel circuit, and the third light emitting element overlapped with the third pixel circuit are adjacent.

In an exemplary implementation mode, an orthographic projection of the first pixel circuit on the base substrate is partially overlapped with an orthographic projection of one of the first light emitting elements electrically connected on the base substrate; an orthographic projection of the second pixel circuit on the base substrate is partially overlapped with an orthographic projection of one of the second light emitting elements electrically connected on the base substrate; and an orthographic projection of the third pixel circuit on the base substrate is partially overlapped with an orthographic projection of the second light emitting element located between two of the third light emitting elements electrically connected with the third pixel circuit on the base substrate.

In an exemplary implementation mode, an orthographic projection of the first pixel circuit on the base substrate is partially overlapped with an orthographic projection of a second light emitting element located between two of the first light emitting elements electrically connected with the first pixel circuit on the base substrate; an orthographic projection of the second pixel circuit on the base substrate is partially overlapped with an orthographic projection of one of the second light emitting elements electrically connected on the base substrate; and an orthographic projection of the third pixel circuit on the base substrate is partially overlapped with an orthographic projection of one of the third light emitting elements electrically connected on the base substrate.

In an exemplary implementation mode, the anode connection lines include: a first anode connection line, a second anode connection line, and a third anode connection line; the first anode connection line is electrically connected with the first pixel circuit and the first light emitting element respectively, and at least part of the first anode connection line extends along the second direction; the second anode connection line is electrically connected with the second pixel circuit and the second light emitting element respectively, and at least part of the second anode connection line extends along the second direction; the third anode connection line is electrically connected with the third pixel circuit and the third light emitting element respectively, and at least part of the third anode connection line extends along the second direction.

In an exemplary implementation mode, data signal lines electrically connected with first type pixel circuits located in a same column are a same signal line, first power supply lines electrically connected with at least two adjacent first type pixel circuits located in a same column are disposed at intervals, and the first power supply lines disposed at intervals located in the same column are electrically connected through at least one signal connection line located in the fourth conductive layer.

In an exemplary implementation mode, the multiple light emitting elements further include multiple second type light emitting elements located in the conventional display region, and the multiple pixel circuits further include multiple second type pixel circuits located in the conventional display region; at least one second type light emitting element among the multiple second type light emitting elements is electrically connected with at least one second type pixel circuit among the multiple second type pixel circuits, and an orthographic projection of the second type light emitting element on the base substrate is overlapped with an orthographic projection of a second type pixel circuit electrically connected on the base substrate.

In a second aspect, the present disclosure also provides a display apparatus, including the above display substrate.

After drawings and detailed description are read and understood, other aspects may be comprehended.

Brief Description of Drawings

Accompanying drawings are used for providing further understanding of technical solutions of the present disclosure, constitute a part of the specification, and are used for explaining the technical solutions of the present disclosure together with embodiments of the present disclosure, but do not constitute limitations on the technical solutions of the present disclosure. Shapes and sizes of one or more components in the drawings do not reflect actual scales, and are only intended to schematically describe contents of the present disclosure.

FIG. 1 is a schematic diagram of a display substrate according to at least one embodiment of the present disclosure.

FIG. 2 is a first schematic diagram of an arrangement of a first type light emitting element in a light-transmitting display region according to at least one embodiment of the present disclosure.

FIG. 3 is a second schematic diagram of an arrangement of a first type light emitting element in a light-transmitting display region according to at least one embodiment of the present disclosure.

FIG. 4 is a first schematic diagram of an arrangement relationship of a first type pixel circuit and a first type light emitting element in a light-transmitting display region according to an exemplary embodiment.

FIG. 5 is a second schematic diagram of an arrangement relationship of a first type pixel circuit and a first type light emitting element in a light-transmitting display region according to an exemplary embodiment.

FIG. 6 is a third schematic diagram of an arrangement relationship of a first type pixel circuit and a first type light emitting element in a light-transmitting display region according to an exemplary embodiment.

FIG. 7 is a fourth schematic diagram of an arrangement relationship of a first type pixel circuit and a first type light emitting element in a light-transmitting display region according to an exemplary embodiment.

FIG. 8 is a fifth schematic diagram of an arrangement relationship of a first type pixel circuit and a first type light emitting element in a light-transmitting display region according to an exemplary embodiment.

FIG. 9 is a sixth schematic diagram of an arrangement relationship of a first type pixel circuit and a first type light emitting element in a light-transmitting display region according to an exemplary embodiment.

FIG. 10 is an equivalent circuit diagram of a first type pixel circuit.

FIG. 11 is a working timing diagram of the first type pixel circuit provided in FIG. 10.

FIG. 12 is a first partial top view of a light-transmitting display region according to an exemplary embodiment.

FIG. 13 is a second partial top view of a light-transmitting display region according to an exemplary embodiment.

FIG. 14 is a third partial top view of a light-transmitting display region according to an exemplary embodiment.

FIG. 15A is a schematic diagram of the light-transmitting display region provided in FIG. 12 after a pattern of a semiconductor is formed.

FIG. 15B is a schematic diagram of a pattern of a first conductive layer of the light-transmitting display region provided in FIG. 12.

FIG. 15C is a schematic diagram of the light-transmitting display region provided in FIG. 12 after the pattern of the first conductive layer is formed.

FIG. 15D is a schematic diagram of a pattern of a second conductive layer of the light-transmitting display region provided in FIG. 12.

FIG. 15E is a schematic diagram of the light-transmitting display region provided in FIG. 12 after the pattern of the second conductive layer is formed.

FIG. 15F is a schematic diagram of the light-transmitting display region provided in FIG. 12 after a pattern of a third insulation layer is formed.

FIG. 15G is a schematic diagram of a pattern of a third conductive layer of the light-transmitting display region provided in FIG. 12.

FIG. 15H is a schematic diagram of the light-transmitting display region provided in FIG. 12 after the pattern of the third conductive layer is formed.

FIG. 151 is a schematic diagram of the light-transmitting display region provided in FIG. 12 after a pattern of a fourth insulation layer is formed.

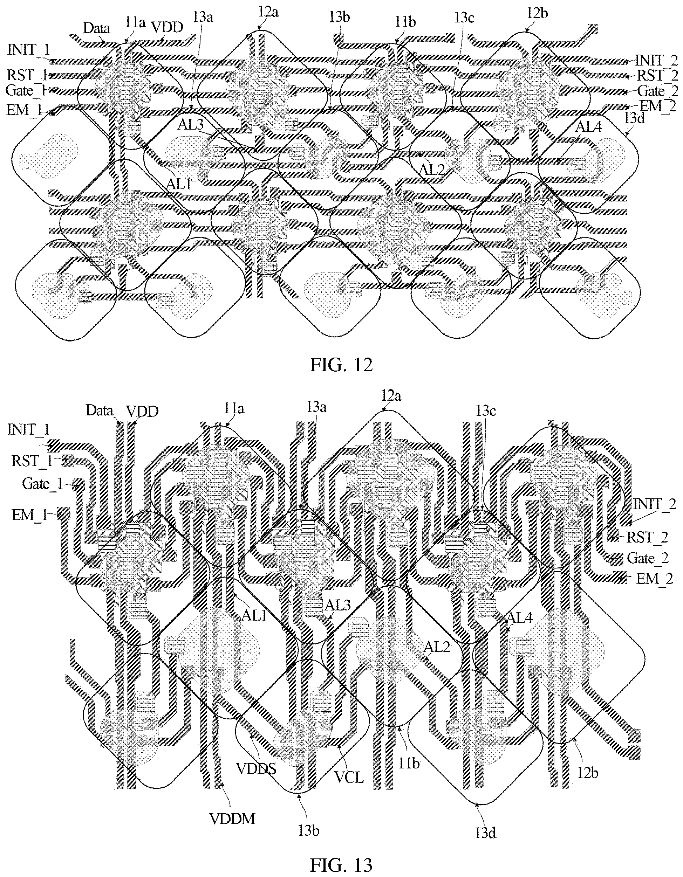

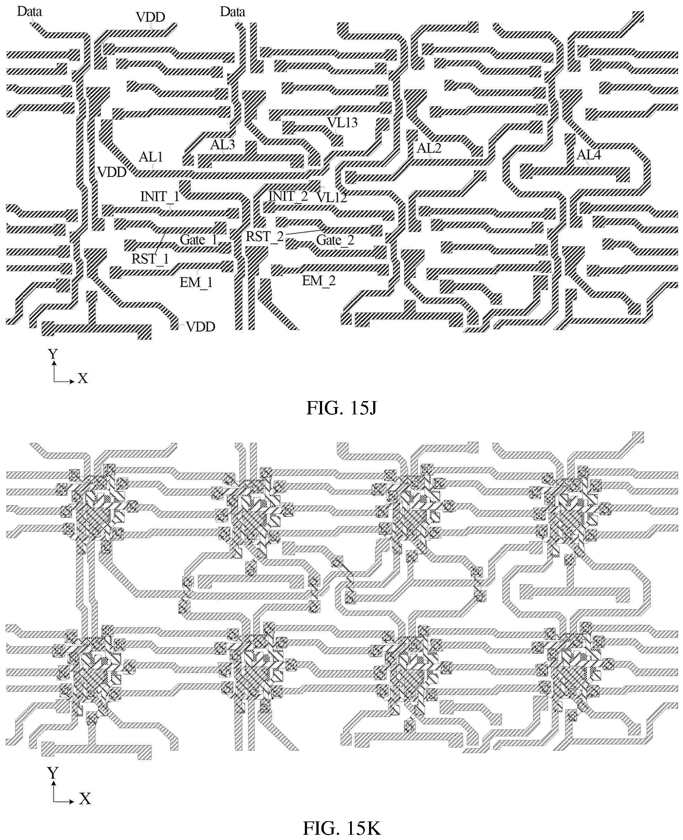

FIG. 15J is a schematic diagram of a pattern of a transparent conductive layer of the light-transmitting display region provided in FIG. 12.

FIG. 15K is a schematic diagram of the light-transmitting display region provided in FIG. 12 after a pattern of a transparent conductive layer is formed.

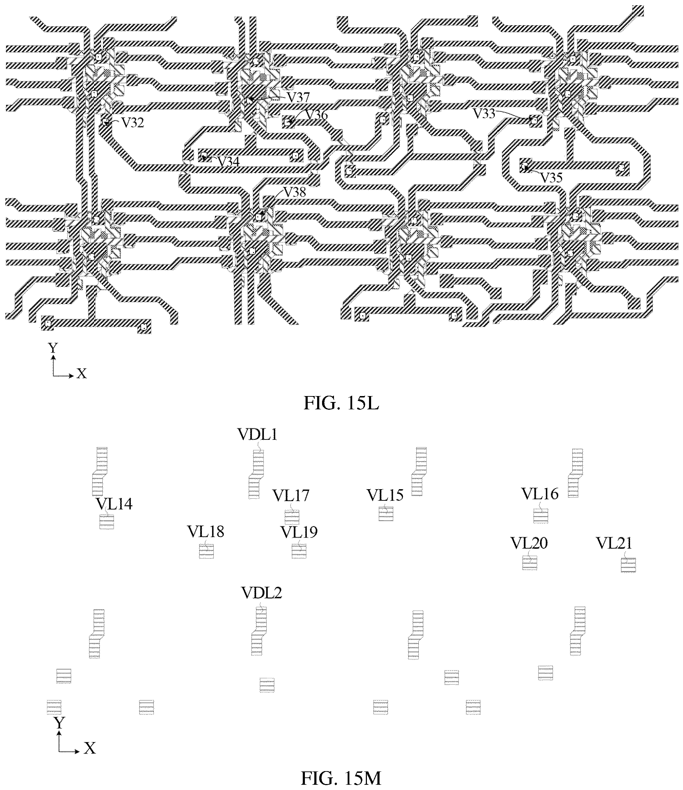

FIG. 15L is a schematic diagram of the light-transmitting display region provided in FIG. 12 after a first planarization layer is formed.

FIG. 15M is a schematic diagram of a pattern of a fourth conductive layer of the light-transmitting display region provided in FIG. 12.

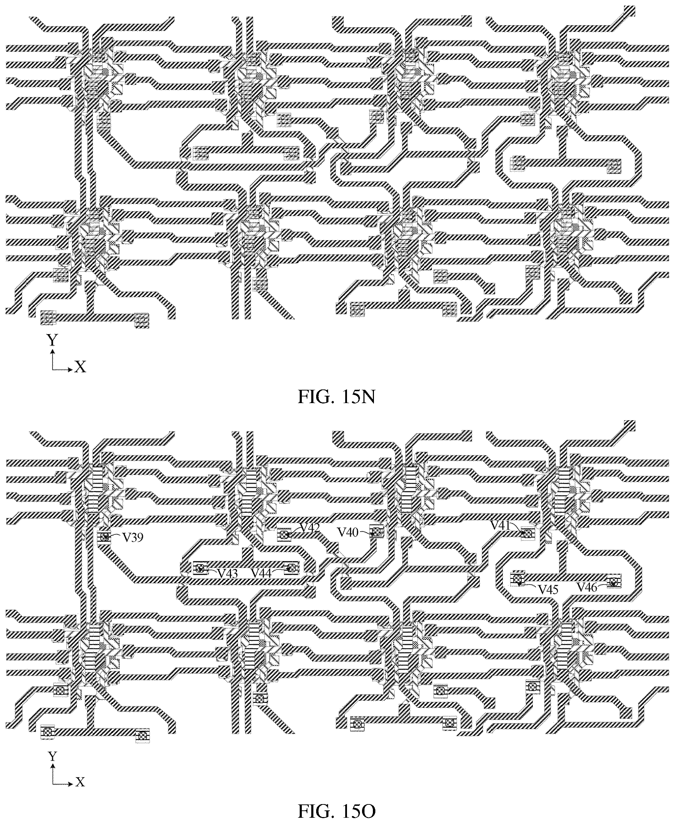

FIG. 15N is a schematic diagram of the light-transmitting display region provided in FIG. 12 after the pattern of the fourth conductive layer is formed.

FIG. 15O is a schematic diagram of the light-transmitting display region provided in FIG. 12 after a pattern of a second planarization layer is formed.

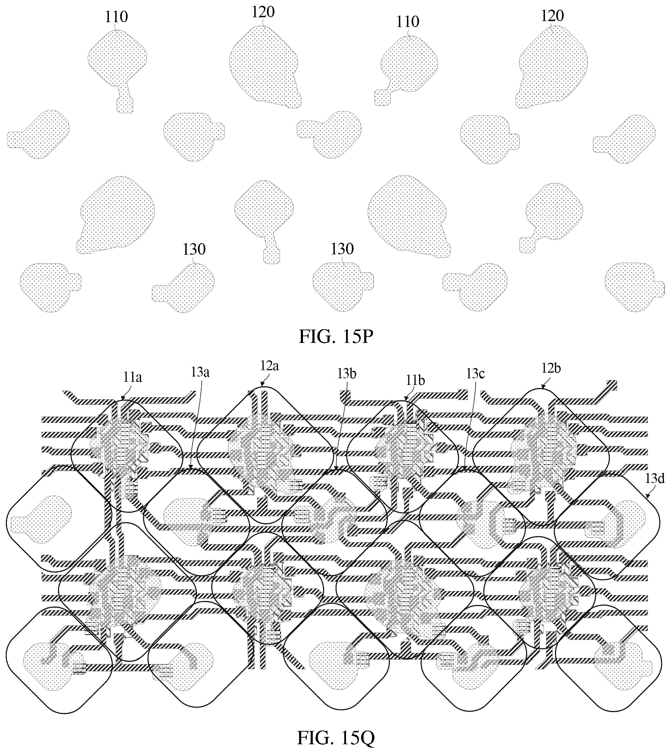

FIG. 15P is a schematic diagram of a pattern of an anode conductive layer of the light-transmitting display region provided in FIG. 12.

FIG. 15Q is a schematic diagram of the light-transmitting display region provided in FIG. 12 after the pattern of the anode conductive layer is formed.

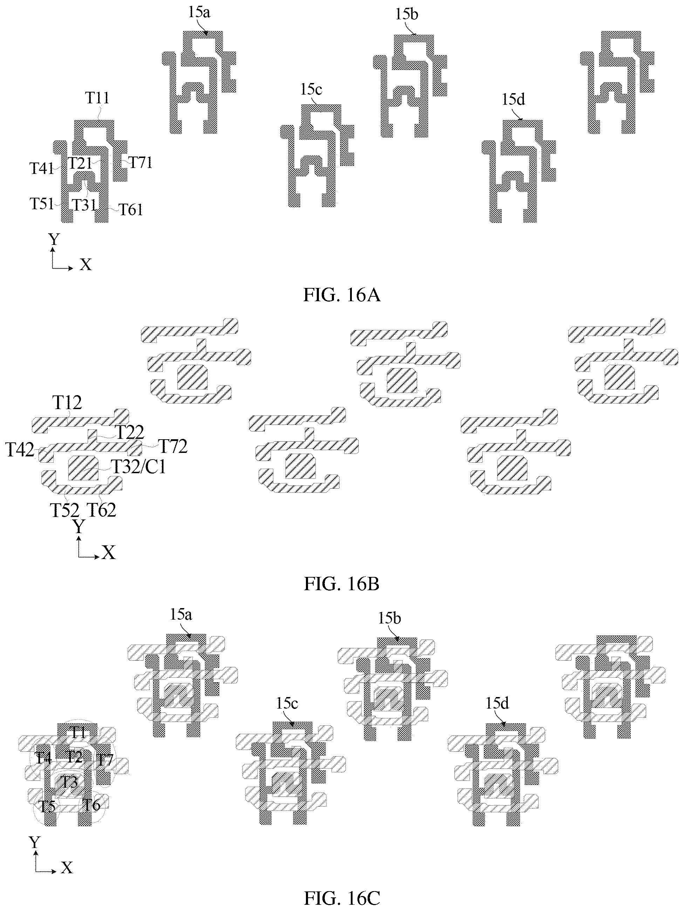

FIG. 16A is a schematic diagram of the light-transmitting display region provided in FIG. 13 after a pattern of a semiconductor is formed.

FIG. 16B is a schematic diagram of a pattern of a first conductive layer of the light-transmitting display region provided in FIG. 13.

FIG. 16C is a schematic diagram of the light-transmitting display region provided in FIG. 13 after the pattern of the first conductive layer is formed.

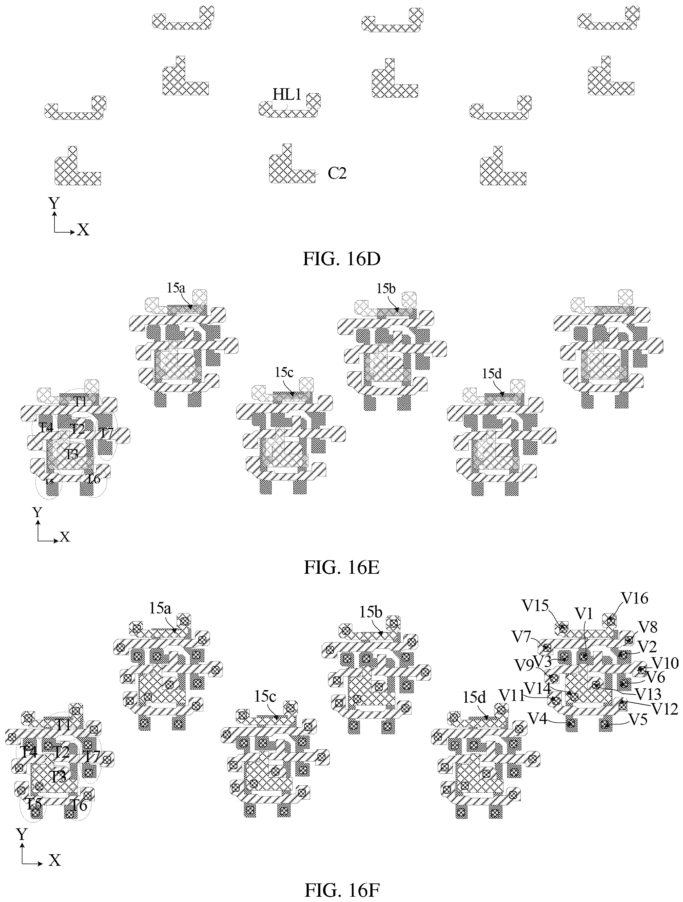

FIG. 16D is a schematic diagram of a pattern of a second conductive layer of the light-transmitting display region provided in FIG. 13.

FIG. 16E is a schematic diagram of the light-transmitting display region provided in FIG. 13 after the pattern of the second conductive layer is formed.

FIG. 16F is a schematic diagram of the light-transmitting display region provided in FIG. 13 after a pattern of a third insulation layer is formed.

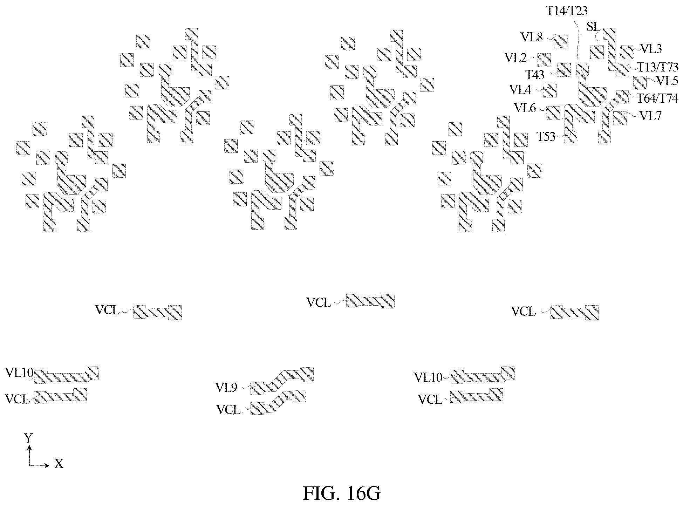

FIG. 16G is a schematic diagram of a pattern of a third conductive layer of the light-transmitting display region provided in FIG. 13.

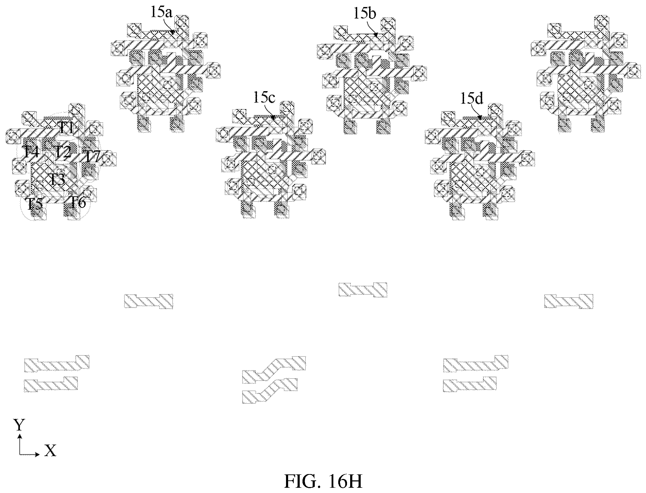

FIG. 16H is a schematic diagram of the light-transmitting display region provided in FIG. 13 after the pattern of the third conductive layer is formed.

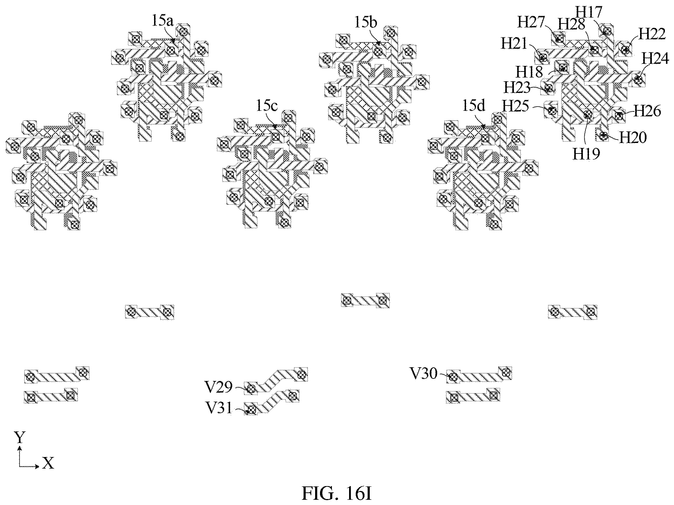

FIG. 16I is a schematic diagram of the light-transmitting display region provided in FIG. 13 after a pattern of a fourth insulation layer is formed.

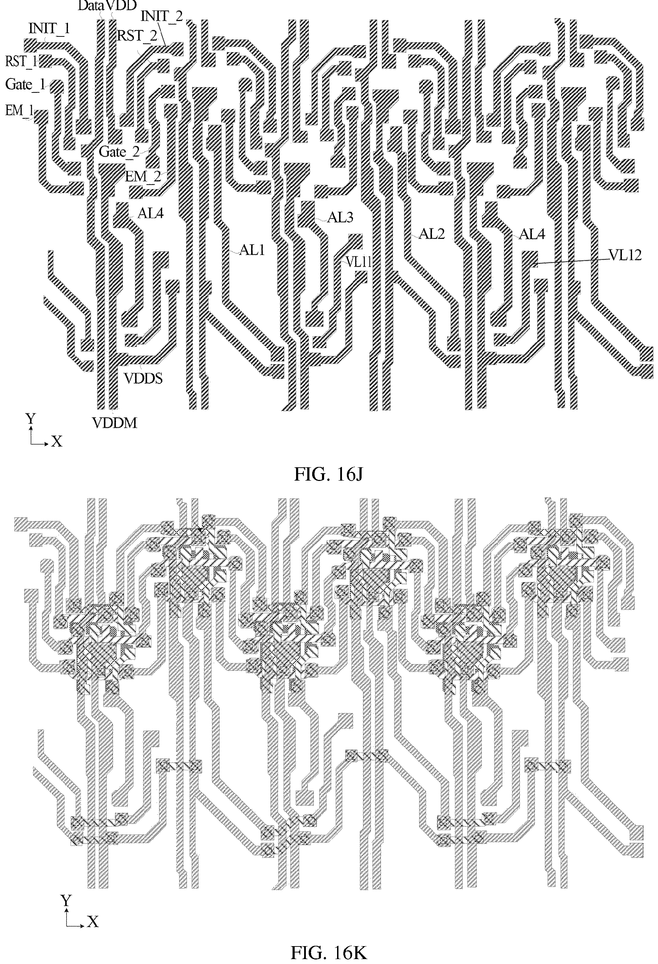

FIG. 16J is a schematic diagram of a pattern of a transparent conductive layer of the light-transmitting display region provided in FIG. 13.

FIG. 16K is a schematic diagram of the light-transmitting display region provided in FIG. 13 after the pattern of the transparent conductive layer is formed.

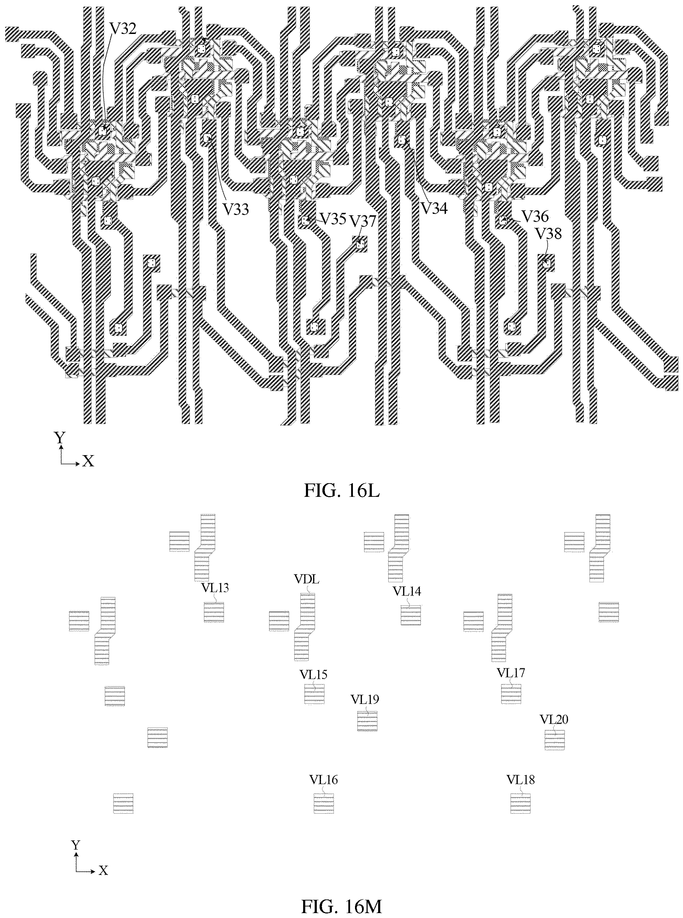

FIG. 16L is a schematic diagram of the light-transmitting display region provided in FIG. 13 after a first planarization layer is formed.

FIG. 16M is a schematic diagram of a pattern of a fourth conductive layer of the light-transmitting display region provided in FIG. 13.

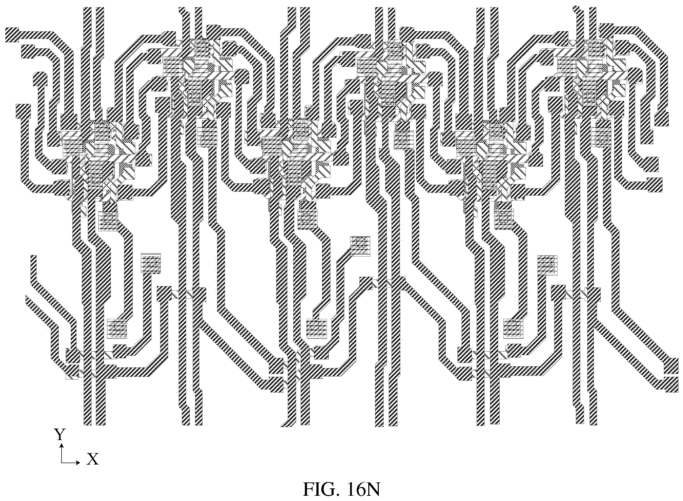

FIG. 16N is a schematic diagram of the light-transmitting display region provided in FIG. 13 after the pattern of the fourth conductive layer is formed.

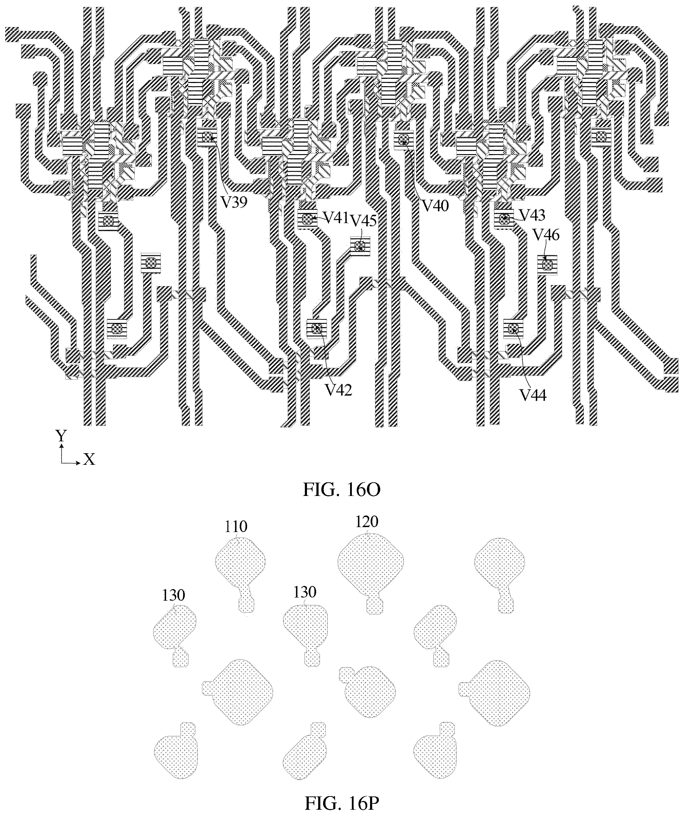

FIG. 16O is a schematic diagram of the light-transmitting display region provided in FIG. 13 after a pattern of a second planarization layer is formed.

FIG. 16P is a schematic diagram of a pattern of an anode conductive layer of the light-transmitting display region provided in FIG. 13.

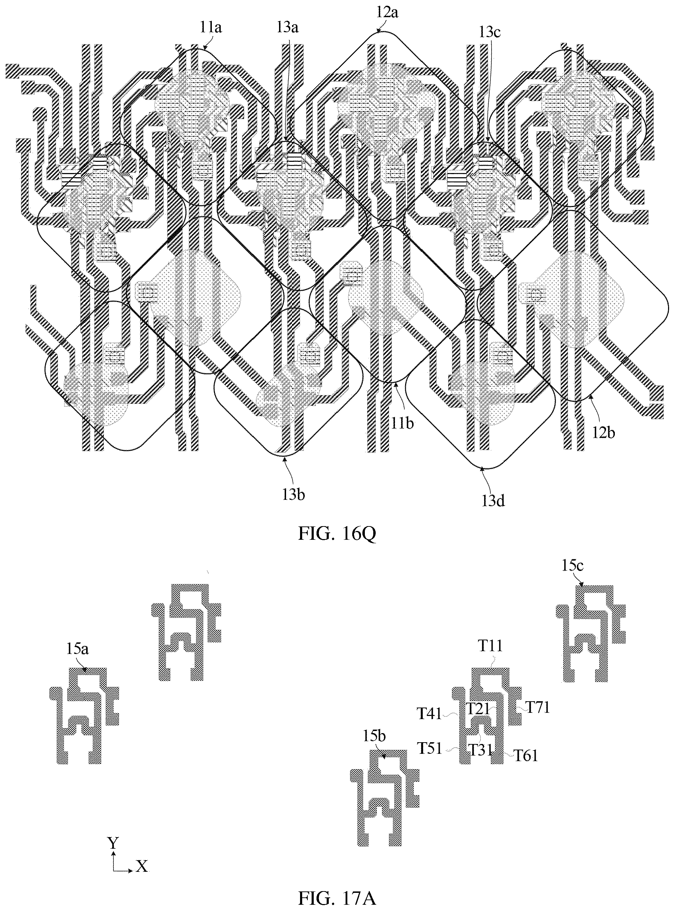

FIG. 16Q is a schematic diagram of the light-transmitting display region provided in FIG. 13 after the pattern of the anode conductive layer is formed.

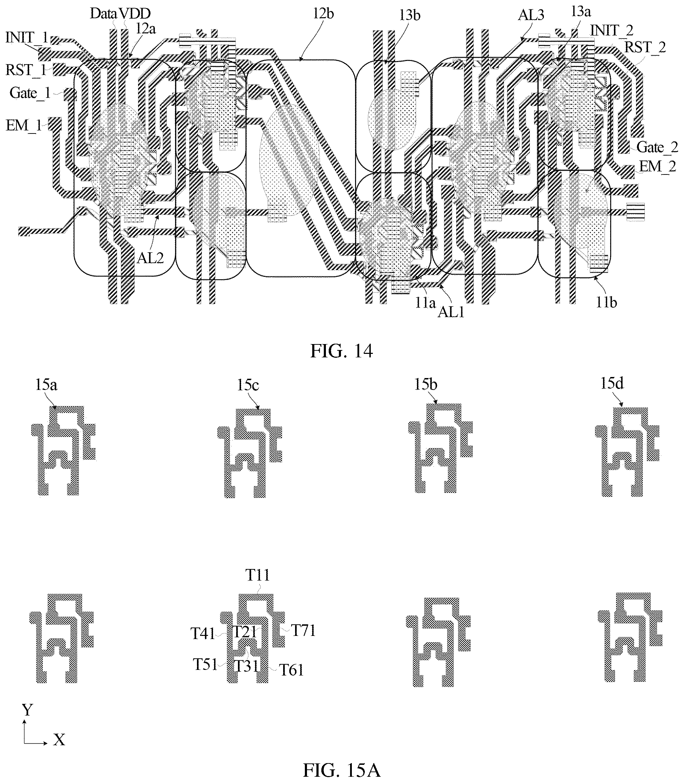

FIG. 17A is a schematic diagram of the light-transmitting display region provided in FIG. 14 after a pattern of a semiconductor is formed.

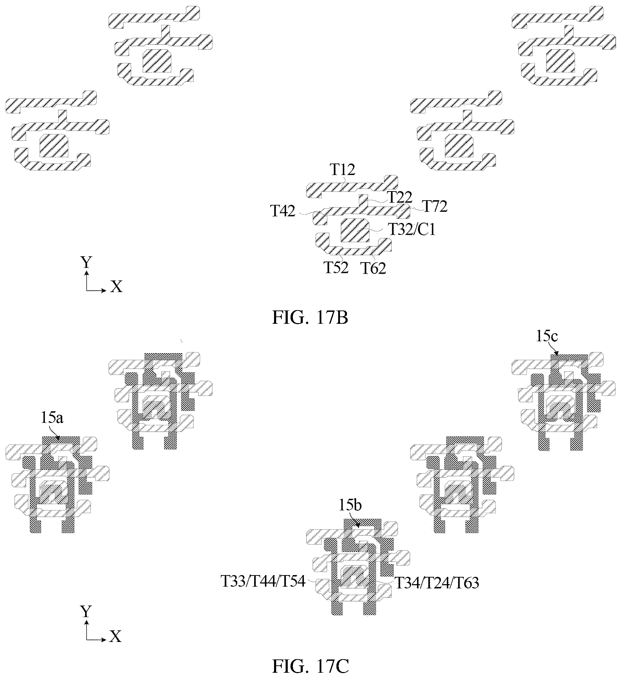

FIG. 17B is a schematic diagram of a pattern of a first conductive layer of the light-transmitting display region provided in FIG. 14.

FIG. 17C is a schematic diagram of the light-transmitting display region provided in FIG. 14 after the pattern of the first conductive layer is formed.

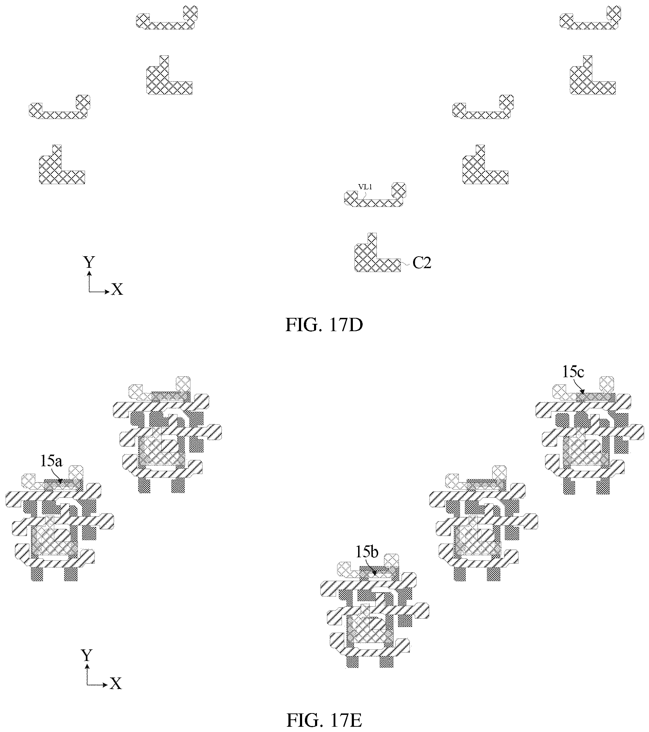

FIG. 17D is a schematic diagram of a pattern of a second conductive layer of the light-transmitting display region provided in FIG. 14.

FIG. 17E is a schematic diagram of the light-transmitting display region provided in FIG. 14 after the pattern of the second conductive layer is formed.

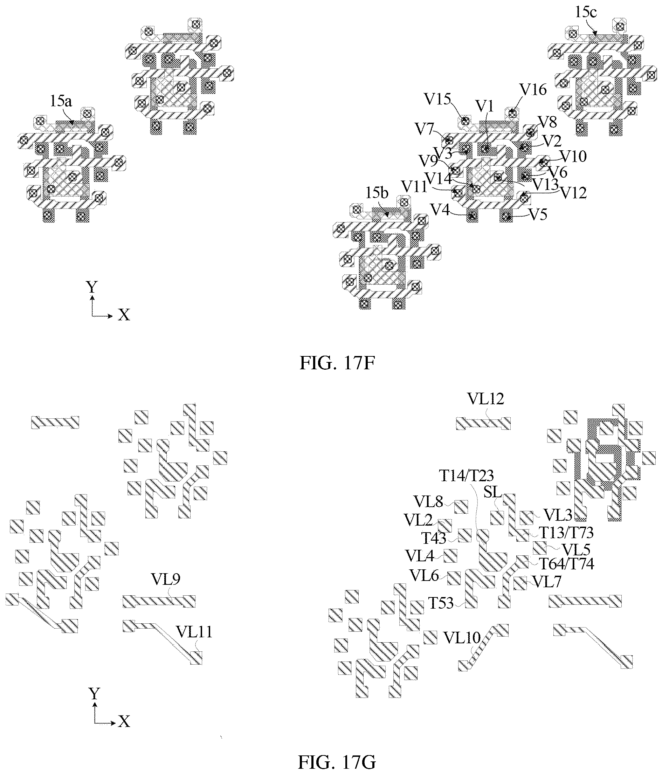

FIG. 17F is a schematic diagram of the light-transmitting display region provided in FIG. 14 after a pattern of a third insulation layer is formed.

FIG. 17G is a schematic diagram of a pattern of a third conductive layer of the light-transmitting display region provided in FIG. 14.

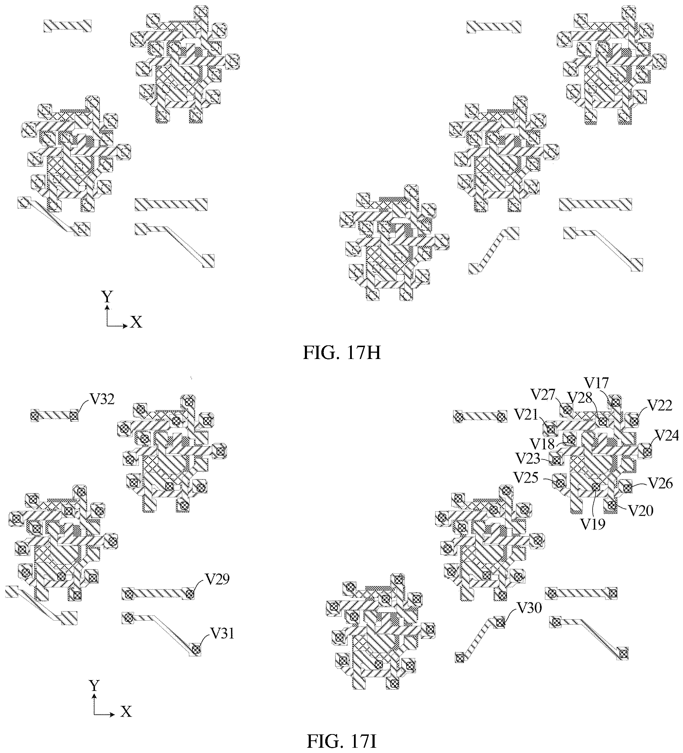

FIG. 17H is a schematic diagram of the light-transmitting display region provided in FIG. 14 after the pattern of the third conductive layer is formed.

FIG. 17I is a schematic diagram of the light-transmitting display region provided in FIG. 14 after a pattern of a fourth insulation layer is formed.

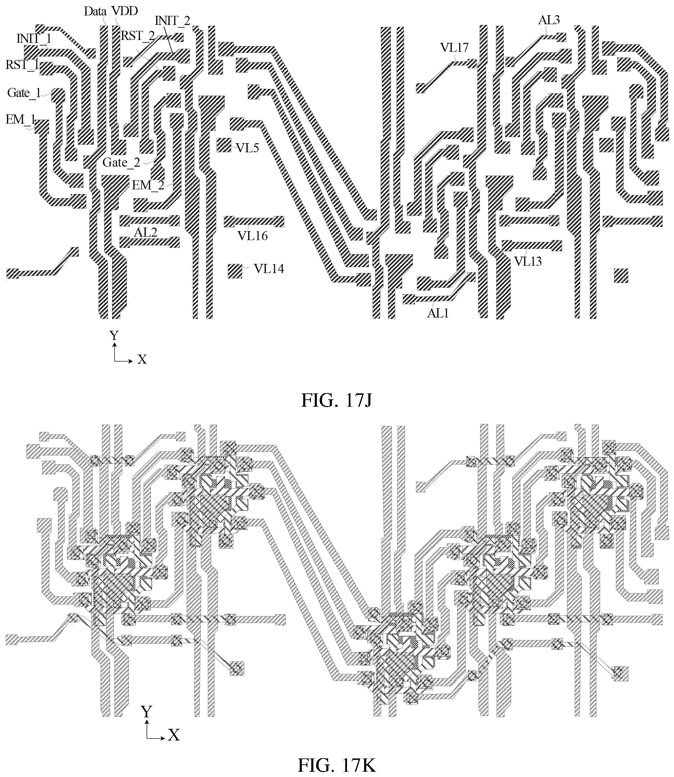

FIG. 17J is a schematic diagram of a pattern of a transparent conductive layer of the light-transmitting display region provided in FIG. 14.

FIG. 17K is a schematic diagram of the light-transmitting display region provided in FIG. 14 after the pattern of the transparent conductive layer is formed.

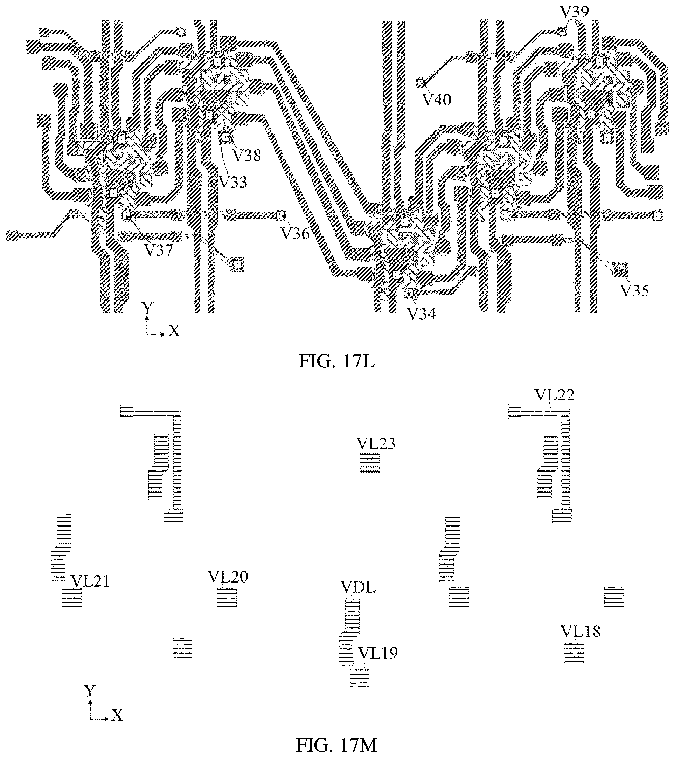

FIG. 17L is a schematic diagram of the light-transmitting display region provided in FIG. 14 after a first planarization layer is formed.

FIG. 17M is a schematic diagram of a pattern of a fourth conductive layer of the light-transmitting display region provided in FIG. 14.

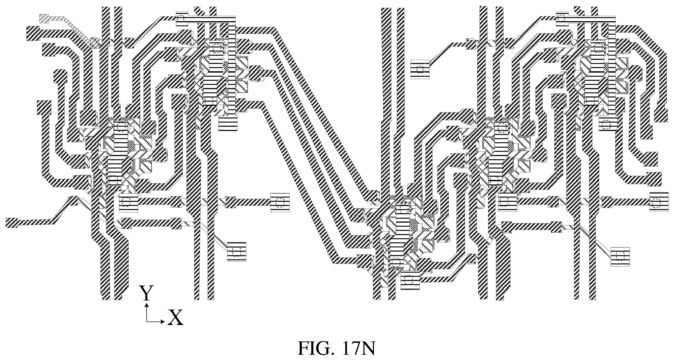

FIG. 17N is a schematic diagram of the light-transmitting display region provided in FIG. 14 after the pattern of the fourth conductive layer is formed.

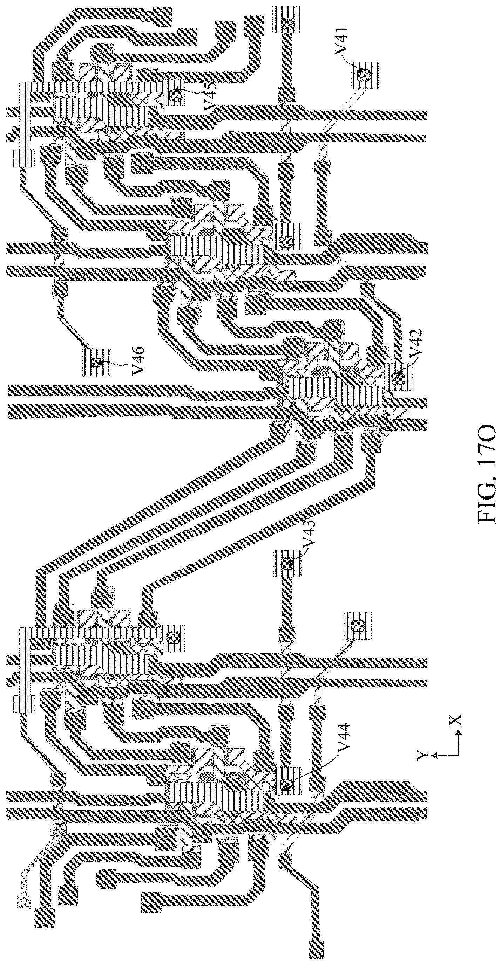

FIG. 17O is a schematic diagram of the light-transmitting display region provided in FIG. 14 after a pattern of a second planarization layer is formed.

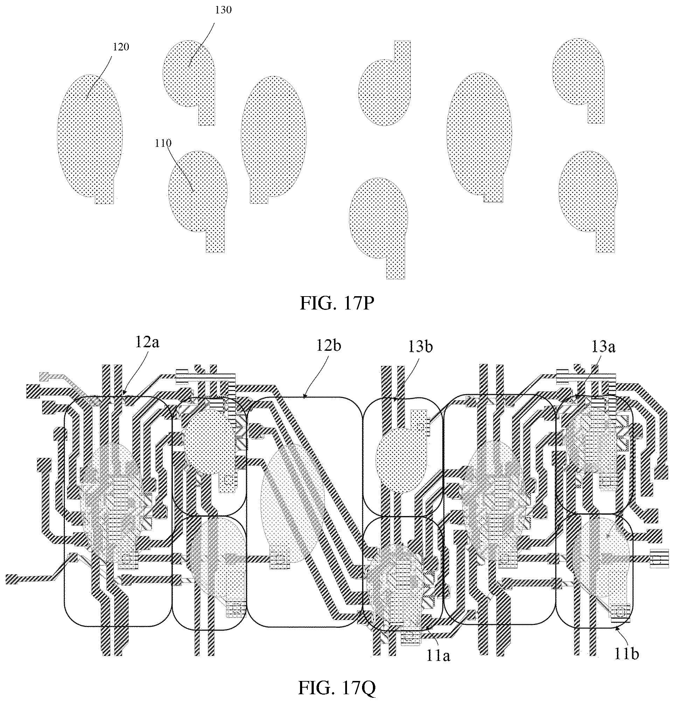

FIG. 17P is a schematic diagram of a pattern of an anode conductive layer of the light-transmitting display region provided in FIG. 14.

FIG. 17Q is a schematic diagram of the light-transmitting display region provided in FIG. 14 after the pattern of the anode conductive layer is formed.

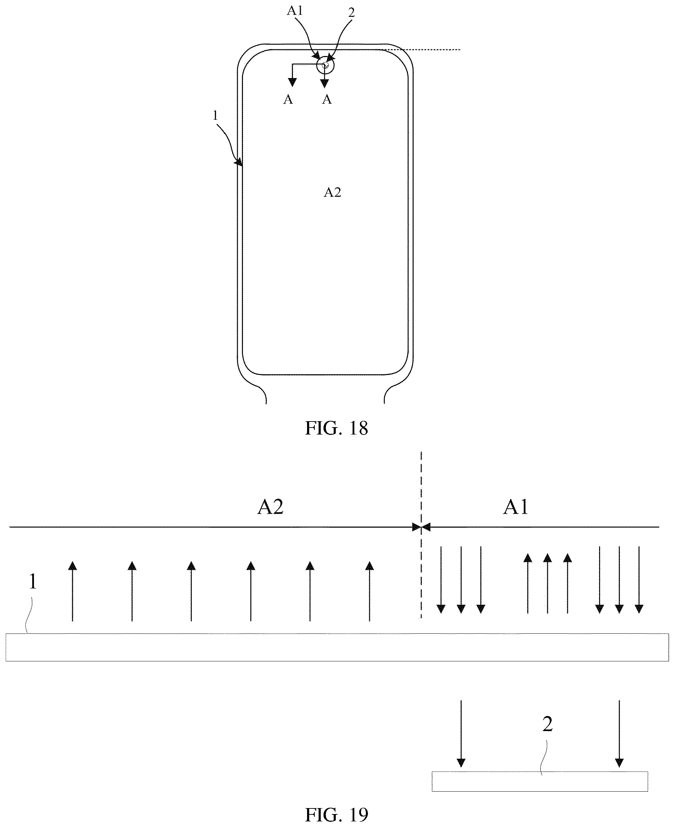

FIG. 18 is a schematic diagram of a structure of a display apparatus according to an embodiment of the present disclosure.

FIG. 19 is a cross-sectional view of FIG. 18 along an A-A direction.

Detailed Description

The embodiments of the present disclosure will be described below with reference to the drawings in detail. Implementation modes may be implemented in multiple different forms. Those of ordinary skills in the art may easily understand such a fact that modes and contents may be transformed into other forms without departing from the purpose and scope of the present disclosure. Therefore, the present disclosure should not be explained as being limited to contents recorded in following implementation modes only. The embodiments in the present disclosure and features in the embodiments may be randomly combined with each other in case of no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the accompanying drawings schematically illustrate ideal examples, and a mode of the present disclosure is not limited to shapes, numerical values, or the like shown in the drawings.

Ordinal numerals "first", "second", "third", etc., in the specification are set to avoid confusion of constituent elements, not to limit a quantity. In the present disclosure, "plurality" represents two or more than two.

In the specification, for convenience, expressions "central", "above", "below", "front", "back", "vertical", "horizontal", "top", "bottom", "inside", "outside", etc., indicating orientations or positional relationships are used to illustrate positional relationships between constituent elements with reference to the drawings, only for convenience of describing the specification and simplifying the description, and do not indicate or imply that a referred apparatus or element must have a specific orientation and be structured and operated in a specific orientation, so they cannot be understood as limitations on the present disclosure. The positional relationships between the constituent elements are changed as appropriate according to a direction where the constituent elements are described. Therefore, appropriate replacements may be made according to a situation, not limited to the expressions in the specification.

In the specification, unless otherwise specified and defined, terms "mounting", "mutual connection", and "connection" should be generally understood. For example, it may be a fixed connection, a detachable connection, or an integral connection; it may be a mechanical connection or a connection; it may be a direct connection, an indirect connection through a middleware, or internal communication inside two elements. Those of ordinary skills in the art may understand meanings of the aforementioned terms in the present disclosure according to situations.

In the specification, an "electrical connection" includes a case that constituent elements are connected together through an element having some electrical function. The "element having some electrical function" is not particularly limited as long as electrical signals between the connected constituent elements may be transmitted. Examples of the "element having some electrical function" not only include an electrode and a wiring, but also include a switching element such as a transistor, a resistor, an inductor, a capacitor, another element with multiple functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

A "light transmittance" in the present disclosure refers to an ability of light to pass through a medium, and is a percentage of luminous flux passing through a transparent or translucent body to its incident luminous flux.

In the present disclosure, "about" and "substantially" refer to that a boundary is not defined strictly and a case within a range of process and measurement errors is allowed. In the present disclosure, "substantially the same" refers to a case where numerical values differ by less than 10%.

At least one embodiment of the present disclosure provides a display substrate, including a display region and a peripheral region at least partially surrounding the display region, wherein the display region includes a light-transmitting display region and a conventional display region located on at least one side of the light-transmitting display region, and a light transmittance of the light-transmitting display region is greater than a light transmittance of the conventional display region; the display substrate includes a base substrate and multiple light emitting elements and multiple pixel circuits located on a side of the base substrate, wherein the multiple light emitting elements include multiple first type light emitting elements located in the light-transmitting display region, the multiple pixel circuits include multiple first type pixel circuits located in the light-transmitting display region, at least one first type pixel circuit among the multiple first type pixel circuits is electrically connected with at least two first type light emitting elements emitting light of a same color, and the first type pixel circuit is configured to drive the at least two first type light emitting elements to emit light; an orthographic projection of at least one first type pixel circuit on the base substrate is overlapped with an orthographic projection of at least one first type light emitting element on the base substrate.

According to the display substrate provided by the embodiment of the present disclosure, by reducing a quantity of first type pixel circuits in the light-transmitting display region and using one first type pixel circuit to drive at least two first type light emitting elements emitting light of a same color, it may be ensured that a resolution (Pixel Per Inch (PPI)) of the display region of the display substrate is consistent, a light transmittance of the light-transmitting display region is improved, and diffraction of the light-transmitting display region during photographing is reduced. The display substrate provided by the embodiment may be applied to a Quarter High Definition (QHD) display device. However, the embodiment is not limited thereto.

In an exemplary implementation mode, an orthographic projection of at least one first type pixel circuit on the base substrate is overlapped with an orthographic projection of at least partial first type light emitting element in at least two first type light emitting elements electrically connected with the at least one first type pixel circuit on the base substrate.

In an exemplary implementation mode, the display substrate may further include multiple first signal lines and at least one first type pixel circuit is electrically connected with at least one first signal line. Among them, the multiple first signal lines include at least one of a scan signal line, a reset signal line, an initial signal line, and a light emitting signal line.

In an exemplary implementation mode, the multiple first signal lines include multiple sub-signal lines; adjacent sub-signal lines of a first signal line are electrically connected through electrically connected first type pixel circuits.

In an exemplary implementation mode, the display substrate may further include multiple second signal lines and at least one first type pixel circuit is electrically connected with at least one second signal line; the multiple second signal lines include at least one of a data signal line and a first power supply line, and multiple data signal lines and multiple first power supply lines are extending along a first direction.

In an exemplary implementation mode, a data signal line and a first power supply line electrically connected with a first type pixel circuit are located between adjacent sub-signal lines of a first signal line, and orthographic projections of the data signal line and the first power supply line electrically connected with the first type pixel circuit on the base substrate are overlapped with an orthographic projection of the first type pixel circuit on the base substrate.

In an exemplary implementation mode, an orthographic projection of at least one of a scan signal line, a reset signal line, an initial signal line, a light emitting signal line, a data signal line, and a first power supply line on the base substrate is partially overlapped with an orthographic projection of a first type light emitting element on the base substrate.

In an exemplary implementation mode, multiple first type light emitting elements at least include multiple first light emitting elements emitting light of a first color, multiple second light emitting elements emitting light of a second color, and multiple third light emitting elements emitting light of a third color, an area of an anode of at least one first light emitting element among the multiple first light emitting elements is greater than an area of an anode of at least one third light emitting element among the multiple third light emitting elements, and an area of an anode of at least one second light emitting element among the multiple second light emitting elements is greater than an area of an anode of at least one third light emitting element. In some examples, the light of the first color may be red light, the light of the second color may be blue light, and the light of the third color may be green light.

Solutions of the embodiments will be described below through some examples.

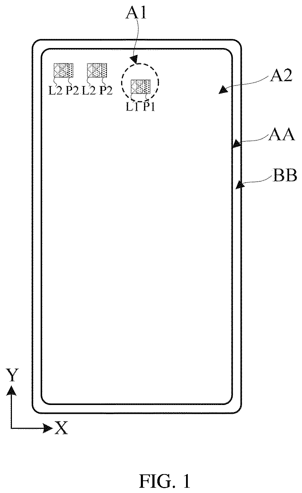

FIG. 1 is a schematic diagram of a display substrate according to at least one embodiment of the present disclosure. In an exemplary implementation mode, as shown in FIG. 1, the display substrate may include a display region AA and a peripheral region BB surrounding a periphery of the display region AA. The display region AA of the display substrate may include a light-transmitting display region A1 and a conventional display region A2 located on at least one side of the light-transmitting display region A1. In some examples, the light-transmitting display region A1 is the aforementioned light-transmitting display region and the light-transmitting display region A1 may also be referred to as an Under Display Camera (UDC) region. The conventional display region A2 may also be referred to as a normal display region. For example, an orthographic projection of hardware such as a photosensitive sensor (such as a camera and an infrared sensor) on the display substrate may be located in the light-transmitting display region A1 of the display substrate. In some examples, as shown in FIG. 1, the light-transmitting display region A1 may be circular and a size of the orthographic projection of the photosensitive sensor on the display substrate may be less than or equal to a size of the light-transmitting display region A1. However, the embodiment is not limited thereto.

In other examples, the light-transmitting display region may be rectangular, and the size of the orthographic projection of the photosensitive sensor on the display substrate may be less than or equal to a size of an inscribed circle of the light-transmitting display region.

In an exemplary implementation mode, as shown in FIG. 1, the light-transmitting display region A1 may be located at a middle position of a top of the display region AA. The conventional display region A2 may surround the light-transmitting display region A1. However, the embodiment is not limited thereto. For example, the light-transmitting display region A1 may be located at another position such as an upper left corner or an upper right corner of the display region AA.

In an exemplary implementation mode, as shown in FIG. 1, the display region AA may be in a shape of a rectangle, e.g., a rounded rectangle. The light-transmitting display region A1 may be circular or oval. However, the embodiment is not limited thereto. For example, the light-transmitting display region may be rectangular, pentagonal, hexagonal, or in another shape.

In an exemplary implementation mode, the display region AA at least includes multiple pixel units arranged regularly, multiple gate lines (for example, including a scan signal line, a reset signal line, and a light emitting signal line) extending along a first direction Y, and multiple data lines and a first power supply line extending along a second direction X. Among them, the first direction Y and the second direction X are located in a same plane, and the first direction Y interacts with the second direction X, for example, the first direction Y is perpendicular to the second direction X.

In an exemplary implementation mode, one pixel unit of the display region AA may include three sub-pixels, wherein the three sub-pixels may be a red sub-pixel, a green sub-pixel, and a blue sub-pixel respectively. However, the embodiment is not limited thereto. In some examples, one pixel unit may include four sub-pixels, wherein the four sub-pixels may be a red sub-pixel, a green sub-pixel, a blue sub-pixel, and a white sub-pixel respectively.

In an exemplary implementation mode, a shape of a sub-pixel may be a rectangle, a rhombus, a pentagon, or a hexagon. When one pixel unit includes three sub-pixels, the three sub-pixels may be arranged side by side horizontally, side by side vertically, or in a shape of a Chinese character " ". When one pixel unit includes four sub-pixels, the four sub-pixels may be arranged side by side horizontally, side by side vertically, or in a shape of a square. However, the embodiment is not limited thereto.

In an exemplary implementation mode, at least one sub-pixel includes a pixel circuit and a light emitting element. The pixel circuit is configured to drive an electrically connected light emitting element. For example, the pixel circuit is configured to provide a drive current to drive the light emitting element to emit light. The pixel circuit may include multiple transistors and at least one capacitor. For example, the pixel circuit may be of a 3T1C (three transistors and one capacitor) structure, an 8T1C (eight transistors and one capacitor) structure, a 7T1C (seven transistors and one capacitor) structure, or a 5T1C (five transistors and one capacitor) structure. In some examples, the light emitting element may be an Organic Light Emitting Diode (OLED), and the light emitting element emits red light, green light, blue light, or white light, etc. under drive of a pixel circuit corresponding to the light emitting element. A color of light emitted from the light emitting element may be determined as required. The light emitting element may include an anode, a cathode, and an organic emitting layer disposed between the anode and the cathode. The anode of the light emitting element may be electrically connected with a corresponding pixel circuit. However, the embodiment is not limited thereto.

In an exemplary implementation mode, as shown in FIG. 1, the display substrate includes a base substrate, and multiple light emitting elements and multiple pixel circuits located on a side of the base substrate. The multiple light emitting elements may include multiple first type light emitting elements L1 located in the light-transmitting display region A1 and a second type light emitting element L2 located in the conventional display region A2, and the multiple pixel circuits may include multiple first type pixel circuits P1 located in the light-transmitting display region A1 and a second type pixel circuit P2 located in the conventional display region A2.

In an exemplary implementation mode, the light-transmitting display region A1 is provided with multiple first type light emitting elements and multiple firs type pixel circuits. At least one first type pixel circuit is electrically connected with at least two first type light emitting elements emitting light of a same color. That is, at least two sub-pixels of a same color in the light-transmitting display region A1 share one first type pixel circuit. The conventional display region A2 is provided with multiple second type light emitting elements 14 and multiple second type pixel circuits. The multiple second type light emitting elements and the multiple second type pixel circuits are electrically connected in one-to-one correspondence. In the display substrate according to the exemplary implementation mode, one first type pixel circuit is adopted in the light-transmitting display region A1 to drive at least two first type light emitting elements, so that while a resolution of the display region of the display substrate may be ensured to be consistent, a light transmittance of the light-transmitting display region is improved, and diffraction during photographing is reduced. However, the embodiment is not limited thereto.

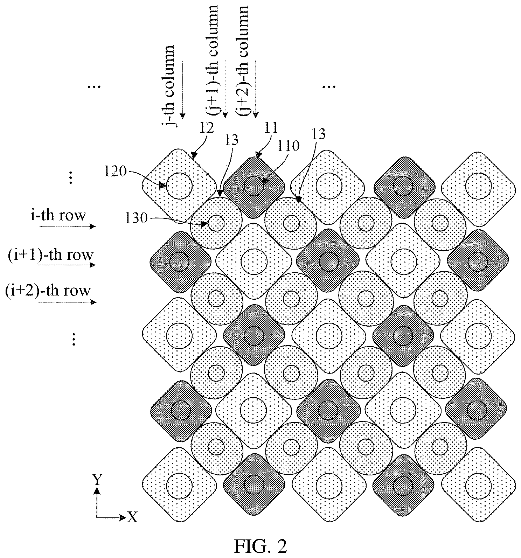

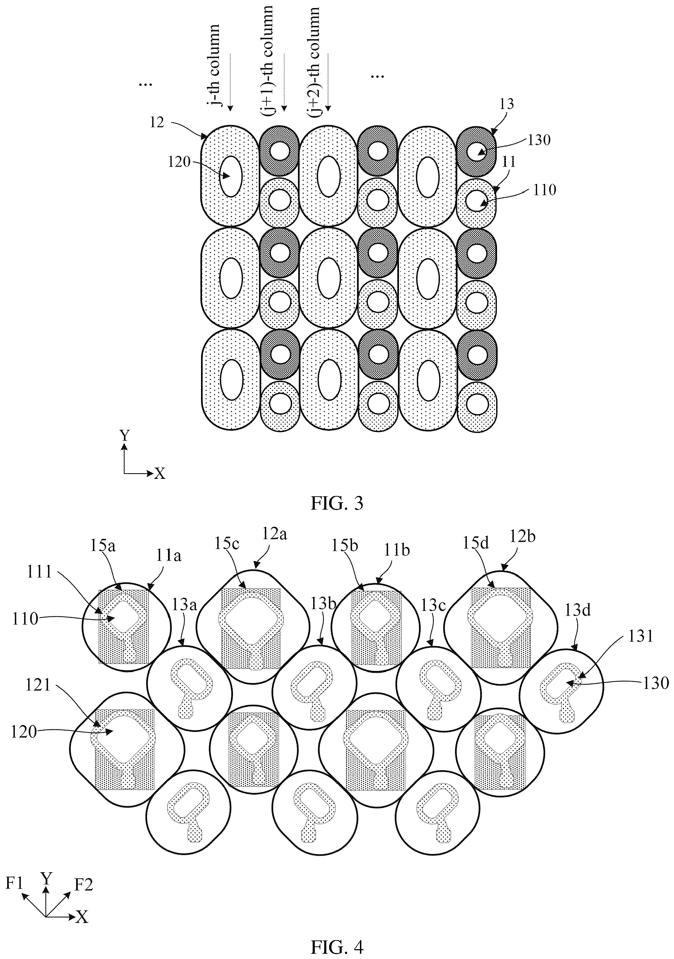

FIG. 2 is a first schematic diagram of an arrangement of a first type light emitting element in a light-transmitting display region according to at least one embodiment of the present disclosure, and FIG. 3 is a second schematic diagram of an arrangement of a first type light emitting element in a light-transmitting display region according to at least one embodiment of the present disclosure. In an exemplary implementation mode, as shown in FIG. 2 and FIG. 3, multiple first type light emitting elements of the light-transmitting display region A1 may include multiple first light emitting elements 11 emitting light of a first color, multiple second light emitting elements 12 emitting light of a second color, and multiple third light emitting elements 13 emitting light of a third color. For example, the light of the first color may be red light, the light of the second color may be blue light, and the light of the third color light may be green light. That is, a first light emitting element 11 may be a red light emitting element, a second light emitting element 12 may be a blue light emitting element, and a third light emitting element 13 may be a green light emitting element. However, the embodiment is not limited thereto.

In an exemplary implementation mode, as shown in FIG. 2, multiple first type light emitting elements of the light-transmitting display region A1 may be arranged according to a Pentile structure. Among them, multiple third light emitting elements 13 are arranged in an i-th row at a certain interval, second light emitting elements 12 and first light emitting elements 11 are alternately arranged in an adjacent row of the i-th row, first light emitting elements 11 and second light emitting elements 12 are alternately arranged in a j-th column, multiple third light emitting elements 13 are arranged in an adjacent column of the j-th column at a certain interval, first light emitting elements 11 and third light emitting elements 13 are alternately arranged along a third direction F1, second light emitting elements 12 and third light emitting elements 13 are alternately arranged along a fourth direction F2, the third direction F1 and the fourth direction F4 intersect with the first direction Y and the second direction X respectively, the first direction Y is a column direction, and the second direction X is a row direction. Exemplarily, multiple third light emitting elements 13 are arranged in an i-th row at a certain interval, and second light emitting elements 12 and first light emitting elements 11 are alternately arranged in an adjacent row of the i-th row, which means that multiple third light emitting elements 13 are arranged in an i-th row at a certain interval, second light emitting elements 12 and first light emitting elements 11 are alternately arranged in an (i+1)-th row adjacent to the i-th row, multiple third light emitting elements 13 are arranged in an (i+2)-th row adjacent to the (i+1)-th row at a certain interval, and first light emitting elements 11 and second light emitting elements 12 are alternately arranged in an (i+3)-th row adjacent to the (i+2)-th row. According to the above rule, multiple rows of first type light emitting elements may be repeatedly arranged. Exemplarily, first light emitting elements 11 and second light emitting elements 12 are alternately arranged in a j-th column and multiple third light emitting elements 13 are arranged in an adjacent column of the j-th column at a certain interval, which means that first light emitting elements 11 and second light emitting elements 12 are alternately arranged in a j-th column, multiple third light emitting elements 13 are arranged in a (j+1)-th column adjacent to the j-th column at a certain interval, first light emitting elements 11 and second light emitting elements 12 are alternately arranged in a (j+2)-th column adjacent to the (j+1)-th column, and multiple third light emitting elements 13 are arranged in a (j+3)-th column at a certain interval. According to the above rule, multiple columns of first type light emitting elements may be repeatedly arranged. In the example, sizes of a first light emitting element 11 and a second light emitting element 12 may both be greater than a size of a third light emitting element 13. Among them, both i and j are integers.

In an exemplary implementation mode, as shown in FIG. 2, a light emitting region 110 of a first light emitting element 11, a light emitting region 120 of a second light emitting element 12, and a light emitting region 130 of a third light emitting element 13 may all be circular or elliptical. The light emitting region 110 of the first light emitting element 11 may be greater than the light emitting region 130 of the third light emitting element 13, and the light emitting region 120 of the second light emitting element 12 may be greater than the light emitting region 130 of the third light emitting element 13. In the example, a light emitting region of a light emitting element may be a portion where the light emitting element is located at a pixel opening of a pixel definition layer.

In an exemplary implementation mode, a light emitting region of a first type light emitting element of the light-transmitting display region A1 may be less than a light emitting region of a second type light emitting element that emits light of a same color in the conventional display region A2. For example, an area of the light emitting region of the first type light emitting element may be 40% to 60% (e.g., may be about 50%) of an area of the light emitting region of the second type light emitting element that emits light of the same color. In the example, by reducing an aperture ratio of the light-transmitting display region A1, a light transmission region of the light-transmitting display region A1 may be increased, thereby improving a light transmittance of the light-transmitting display region A1.

In an exemplary implementation mode, as shown in FIG. 3, multiple first type light emitting elements of the light-transmitting display region A1 may be arranged according to a shape of a Chinese character "品". Multiple second light emitting elements 12 are arranged in a j-th column, first light emitting elements 11 and third light emitting elements 13 are alternately arranged in an adjacent column of the j-th column, multiple second light emitting elements 12 are arranged in an i-th row, and a first light emitting element 11 and a third light emitting element 13 are disposed between adjacent second light emitting elements 12 in a same row. Exemplarily, multiple second light emitting elements 12 are arranged in a j-th column, and first light emitting elements 11 and third light emitting elements 13 are alternately arranged in an adjacent column of the j-th column, which means that multiple second light emitting elements 12 are arranged in a j-th column at a certain interval, first light emitting elements 11 and third light emitting elements 13 are alternately arranged in a (j+1)-th column adjacent to the j-th column, multiple second light emitting elements 12 are arranged in a (j+2)-th column adjacent to the (j+1)-th column at a certain interval, and first light emitting elements 11 and second light emitting elements 12 are alternately arranged in a (j+3)-th column adjacent to the (j+2)-th column. According to the above rule, multiple columns of first type light emitting elements may be repeatedly arranged.

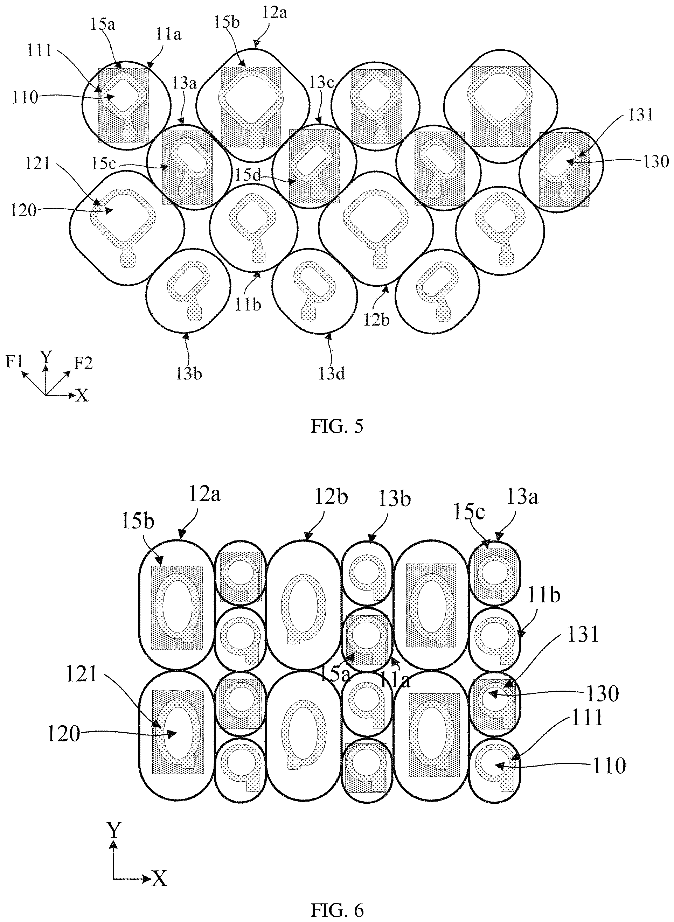

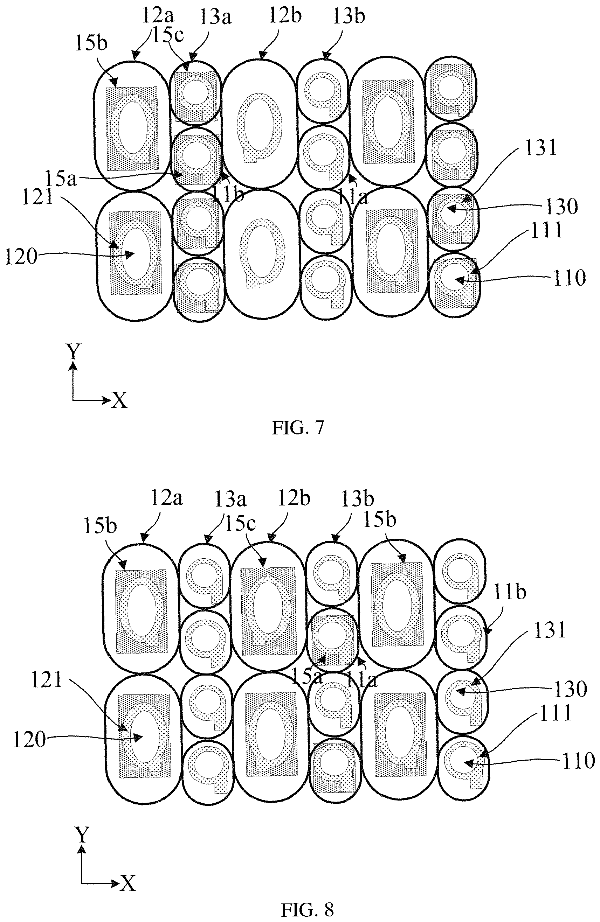

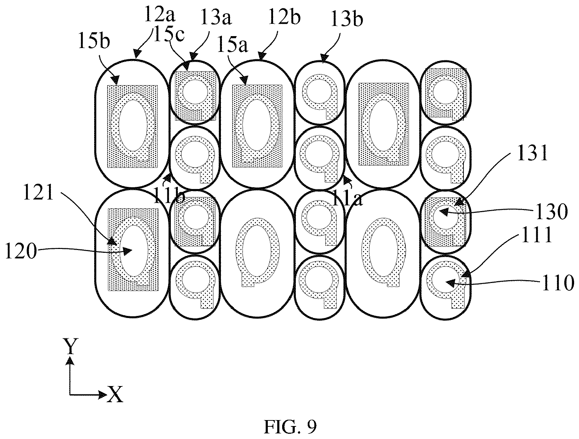

FIG. 4 is a first schematic diagram of an arrangement relationship of a first type pixel circuit and a first type light emitting element in a light-transmitting display region according to an exemplary embodiment, FIG. 5 is a second schematic diagram of an arrangement relationship of a first type pixel circuit and a first type light emitting element in a light-transmitting display region according to an exemplary embodiment, FIG. 6 is a third schematic diagram of an arrangement relationship of a first type pixel circuit and a first type light emitting element in a light-transmitting display region according to an exemplary embodiment, FIG. 7 is a fourth schematic diagram of an arrangement relationship of a first type pixel circuit and a first type light emitting element in a light-transmitting display region according to an exemplary embodiment, FIG. 8 is a fifth schematic diagram of an arrangement relationship of a first type pixel circuit and a first type light emitting element in a light-transmitting display region according to an exemplary embodiment, and FIG. 9 is a sixth schematic diagram of an arrangement relationship of a first type pixel circuit and a first type light emitting element in a light-transmitting display region according to an exemplary embodiment. In FIG. 4 to FIG. 9, a position of the first type pixel circuit is illustrated with a rectangular frame. FIG. 4 and FIG. 5 are illustrated by taking a case in which multiple first type light emitting elements in the light-transmitting display region A1 may be arranged according to a Pentile structure as an example, and FIG. 6 to FIG. 9 are illustrated by taking a case in which multiple first type light emitting elements in the light-transmitting display region A1 may be arranged according to a shape of a Chinese character "品" as an example. FIG. 4 to FIG. 9 are all illustrated by taking a case in which one first type pixel circuit is connected with two first type light emitting elements as an example.

In an exemplary implementation mode, as shown in FIG. 4 to FIG. 9, an area of an anode 111 of a first light emitting element (e.g., first light emitting elements 11a and 11b) is greater than an area of an anode 131 of a third light emitting element (e.g., third light emitting elements 13a and 13b), and an area of an anode 121 of a second light emitting element (e.g., second light emitting elements 12a and 12b) is greater than the area of the anode 131 of the third light emitting element (e.g., the third light emitting elements 13a and 13b).

In an exemplary implementation mode, multiple first type pixel circuits include at least one first pixel circuit, at least one second pixel circuit, at least one third pixel circuit, and at least one fourth pixel circuit; the first pixel circuit is electrically connected with two first light emitting elements, the second pixel circuit is electrically connected with two second light emitting elements, the third pixel circuit is electrically connected with two third light emitting elements, the fourth pixel circuit is electrically connected with two third light emitting elements, and third light emitting elements electrically connected with the third pixel circuit and the fourth pixel circuit are different.

In an exemplary implementation mode, as shown in FIG. 4, multiple first type pixel circuits in the light-transmitting display region may at least include a first pixel circuit 15a, a second pixel circuit 15b, a third pixel circuit 15c, and a fourth pixel circuit 15d. The first pixel circuit 15a is electrically connected with two first light emitting elements 11a and 11b emitting light of a first color and is configured to drive the two first light emitting elements 11a and 11b to emit light. An orthographic projection of the first pixel circuit 15a on the base substrate is overlapped with an orthographic projection of an anode 111 of a first light emitting element 11a on the base substrate and is not overlapped with an orthographic projection of an anode of a first light emitting element 11b on the base substrate. The second pixel circuit 15b is electrically connected with two second light emitting elements 12a and 12b emitting light of a second color and is configured to drive the two second light emitting elements 12a and 12b to emit light. An orthographic projection of the second pixel circuit 15b on the base substrate is not overlapped with orthographic projections of anodes of a second light emitting element 12a and a second light emitting element 12b on the base substrate and is overlapped with an orthographic projection of a first light emitting element 11b located between the second light emitting element 12a and the second light emitting element 12b on the base substrate. The third pixel circuit 15c is electrically connected with two third light emitting elements 13a and 13b emitting light of a third color and is configured to drive the two third light emitting elements 13a and 13b to emit light. An orthographic projection of the third pixel circuit 15c on the base substrate is overlapped with an orthographic projection of an anode of the second light emitting element 12a on the base substrate and is not overlapped with each of orthographic projections of anodes of the two third light emitting elements 13a and 13b on the base substrate. The second light emitting element 12a overlapped with the third pixel circuit 15c is located in an upper row of a row in which the two third light emitting elements 13a and 13b are located, and is located in a middle column of columns in which the two third light emitting elements 13a and 13b are located. The fourth pixel circuit 15d is electrically connected with two third light emitting elements 13c and 13d emitting light of a third color and is configured to drive the two third light emitting elements 13c and 13d to emit light. An orthographic projection of the fourth pixel circuit 15d on the base substrate is overlapped with an orthographic projection of an anode of a second light emitting element 12b on the base substrate and is not overlapped with each of orthographic projections of anodes of the two third light emitting elements 13c and 13d on the base substrate. The second light emitting element 12b overlapped with the fourth pixel circuit 15d is located in an upper row of a row in which the two third light emitting elements 13c and 13d are located, and is located in a middle column of columns in which the third light emitting elements 13c and 13d are located.

In some exemplary embodiments, as shown in FIG. 4, a first type pixel circuit is located below an anode of a first light emitting element or a second light emitting element with a greater anode area, and is not overlapped with an anode of a third light emitting element with a smaller anode area. In the example, a first type pixel circuit is disposed below a first type light emitting element with a greater anode area, and a first type pixel circuit is not disposed below a first type light emitting element with a smaller anode area, so that a light transmittance of the light-transmitting display region may be improved.

In an exemplary implementation mode, as shown in FIG. 4, the two first light emitting elements 11a and 11b electrically connected with the first pixel circuit 15a are in the second direction X (i.e., the two first light emitting elements 11a and 11b are located in a same row), the two second light emitting elements 12a and 12b electrically connected with the second pixel circuit 15b are in the second direction X (i.e., the two second light emitting elements 12a and 12b are located in a same row), and the two third light emitting elements 13a and 13b electrically connected with the third pixel circuit 15c are in the second direction X (i.e., the two third light emitting elements 13a and 13b are located in a same row). The two third light emitting elements 13c and 13d electrically connected with the fourth pixel circuit 15d are in the second direction X (i.e., the two third light emitting elements 13c and 13d are located in a same row).

In an exemplary implementation mode, as shown in FIG. 5, multiple first type pixel circuits in the light-transmitting display region may include at least a first pixel circuit 15a, a second pixel circuit 15b, a third pixel circuit 15c, and a fourth pixel circuit 15d. The first pixel circuit 15a is electrically connected with two first light emitting elements 11a and 11b emitting light of a first color and is configured to drive the two first light emitting elements 11a and 11b to emit light. An orthographic projection of the first pixel circuit 15a on the base substrate is overlapped with an orthographic projection of an anode 111 of a first light emitting element 11a on the base substrate and is not overlapped with an orthographic projection of an anode of a first light emitting element 11b on the base substrate. The second pixel circuit 15b is electrically connected with two second light emitting elements 12a and 12b emitting light of a second color and is configured to drive the two second light emitting elements 12a and 12b to emit light. An orthographic projection of the second pixel circuit 15b on the base substrate is overlapped with an orthographic projection of an anode of a second light emitting element 12a on the base substrate and is not overlapped with an orthographic projection of an anode of a second light emitting element 12b on the base substrate. The third pixel circuit 15c is electrically connected with two third light emitting elements 13a and 13b emitting light of a third color and is configured to drive the two third light emitting elements 13a and 13b to emit light. An orthographic projection of the third pixel circuit 15c on the base substrate is overlapped with an orthographic projection of an anode of a third light emitting element 13a on the base substrate and is not overlapped with an orthographic projection of an anode of a third light emitting element 13b on the base substrate. The fourth pixel circuit 15d is electrically connected with two third light emitting elements 13c and 13d emitting light of a third color and is configured to drive the two third light emitting elements 13c and 13d to emit light. An orthographic projection of the fourth pixel circuit 15d on the base substrate is overlapped with an orthographic projection of an anode of a third light emitting element 13c on the base substrate and is not overlapped with an orthographic projection of an anode of a third light emitting element 13d on the base substrate.

In an exemplary implementation mode, as shown in FIG. 5, the two first light emitting elements 11a and 11b electrically connected with the first pixel circuit 15a are in the third direction F1. The two second light emitting elements 12a and 12b electrically connected with the second pixel circuit 15b are in the third direction F1. The two third light emitting elements 13a and 13b electrically connected with the third pixel circuit 15c are in the first direction Y (i.e., the two third light emitting elements 13a and 13b are located in a same column). The two third light emitting elements 13c and 13d electrically connected with the fourth pixel circuit 15d are in the first direction Y (i.e., the two third light emitting elements 13c and 13d are located in a same column).

In an exemplary implementation mode, multiple first type pixel circuits may include at least one first pixel circuit, at least one second pixel circuit, and at least one third pixel circuit; wherein the first pixel circuit is electrically connected with two first light emitting elements, the second pixel circuit is electrically connected with two second light emitting elements, and the third pixel circuit is electrically connected with two third light emitting elements.

In an exemplary implementation mode, as shown in FIG. 6, multiple first type pixel circuits in the light-transmitting display region may at least include a first pixel circuit15a, a second pixel circuit 15b, and a third pixel circuit 15c. The first pixel circuit 15a is electrically connected with two first light emitting elements 11a and 11b emitting light of a first color and is configured to drive the two first light emitting elements 11a and 11b to emit light. An orthographic projection of the first pixel circuit 15a on the base substrate is overlapped with an orthographic projection of an anode 111 of a first light emitting element 11a on the base substrate and is not overlapped with an orthographic projection of an anode of a first light emitting element 11b on the base substrate. The second pixel circuit 15b is electrically connected with two second light emitting elements 12a and 12b emitting light of a second color and is configured to drive the two second light emitting elements 12a and 12b to emit light. An orthographic projection of the second pixel circuit 15b on the base substrate is overlapped with an orthographic projection of an anode of a second light emitting element 12a on the base substrate and is not overlapped with an orthographic projection of a second light emitting element 12b on the base substrate. The third pixel circuit 15c is electrically connected with two third light emitting elements 13a and 13b emitting light of a third color and is configured to drive the two third light emitting elements 13a and 13b to emit light. An orthographic projection of the third pixel circuit 15c on the base substrate is overlapped with an orthographic projection of an anode of a third light emitting element 13a on the base substrate and is not overlapped with an orthographic projection of an anode of a third light emitting element 13b on the base substrate.

In an exemplary implementation mode, as shown in FIG. 7, multiple first type pixel circuits in the light-transmitting display region may at least include a first pixel circuit15a, a second pixel circuit 15b, and a third pixel circuit 15c. The first pixel circuit 15a is electrically connected with two first light emitting elements 11a and 11b emitting light of a first color and is configured to drive the two first light emitting elements 11a and 11b to emit light. An orthographic projection of the first pixel circuit 15a on the base substrate is overlapped with an orthographic projection of an anode 111 of a first light emitting element 1 1b on the base substrate and is not overlapped with an orthographic projection of an anode of a first light emitting element 11a on the base substrate. The second pixel circuit 15b is electrically connected with two second light emitting elements 12a and 12b emitting light of a second color and is configured to drive the two second light emitting elements 12a and 12b to emit light. An orthographic projection of the second pixel circuit 15b on the base substrate is overlapped with an orthographic projection of an anode of a second light emitting element 12a on the base substrate and is not overlapped with an orthographic projection of a second light emitting element 12b on the base substrate. The third pixel circuit 15c is electrically connected with two third light emitting elements 13a and 13b emitting light of a third color and is configured to drive the two third light emitting elements 13a and 13b to emit light. An orthographic projection of the third pixel circuit 15c on the base substrate is overlapped with an orthographic projection of an anode of a third light emitting element 13a on the base substrate and is not overlapped with an orthographic projection of an anode of a third light emitting element 13b on the base substrate.

In an exemplary implementation mode, as shown in FIG. 8, multiple first type pixel circuits in the light-transmitting display region may at least include a first pixel circuit15a, a second pixel circuit 15b, and a third pixel circuit 15c. The first pixel circuit 15a is electrically connected with two first light emitting elements 11a and 11b emitting light of a first color and is configured to drive the two first light emitting elements 11a and 11b to emit light. An orthographic projection of the first pixel circuit 15a on the base substrate is overlapped with an orthographic projection of an anode 111 of a first light emitting element 11a on the base substrate and is not overlapped with an orthographic projection of an anode of a first light emitting element 11b on the base substrate. The second pixel circuit 15b is electrically connected with two second light emitting elements 12a and 12b emitting light of a second color and is configured to drive the two second light emitting elements 12a and 12b to emit light. An orthographic projection of the second pixel circuit 15b on the base substrate is overlapped with an orthographic projection of an anode of a second light emitting element 12a on the base substrate and is not overlapped with an orthographic projection of a second light emitting element 12b on the base substrate. The third pixel circuit 15c is electrically connected with two third light emitting elements 13a and 13b emitting light of a third color and is configured to drive the two third light emitting elements 13a and 13b to emit light. An orthographic projection of the third pixel circuit 15c on the base substrate is not overlapped with orthographic projections of anodes of the two third light emitting elements 13a and13b on the base substrate and is overlapped with an orthographic projection of an anode of a second light emitting element 12b located between the two third light emitting elements 13a and 13b on the base substrate.

In an exemplary implementation mode, as shown in FIG. 9, multiple first type pixel circuits in the light-transmitting display region may at least include a first pixel circuit15a, a second pixel circuit 15b, and a third pixel circuit 15c. The first pixel circuit 15a is electrically connected with two first light emitting elements 11a and 11b emitting light of a first color and is configured to drive the two first light emitting elements 11a and 11b to emit light. An orthographic projection of the first pixel circuit 15a on the base substrate is not overlapped with orthographic projections of anodes 111 of the first light emitting elements 11a and 11b on the base substrate and is overlapped with an orthographic projection of an anode of a second light emitting element 12b located between the first light emitting elements 11a and 11b on the base substrate. The second pixel circuit 15b is electrically connected with two second light emitting elements 12a and 12b emitting light of a second color and is configured to drive the two second light emitting elements 12a and 12b to emit light. An orthographic projection of the second pixel circuit 15b on the base substrate is overlapped with an orthographic projection of an anode of a second light emitting element 12a on the base substrate and is not overlapped with an orthographic projection of a second light emitting element 12b on the base substrate. The third pixel circuit 15c is electrically connected with two third light emitting elements 13a and 13b emitting light of a third color and is configured to drive the two third light emitting elements 13a and 13b to emit light. An orthographic projection of the third pixel circuit 15c on the base substrate is overlapped with an orthographic projection of an anode of a third light emitting element 13a on the base substrate and is not overlapped with an orthographic projection of an anode of a third light emitting element 13b on the base substrate.

In an exemplary implementation mode, as shown in FIG. 6 to FIG. 9, the two first light emitting elements 11a and 11b electrically connected with the first pixel circuit 15a are in the second direction X (i.e., the two first light emitting elements 11a and 11b are located in a same row), the two second light emitting elements 12a and 12b electrically connected with the second pixel circuit 15b are in the second direction X (i.e., the two second light emitting elements 12a and 12b are located in a same row), and the two third light emitting elements 13a and 13b electrically connected with the third pixel circuit 15c are in the second direction X (i.e., the two third light emitting elements 13a and 13b are located in a same row).

In an exemplary implementation mode, at least two of a first light emitting element overlapped with a first pixel circuit, a second light emitting element overlapped with a second pixel circuit, and a third light emitting element overlapped with a third pixel circuit are adjacent. FIG. 7 is illustrated by taking a case in which the first light emitting element overlapped with the first pixel circuit, the second light emitting element overlapped with the second pixel circuit, and the third light emitting element overlapped with the third pixel circuit are located in a same light emitting unit as an example. FIG. 6, FIG. 8, and FIG. 9 are illustrated by taking a case in which the first light emitting element overlapped with the first pixel circuit, the second light emitting element overlapped with the second pixel circuit, and the third light emitting element overlapped with the third pixel circuit are located in a same light emitting unit located in two light emitting units as an example. A light emitting unit includes a first light emitting element, a second light emitting element, and a third light emitting element.

In an exemplary implementation mode, in the light-transmitting display region, at least two first type light emitting elements emitting light of a same color are driven by using one first type pixel circuit, and the first type pixel circuit is disposed below anodes with a first light emitting element, a second light emitting element, and a third light emitting element, so that a light transmittance may be improved on a basis of ensuring a resolution of the display substrate.

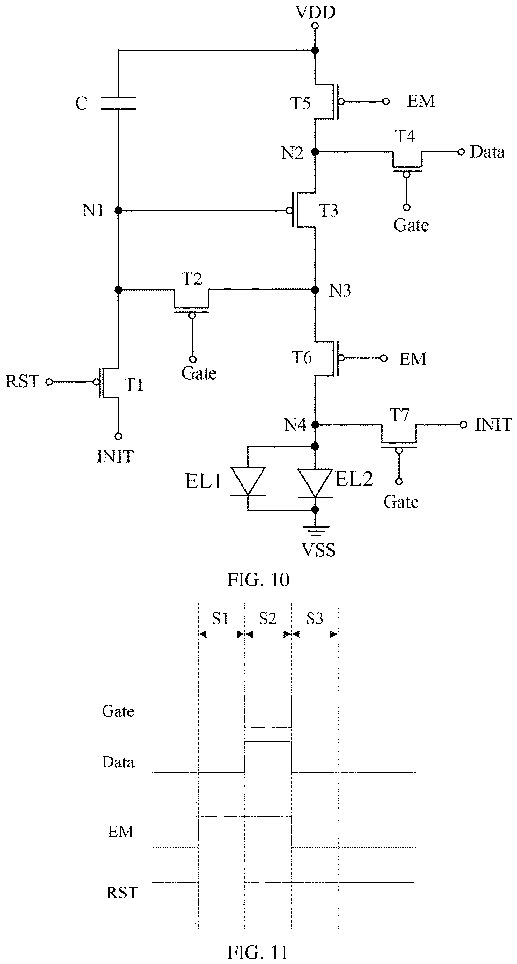

FIG. 10 is an equivalent circuit diagram of a first type pixel circuit. In an exemplary implementation mode, as shown in FIG. 10, a first type pixel circuit of an exemplary embodiment may be of a structure of 8T1C, i.e., including a first transistor T1 to a seventh transistor T7 and a capacitor C. First type light emitting elements EL1 and EL2 may emit light of a same color, and may each include an anode, a cathode, and an organic emitting layer located between the anode and the cathode. In the example, the third transistor T3 is a drive transistor.

In an exemplary implementation mode, as shown in FIG. 10, the first type pixel circuit is electrically connected with a scan signal line Gate, a reset signal line RST, an initial signal line INIT, a light emitting signal line EM, a data signal line Data, a first power supply line VDD, and a second power supply line VSS. Exemplarily, the first power supply line VDD is configured to provide a constant first voltage signal to the first type pixel circuit, and the second power supply line VSS is configured to provide a constant second voltage signal to the first type pixel circuit, and a voltage value of the first voltage signal is greater than a voltage value of the second voltage signal. The scan signal line Gate is configured to provide a scan signal to the first type pixel circuit, the data signal line Data is configured to provide a data signal to the first type pixel circuit, the light emitting signal line EM is configured to provide a light emitting control signal to the first type pixel circuit, and the reset signal line RST is configured to provide a reset control signal to the first type pixel circuit. In some examples, in a first type pixel circuit in an n-th row, a reset signal line RST may be connected with a scan signal line Gate of a first type pixel circuit in an (n-1)-th row. Thus, signal lines of the display substrate may be reduced, and a narrow bezel of the display substrate may be achieved.

In an exemplary implementation mode, as shown in FIG. 10, a control electrode of the first transistor T1 is electrically connected with the reset signal line RST, a first electrode of the first transistor T1 is electrically connected with the initial signal line INIT, and a second electrode of the first transistor T1 is electrically connected with a first node N1. A control electrode of the second transistor T2 is electrically connected with the scan signal line Gate, a first electrode of the second transistor T2 is electrically connected with the first node N1, and a second electrode of the second transistor T2 is electrically connected with a third node N3. A control electrode of the third transistor T3 is electrically connected with the first node N1, a first electrode of the third transistor T3 is electrically connected with a second node N2, and a second electrode of the third transistor T3 is connected with the third node N3. A control electrode of the fourth transistor T4 is electrically connected with the scan signal line Gate, a first electrode of the fourth transistor T4 is electrically connected with the data signal line Data, a second electrode of the fourth transistor T4 is electrically connected with the second node N2. A control electrode of the fifth transistor T5 is electrically connected with the light emitting signal line EM, a first electrode of the fifth transistor T5 is electrically connected with the first power supply line VDD, and a second electrode of the fifth transistor T5 is electrically connected with the second node N2. A control electrode of the sixth transistor T6 is electrically connected with the light emitting signal line EM, a first electrode of the sixth transistor T6 is electrically connected with the third node N3, and a second electrode of the sixth transistor T6 is electrically connected with a fourth node N4. A control electrode of the seventh transistor T7 is electrically connected with the scan signal line Gate, a first electrode of the seventh transistor T7 is electrically connected with the initial signal line INIT, and a second electrode of the seventh transistor T7 is electrically connected with the fourth node N4. A first electrode plate of the capacitor C is electrically connected with the first node N1 and a second electrode plate of the capacitor C is electrically connected with the first power supply line VDD.

In the example, the first node N1 is a connection point of the capacitor C, the first transistor T1, and the third transistor T3, the second node N2 is a connection point of the fifth transistor T5, the fourth transistor T4, and the third transistor T3, the third node N3 is a connection point of the third transistor T3, the second transistor T2, and the sixth transistor T6, the fourth node N4 is a connection point of the sixth transistor T6, the seventh transistor T7, and the two first type light emitting elements EL1 and EL2.

In an exemplary implementation mode, the first transistor T1 to the seventh transistor T7 of the first type pixel circuit may all be P-type transistors or may all be N-type transistors.

In an exemplary implementation mode, for first type transistors (e.g., the first transistor T1 to the seventh transistor T7) of the first type pixel circuit, a low temperature poly silicon thin film transistor may be adopted, or an oxide thin film transistor may be adopted. Low Temperature Poly Silicon (LTPS) is adopted for an active layer of a low temperature poly silicon thin film transistor and an oxide semiconductor (Oxide) is adopted for an active layer of an oxide thin film transistor. A low temperature poly silicon thin film transistor has advantages such as a high mobility and fast charging, and an oxide thin film transistor has advantages such as a low leakage current. The low temperature poly silicon thin film transistor and the oxide thin film transistor are integrated on one display substrate to form a Low Temperature Polycrystalline Oxide (LTPO) display substrate, and advantages of both the low temperature poly silicon thin film transistor and the oxide thin film transistor may be utilized to achieve low-frequency drive, reduce power consumption, and improve display quality. However, the embodiment is not limited thereto. For example, for all multiple transistors of the first type pixel circuit, a low temperature poly silicon thin film transistor may be adopted, or an oxide thin film transistor may be adopted.

FIG. 11 is a working timing diagram of the first type pixel circuit provided in FIG. 10. A working process of the first type pixel circuit shown in FIG. 10 will be described below with reference to FIG. 11. Among them, the first transistor T1 to the seventh transistor T7 of the first type pixel circuit are P-type transistors.

In an exemplary implementation mode, as shown in FIG. 10 and FIG. 11, during one frame display period, the working process of the first type pixel circuit may include a first stage S1, a second stage S2, and a third stage S3.

The first stage S 1 is referred to as a reset stage. A signal provided by the reset signal line RST is a low-level signal, so that the first transistor T1 is turned on. An initial signal provided by the initial signal line INIT is provided to the first node N1 to initialize the first node N1 and clear an original data voltage in the capacitor C. A signal provided by the scan signal line Gate is a high-level signal and a light emitting control signal EM provided by the light emitting signal line EM is a high-level signal, so that the fourth transistor T4, the second transistor T2, the seventh transistor T7, the fifth transistor T5, and the sixth transistor T6 are turned off. At this stage, the first type light emitting elements EL1 and EL2 do not emit light.

The second stage S2 is referred to as a data writing stage or a threshold compensation stage. A signal provided by the scan signal line Gate is a low-level signal and the data signal line Data outputs data, at this stage, since a signal of the first node N1 is a low-level signal, the third transistor T3 is turned on. The signal provided by the scan signal line Gate enables the second transistor T2, the fourth transistor T4, and the seventh transistor T7 to be turned on. The second transistor T2 and the fourth transistor T4 are turned on, so that a data voltage Vdata output by the data signal line Data is provided to the first node N1 through the second node N2, the turned-on third transistor T3, the third node N3, and the turned-on second transistor T2, a difference between the data voltage Vdata output by the data signal line Data and a threshold voltage of the third transistor T3 is charged into the capacitor C, and a voltage of a first electrode (i.e., the first node N1) of the capacitor is Vdata-IVthI, wherein Vdata is the data voltage output by the data signal line Data and Vth is the threshold voltage of the third transistor T3. The seventh transistor T7 is turned on, so that an initial signal Vinit provided by the initial signal line INIT is provided to the fourth node N4, and anodes of the two first type light emitting elements EL1 and EL2 are initialized (reset) to empty pre-stored voltages inside the two first type light emitting elements EL1 and EL2 to complete the initialization, so as to ensure that the first type light emitting elements EL1 and EL2 do not emit light. A signal provided by the reset signal line RST is a high-level signal, so that the first transistor T1 is turned off. A signal provided by the light emitting signal line EM is a high-level signal, so that the fifth transistor T5 and the sixth transistor T6 are turned off.

The third stage S3 is referred to as a light emitting stage. A signal provided by the light emitting signal line EM is a low-level signal, so that the fifth transistor T5 and the sixth transistor T6 are turned on. Signals provided by the scan signal line Gate and the reset signal line RST are high-level signals, so that the second transistor T2, the fourth transistor T4, the seventh transistor T7, and the first transistor T1 are turned off. A first voltage signal outputted by the first power supply line VDD provides a drive voltage to the anodes of the first type light emitting elements EL1 and EL2 through the turned-on fifth transistor T5, the third transistor T3, and the sixth transistor T6 to drive the two first type light emitting elements EL1 and EL2 to emit light.

In a drive process of the first type pixel circuit, a drive current flowing through the third transistor T3 is determined by a voltage difference between a control electrode and a first electrode of the third transistor T3. Since the voltage of the first node N1 is Vdata-|Vthl|, the drive current of the third transistor T3 is as follows.

$$I=K\times(Vgs-Vth)^2=K\times[(VDD-Vdata+|Vthl|)-Vth]^2=K\times[VDD-Vdata]^2$$

Herein, I is the drive current flowing through the third transistor T3, that is, a drive current for driving a first type light emitting element, K is a constant, Vgs is the voltage difference between the control electrode and the first electrode of the third transistor T3, Vth is the threshold voltage of the third transistor T3, Vdata is the data voltage outputted by the data signal line Data, and VDD is the first voltage signal outputted by the first power supply line PL1.

It may be seen from the above formula that a current flowing through the first type light emitting element is independent of the threshold voltage of the third transistor T3. Therefore, the first type pixel circuit according to the embodiment may better compensate the threshold voltage of the third transistor T3.

FIG. 12 is a first partial top view of a light-transmitting display region according to an exemplary embodiment, FIG. 13 is a second partial top view of a light-transmitting display region according to an exemplary embodiment, and FIG. 14 is a third partial top view of a light-transmitting display region according to an exemplary embodiment. FIG. 12 is illustrated by the light-transmitting display region provided in FIG. 4 as an example, FIG. 13 is illustrated by the light-transmitting display region provided in FIG. 5 as an example, and FIG 14 is illustrated by the light-transmitting display region provided in FIG. 6 as an example.

In an exemplary implementation mode, the first type pixel circuit includes multiple transistors and at least one capacitor; in a direction perpendicular to the display substrate, the light-transmitting display region at least includes a semiconductor layer, a first insulation layer, a first conductive layer, a second insulation layer, a second conductive layer, a third insulation layer, a third conductive layer, a fourth insulation layer, a transparent conductive layer, a first planarization layer, a fourth conductive layer, and a second planarization layer disposed on the base substrate.

The semiconductor layer at least includes active layers of the multiple transistors of the first type pixel circuit.

The first conductive layer at least includes control electrodes of the multiple transistors and a first electrode plate of the capacitor of the first type pixel circuit.

The second conductive layer at least includes a second electrode plate of the capacitor of the first type pixel circuit.

The third conductive layer at least includes first electrodes and second electrodes of the multiple transistors of the first type pixel circuit and multiple connection electrodes.

The transparent conductive layer at least includes multiple first signal lines, multiple second signal lines, and multiple anode connection lines, and at least one anode connection line among the multiple anode connection lines is electrically connected with at least one first type pixel circuit and anodes of at least two first type light emitting elements emitting light of a same color; at least one first type pixel circuit is electrically connected with at least one first signal line and at least one second signal line.

The fourth conductive layer at least includes multiple signal connection lines.

In an exemplary implementation mode, as shown in FIG. 12 to FIG. 14, the at least one first signal line includes multiple sub-signal lines; adjacent sub-signal lines of the first signal line are electrically connected through the first type pixel circuit. Exemplarily, the multiple first signal lines include at least one of a scan signal line, a reset signal line, an initial signal line, and a light emitting signal line. As shown in FIG. 12 to FIG. 14, illustration is made by taking a case in which the scan signal line includes two sub-signal lines Gate_1 and Gate_2, the reset signal line includes two sub-signal lines RST_1 and RST_2, the initial signal line includes two sub-signal lines INIT_1 and INIT_2, and the light emitting signal line includes two sub-signal lines EM_1 and EM_2 as an example.

In an exemplary implementation mode, as shown in FIG. 12 to FIG. 14, the multiple second signal lines include multiple data signal lines Data and multiple first power supply lines VDD, at least parts of a data signal line Data and a first power supply line VDD extend along the first direction Y. A data signal line Data and a first power supply line VDD electrically connected with the first type pixel circuit are located between adjacent sub-signal lines of the first signal line and orthographic projections of the data signal line Data and the first power supply line VDD on the base substrate are overlapped with an orthographic projection of the first type pixel circuit on the base substrate.

In an exemplary implementation mode, as shown in FIG. 12, a sub-signal line of the first signal line is in a polyline type and at least part of the sub-signal line of the first signal lines extends along the second direction X.

In an exemplary implementation mode, as shown in FIG. 12, an anode connection line may include a first anode connection line AL1, a second anode connection line AL2, a third anode connection line AL3, and a fourth anode connection line AL4. The first anode connection line AL1, the second anode connection line AL2, the third anode connection line AL3, and the fourth anode connection line AL4 may be in a polyline type. Among them, the first anode connection line AL1 is electrically connected with a first pixel circuit and a first light emitting element respectively and at least part of the first anode connection line AL1 may extend along the second direction X. The second anode connection line AL2 is electrically connected with a second pixel circuit and a second light emitting element respectively and at least part of the second anode connection line AL2 extends along the second direction X. The third anode connection line AL3 is electrically connected with a third pixel circuit and a third light emitting element respectively, at least part of the third anode connection line AL3 extends along the second direction X, and the third anode connection line AL3 is located between a data signal line Data and a first power supply line VDD electrically connected with the third pixel circuit. The fourth anode connection line AL4 is electrically connected with a fourth pixel circuit and a third light emitting element respectively, at least part of the fourth anode connection line AL4 extends along the second direction X, and the fourth anode connection line AL4 is located between a data signal line Data and a first power supply line VDD electrically connected with the fourth pixel circuit.

In an exemplary implementation mode, as shown in FIG. 12, first power supply lines electrically connected with at least two adjacent first type pixel circuits located in a same column are disposed at intervals, and the first power supply lines disposed at intervals located in the same column are electrically connected through at least one signal connection line located in the fourth conductive layer.

In an exemplary implementation mode, as shown in FIG. 12, data signal lines Data electrically connected with at least two adjacent first type pixel circuits located in a same column are disposed at intervals, and the data signal lines Data disposed at intervals located in the same column are electrically connected through at least one signal connection line located in the fourth conductive layer.

In an exemplary implementation mode, as shown in FIG. 13, a sub-signal line of the first signal line is in a polyline type, and at least part of the sub-signal line of the first signal line extends along the first direction Y.

In an exemplary implementation mode, as shown in FIG. 13, an anode connection line includes a first anode connection line AL1, a second anode connection line AL2, a third anode connection line AL3, and a fourth anode connection line AL4. The first anode connection line AL1, the second anode connection line AL2, the third anode connection line AL3, and the fourth anode connection line AL4 may be in a polyline type. Among them, the first anode connection line AL1 is electrically connected with a first pixel circuit and a first light emitting element respectively and at least part of the first anode connection line AL1 extends along the first direction Y. The second anode connection line AL2 is electrically connected with a second pixel circuit and a second light emitting element respectively and at least part of the second anode connection line AL2 extends along the first direction Y. The third anode connection line AL3 is electrically connected with a third pixel circuit and a third light emitting element respectively, at least part of the third anode connection line AL3 extends along the first direction Y, and the third anode connection line AL3 is located on a side of a first power supply line VDD electrically connected with the third pixel circuit away from a data signal line Data. The fourth anode connection line AL4 is electrically connected with a fourth pixel circuit and a third light emitting element respectively, at least part of the fourth anode connection line AL4 extends along the first direction Y, and the fourth anode connection line AL4 is located on a side of a first power supply line VDD electrically connected with the fourth pixel circuit away from a data signal line Data.

In an exemplary implementation mode, as shown in FIG. 13, data signal lines Data electrically connected with first type pixel circuits located in a same column are a same signal line.

In an exemplary implementation mode, as shown in FIG. 13, first power supply lines VDD electrically connected with at least two adjacent first type pixel circuits located in a same column are disposed at intervals, and the first power supply lines VDD disposed at intervals located in the same column are electrically connected through at least one signal connection line located in the fourth conductive layer.

In an exemplary implementation mode, as shown in FIG. 13, the transparent conductive layer may further include a power supply connection line VCL, and at least part of the power supply connection line extends along the second direction X. The power supply connection line VCL is electrically connected with first power supply lines VDD electrically connected with two adjacent pixel circuits located in a same row respectively, and the first power supply lines VDD and the power supply connection line VCL are electrically connected through a connection electrode located in the third conductive layer.

In an exemplary implementation mode, as shown in FIG. 13, for a same first type pixel circuit, a first power supply line VDD may include a power supply main body portion VDDM extending along the first direction Y and a power supply connection portion VDDS extending at least partially along the second direction X, and the power supply connection portion VDDS is located on a side of the power supply main body portion VDDM away from a data signal line. The power supply connection line VDDS is electrically connected with a power supply connection portion of one first type pixel circuit and a power supply main body portion of the other first type pixel circuit of adjacent first type pixel circuits located in a same row respectively.

In an exemplary implementation mode, as shown in FIG. 14, a sub-signal line of the first signal line may be in a polyline type, and at least part of the sub-signal line of the first signal line may extend along the second direction X.

In an exemplary implementation mode, as shown in FIG. 14, an anode connection line may include a first anode connection line AL1, a second anode connection line AL2, and a third anode connection line AL3; the first anode connection line AL1, the second anode connection line AL2, and the third anode connection line AL3 may be in a polyline type. Among them, the first anode connection line AL1 is electrically connected with a first pixel circuit and a first light emitting element respectively and at least part of the first anode connection line AL1 extends along the second direction X; the second anode connection line AL2 is electrically connected with a second pixel circuit and a second light emitting element respectively and at least part of the second anode connection line AL2 extends along the second direction X; the third anode connection line AL3 is electrically connected with a third pixel circuit and a third light emitting element respectively and at least part of the third anode connection line AL3 extends along the second direction X.

In an exemplary implementation mode, as shown in FIG. 14, data signal lines Data electrically connected with pixel circuits located in a same column are a same signal line.

In an exemplary implementation mode, as shown in FIG. 14, first power supply lines VDD electrically connected with at least two adjacent first type pixel circuits located in a same column are disposed at intervals, and the first power supply lines VDD disposed at intervals located in the same column are electrically connected through at least one signal connection line located in the fourth conductive layer.

A structure of the display substrate will be described below through an example of a preparation process of the display substrate. A "patterning process" mentioned in the embodiments of the present disclosure includes a treatment such as photoresist coating, mask exposure, development, etching, and photoresist stripping for a metal material, an inorganic material, or a transparent conductive material, and includes a treatment such as organic material coating, mask exposure, and development for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on the base substrate using deposition, coating, or another process. If the "thin film" does not need a patterning process in an entire manufacturing process, the "thin film" may also be called a "layer". If the "thin film" needs the patterning process in the entire manufacturing process, the "thin film" is called a "thin film" before the patterning process and is called a "layer" after the patterning process. At least one "pattern" is contained in the "layer" after the patterning process.

In an exemplary implementation mode, a preparation process of the light-transmitting display region provided in FIG. 12 may include following operations.

(1) A pattern of a semiconductor layer is formed. In an exemplary implementation mode, forming the pattern of the semiconductor layer may include: depositing a semiconductor thin film sequentially on a base substrate and patterning the semiconductor thin film through a patterning process to form the pattern of the semiconductor layer, as shown in FIG. 15A, wherein FIG. 15A is a schematic diagram of the light-transmitting display region provided in FIG. 12 after a pattern of a semiconductor is formed.

In an exemplary implementation mode, as shown in FIG. 15A, the pattern of the semiconductor layer includes an active layer T11 of a first transistor to an active layer T71 of a seventh transistor. The active layer T11 of the first transistor T1 to the active layer T71 of the seventh transistor may be of an interconnected integral structure.

In an exemplary implementation mode, as shown in FIG. 15A, in the second direction X, the active layer T21 of the second transistor, the active layer T61 of the sixth transistor, and the active layer T71 of the seventh transistor may be located on a same side of the active layer T31 of the third transistor in a present sub-pixel, the active layer T41 of the fourth transistor and the active layer T51 of the fifth transistor may be located on a same side of the active layer T31 of the third transistor in the present sub-pixel, and the active layer T21 of the second transistor and the active layer T41 of the fourth transistor may be located on different sides of the active layer T31 of the third transistor in the present sub-pixel. In the first direction Y, the active layer T11 of the first transistor, the active layer T21 of the second transistor, the active layer T41 of the fourth transistor, and the active layer T71 of the seventh transistor may be located on a same side of the active layer T31 of the third transistor in the present sub-pixel, and the active layer T51 of the fifth transistor and the active layer T61 of the sixth transistor may be located on the other side of the active layer T31 of the third transistor in the present sub-pixel.

In an exemplary implementation mode, as shown in FIG. 15A, the active layer T11 of the first transistor may be in an "n" shape, the active layer T21 of the second transistor may be in an "L" shape, the active layer T31 of the third transistor may be in an "Q" shape, and the active layer T41 of the fourth transistor, the active layer T51 of the fifth transistor, the active layer T61 of the sixth transistor, and the active layer T71 of the seventh transistor may be in an "I" shape.

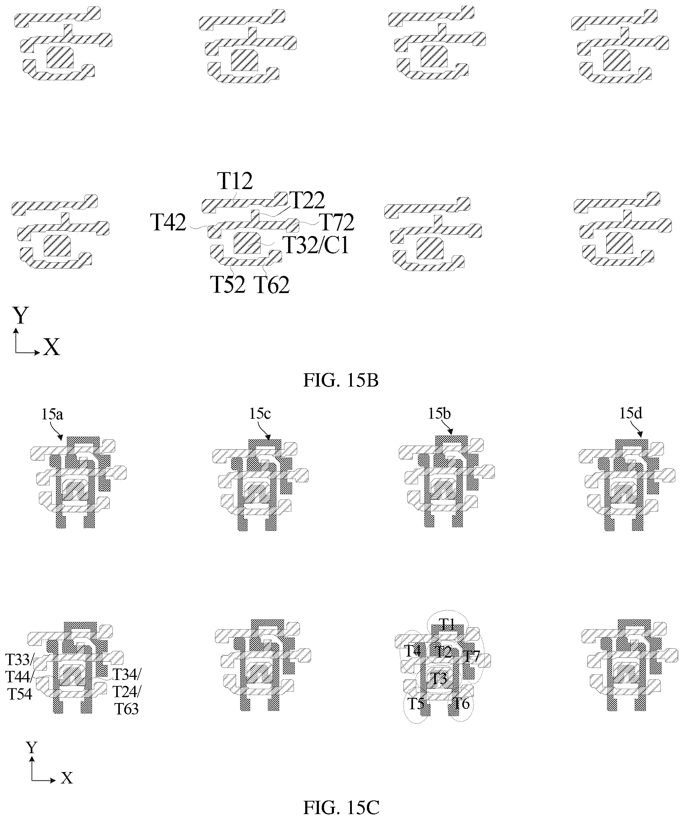

(2) A pattern of a first conductive layer is formed. In an exemplary implementation mode, forming the pattern of the first conductive layer may include: depositing sequentially a first insulation thin film and a first conductive thin film on the base substrate on which the aforementioned pattern is formed, and patterning the first conductive thin film through a patterning process to form a first insulation layer covering the pattern of the semiconductor layer and form the pattern of the first conductive layer located on the first insulation layer, as shown in FIG. 15B and FIG. 15C, wherein FIG. 15B is a schematic diagram of the pattern of the first conductive layer of the light-transmitting display region provided in FIG. 12, and FIG. 15C is a schematic diagram of the light-transmitting display region provided in FIG. 12 after the pattern of the first conductive layer is formed. In an exemplary implementation mode, the first conductive layer may be referred to as a first gate metal (GATE1) layer.

In an exemplary implementation mode, as shown in FIG. 15B and FIG. 15C, the pattern of the first conductive layer may include a control electrode T12 of the first transistor to a control electrode T72 of the seventh transistor, and a first electrode plate C1 of a capacitor.

In an exemplary implementation mode, as shown in FIG. 15B and FIG. 15C, the first electrode plate C1 of the capacitor may be in a shape of a rectangle, and chamfers may be disposed at corners of the rectangle. An orthographic projection of the first electrode plate C1 of the capacitor on the base substrate is at least partially overlapped with an orthographic projection of the active layer of the third transistor T3 on the base substrate. In an exemplary implementation mode, the first electrode plate C1 of the capacitor may simultaneously serve as a control electrode T32 of the third transistor.

In an exemplary implementation mode, as shown in FIG. 15B and FIG. 15C, the control electrode T12 of the first transistor may be in a shape of a line extending along the second direction X.

In an exemplary implementation mode, as shown in FIG. 15B and FIG. 15C, a control electrode T22 of the second transistor, a control electrode T42 of the fourth transistor, and the control electrode T72 of the seventh transistor may be of an integrally formed structure, and may be in a shape of a line extending along the second direction X.

In an exemplary implementation mode, as shown in FIG. 15B and FIG. 15C, a control electrode T52 of the fifth transistor and a control electrode T62 of the sixth transistor may be of an integrally formed structure, and may be in a shape of a line extending along the second direction X.

In an exemplary implementation mode, as shown in FIG. 15C, after the pattern of the first conductive layer is formed, the semiconductor layer may be subjected to a conductorization treatment by using the first conductive layer as a shield, the semiconductor layer in a region shielded by the first conductive layer forms channel regions of the first transistor T1 to the seventh transistor T7, the semiconductor layer in a region not shielded by the first conductive layer is made to be conductive, that is, first regions and second regions of active layers of the first transistor to the seventh transistor are both made to be conductive, and a first region of the active layer of the third transistor (which is also a second region of the active layer of the fourth transistor and the second region of the active layer of the fifth transistor) after conductorization may simultaneously serve as a first electrode T33 of the third transistor, a second electrode T44 of the fourth transistor, and a second electrode T54 of the fifth transistor, and a second region of the active layer of the third transistor (which is also a second region of the active layer of the second transistor and a first region of the active layer of the sixth transistor) after conductorization may simultaneously serve as a second electrode T24 of the second transistor, a second electrode T34 of the third transistor, and a first electrode T63 of the sixth transistor.

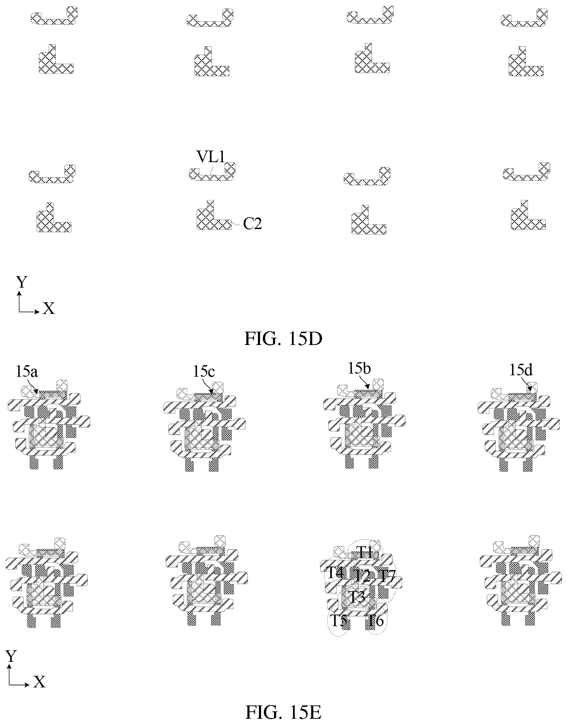

(3) A pattern of a second conductive layer is formed. In an exemplary implementation mode, forming the pattern of the second conductive layer may include: depositing a second insulation layer thin film and a second conductive thin film on the base substrate on which the aforementioned patterns are formed, and patterning the second conductive thin film using a patterning process to form the pattern of the second conductive layer on the second insulation layer. As shown in FIG. 15D and FIG. 15E, FIG. 15D is a schematic diagram of the pattern of the second conductive layer of the light-transmitting display region provided in FIG. 12, and FIG. 15E is a schematic diagram of the light-transmitting display region provided in FIG. 12 after the pattern of the second conductive layer is formed. In an exemplary implementation mode, the second conductive layer may be referred to as a second gate metal (GATE2) layer.

In an exemplary implementation mode, as shown in FIG. 15D and FIG. 15E, the pattern of the second conductive layer may include a first connection electrode VL1 and a second electrode plate C2 of the capacitor.

In an exemplary implementation mode, as shown in FIG. 15D and FIG. 15E, at least part of the first connection electrode VL1 may extend along the second direction X.

In an exemplary implementation mode, as shown in FIG. 15D and FIG. 15E, a contour shape of the second electrode plate C2 may be an "L" shape, there is an overlapping region between an orthographic projection of the second electrode plate C2 on the base substrate and an orthographic projection of the first electrode plate C1 on the base substrate, and the second electrode plate C2 serves as another electrode plate of the capacitor. The first electrode plate C1 and the second electrode plate C2 constitute capacitance of a pixel circuit.

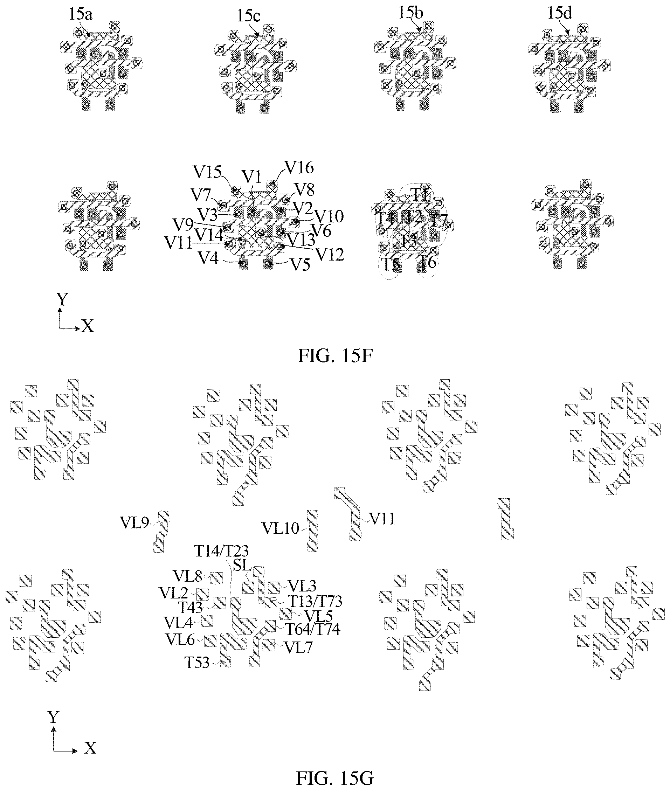

(4) A pattern of a third insulation layer is formed. In an exemplary implementation mode, forming the pattern of the third insulation layer may include: depositing a third insulation thin film on the base substrate on which the aforementioned patterns are formed, and patterning the third insulation thin film using a patterning process to form the third insulation layer covering the second conductive layer, wherein multiple vias are disposed on the third insulation layer, as shown in FIG. 15F, FIG. 15F is a schematic diagram of the light-transmitting display region provided in FIG. 12 after the pattern of the third insulation layer is formed.

In an exemplary implementation mode, as shown in FIG. 15F, the multiple vias may each include a first via V1 to a sixth via disposed in the first insulation layer to the third insulation layer, a seventh via V7 to a thirteenth via V13 disposed in the second insulation layer and the third insulation layer, and a fourteenth via V14 to a sixteenth via V16 disposed on the third insulation layer. Among them, the first via V1 exposes a connection portion of the active layer of the first transistor and the active layer of the second transistor, the second via V2 exposes a connection portion of the active layer of the first transistor and the active layer of the seventh transistor, the third via V3 exposes the active layer of the fourth transistor, the fourth via V4 exposes the active layer of the fifth transistor, the fifth via V5 exposes the active layer of the sixth transistor, the sixth via V6 exposes the active layer of the seventh transistor, the seventh via V7 and the eighth via V8 respectively expose both ends of the control electrode of the first transistor, the ninth via V9 and the tenth via V10 respectively expose both ends of an integrally formed structure of the control electrode of the second transistor, the control electrode of the fourth transistor, and the control electrode of the seventh transistor, the eleventh via V11 and the twelfth Via V12 respectively expose both ends of an integrally formed structure of the control electrode of the fifth transistor and the control electrode of the sixth transistor, the thirteenth via V13 exposes the first electrode plate of the capacitor, the fourteenth via V14 exposes the second electrode plate of the capacitor, and the fifteenth via V15 and the sixteenth via V16 expose both ends of the first connection electrode respectively.

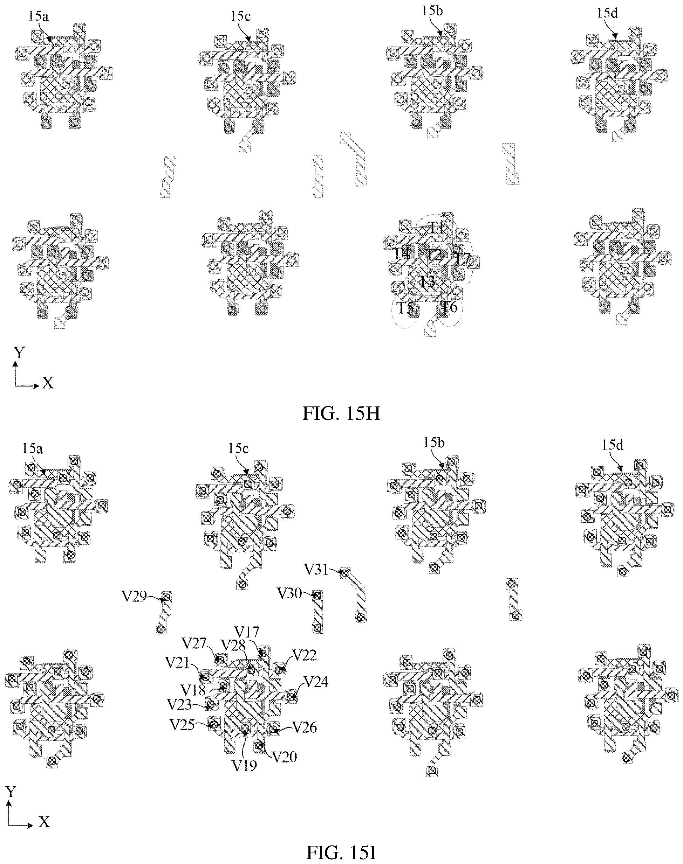

(5) A pattern of a third conductive layer is formed. In an exemplary implementation mode, forming the pattern of the third conductive layer may include: depositing a third conductive thin film on the base substrate on which the aforementioned patterns are formed, and patterning the third conductive thin film using a patterning process to form the third conductive layer disposed on the third insulation layer, as shown in FIG. 15G and FIG. 15H, wherein FIG. 15G is a schematic diagram of the pattern of the third conductive layer of the light-transmitting display region provided in FIG. 12, and FIG. 15H is a schematic diagram of the light-transmitting display region provided in FIG. 12 after the pattern of the third conductive layer is formed. In an exemplary implementation mode, the third conductive layer may be referred to as a first source-drain metal (SD1) layer.

In an exemplary implementation mode, as shown in FIG. 15G and FIG. 15H, the pattern of the third conductive layer may include a first electrode T13 and a second electrode T14 of the first transistor, a first electrode T23 of the second transistor, a first electrode T43 of the fourth transistor, a first electrode T53 of the fifth transistor, a second electrode T64 of the sixth transistor, a first electrode T73 and a second electrode T74 of the seventh transistor, a second connection electrode VL2 to an eleventh connection electrode VL11, and a shield electrode SL.

In an exemplary implementation mode, as shown in FIG. 15G and FIG. 15H, the first electrode T13 of the first transistor may simultaneously serve as the first electrode T73 of the seventh transistor, the second electrode T14 of the first transistor may simultaneously serve as the first electrode T23 of the second transistor, the second electrode T64 of the sixth transistor may simultaneously serve as the second electrode T74 of the seventh transistor, and the first electrode T43 of the fourth transistor and the first electrode T53 of the fifth transistor may be disposed separately. The first electrode T13 of the first transistor and the second electrode T14 of the first transistor may be in an "L" shape, the first electrode T43 of the fourth transistor may be of a block structure, the first electrode T53 of the fifth transistor is in a horizontally inverted "L" shape, and the second electrode of the sixth transistor may be in a polyline type extending along the first direction Y.

In an exemplary implementation mode, as shown in FIG. 15G and FIG. 15H, the second connection electrode VL2 to the eighth connection electrode VL8 are of a block structure, and the ninth connection electrode VL9 to the eleventh connection electrode VL11 are in a line shape or a polyline type extending along the first direction Y.

In an exemplary implementation mode, as shown in FIG. 15G and FIG. 15H, the shield electrode SL is of a block structure, and an orthographic projection of the shield electrode SL on the base substrate is partially overlapped with an orthographic projection of the control electrode of the first transistor on the base substrate.

In an exemplary implementation mode, as shown in FIG. 15G and FIG. 15H, the first electrode T13 of the first transistor is electrically connected with a connection point of the active layer of the first transistor and the active layer of the seventh transistor through the second via, and is electrically connected with the first connection electrode through the sixteenth via. The second electrode T14 of the first transistor is electrically connected with a connection point of the active layer of the first transistor and the active layer of the second transistor through the first via, and the thirteenth via is electrically connected with the first electrode plate of the capacitor. The first electrode T43 of the fourth transistor is electrically connected with the active layer of the fourth transistor through the third via. The first electrode T53 of the fifth transistor is electrically connected with the active layer of the fifth transistor through the fourth via, and is electrically connected with the second electrode plate of the capacitor through the fourteenth via. The second electrode T64 of the sixth transistor is electrically connected with the active layer of the sixth transistor through the fifth via, and is electrically connected with the active layer of the seventh transistor through the sixth via. The second connection electrode VL2 is electrically connected with the control electrode of the first transistor through the seventh via. The third connection electrode VL3 is electrically connected with the control electrode of the first transistor through the eighth via. The fourth connection electrode VL4 is electrically connected with the control electrode of the fourth transistor through the ninth via. The fifth connection electrode VL5 is electrically connected with the control electrode of the fourth transistor through the tenth via. The sixth connection electrode VL6 is electrically connected with the control electrode of the fifth transistor through the eleventh via. The seventh connection electrode VL7 is electrically connected with the control electrode of the fifth transistor through the twelfth via. The eighth connection electrode VL8 is electrically connected with the first connection electrode through the fifteenth via.

(6) A fourth insulation layer is formed. In an exemplary implementation mode, forming a pattern of the fourth insulation layer may include: depositing a fourth insulation thin film on the base substrate on which the aforementioned patterns are formed, and patterning the fourth insulation thin film using a patterning process to form the fourth insulation layer covering the third conductive layer, wherein multiple vias are disposed on the fourth insulation layer, as shown in FIG. 15I. FIG. 15I is a schematic diagram of the light-transmitting display region provided in FIG. 12 after the pattern of the fourth insulation layer is formed.

In an exemplary implementation mode, as shown in FIG. 15I, the multiple vias of the pattern of the fourth insulation layer may each include a seventeenth via V17 to a thirty-first via V31. Among them, the seventeenth via V17 exposes the first electrode of the first transistor, the eighteenth via V18 exposes the first electrode of the fourth transistor, the nineteenth via V19 exposes the first electrode of the fifth transistor, the twentieth via V20 exposes the second electrode of the sixth transistor, the twenty-first via V21 exposes the second connection electrode, the twenty-second via V22 exposes the third connection electrode, the twenty-third via V23 exposes the fourth connection electrode, the twenty-fourth via V24 exposes the fifth connection electrode, the twenty-fifth via V25 exposes the sixth connection electrode, the twenty-sixth via V26 exposes the seventh connection electrode, the twenty-seventh via V27 exposes the eighth connection electrode, the twenty-eighth via V28 exposes the shield electrode, the twenty-ninth via V29 exposes the nineteenth connection electrode, the thirtieth via V30 exposes the tenth connection electrode, and the thirty-first via V31 exposes the eleventh connection electrode.

In an exemplary implementation mode, a quantity of twenty-ninth vias V29 may be two, and the two twenty-ninth vias may be arranged along the first direction Y and are respectively located at both ends of the ninth connection electrode.

In an exemplary implementation mode, a quantity of thirtieth vias V30 may be two, and the two thirtieth vias V30 may be arranged along the first direction Y and are respectively located at both ends of the tenth connection electrode.

In an exemplary implementation mode, a quantity of thirty-first vias V31 may be two, and the two thirty-first vias V31 may be arranged along the first direction Y and are respectively located at both ends of the eleventh connection electrode.

(7) A pattern of a transparent conductive layer is formed. In an exemplary implementation mode, forming the pattern of the transparent conductive layer may include: depositing a transparent conductive thin film on the base substrate on which the aforementioned patterns are formed, and patterning the transparent conductive thin film using a patterning process to form the transparent conductive layer disposed on the fourth insulation layer, as shown in FIG. 15J and FIG. 15K, wherein FIG. 15J is a schematic diagram of the pattern of the transparent conductive layer of the light-transmitting display region provided in FIG. 12, and FIG. 15K is a schematic diagram of the light-transmitting display region provided in FIG. 12 after the pattern of the transparent conductive layer is formed.

In an exemplary implementation mode, as shown in FIG. 15J and FIG. 15K, the pattern of the transparent conductive layer may include a data signal line Data, a first power supply line VDD, a first anode connection line AL1, a second anode connection line AL2, a third anode connection line AL3, a fourth anode connection line AL4, two sub-signal lines INIT_1 and INIT_2 of an initial signal line, two sub-signal lines RST_1 and RST_2 of a reset signal line, two sub-signal lines Gate_1 and Gate_2 of a scan signal line, two sub-signal lines EM_1 and EM_2 of a light emitting signal line, a twelfth connection electrode VL12, and a thirteenth connection electrode VL13.

In an exemplary implementation mode, as shown in FIG. 15J and FIG. 15K, the data signal line Data and the first power supply line VDD may be located between two sub-signal lines of multiple first signal lines electrically connected with a first type pixel circuit with which the data signal line Data and the first power supply line VDD are electrically connected, and orthographic projections of the data signal line Data and the first power supply line VDD on the base substrate are overlapped with an orthographic projection of the first type pixel circuit on the base substrate.

In an exemplary implementation mode, as shown in FIG. 15J and FIG. 15K, the data signal line Data may be in a polyline type, at least part of the data signal line Data may extend along the first direction Y, and data signal lines Data electrically connected with adjacent first type pixel circuits located in a same column may be a same signal line, or may be disposed at intervals. Data signal lines Data disposed at intervals and electrically connected with two adjacent first type pixel circuits located in a same column may be electrically connected with the ninth connection electrode through the twenty-ninth via respectively, and data signal lines Data electrically connected with first type pixel circuits disposed at intervals in a same column may be electrically connected through the ninth connection electrode. A data signal line is electrically connected with a first electrode of a fourth transistor of a first type pixel circuit electrically connected through the eighteenth via.

In an exemplary implementation mode, as shown in FIG. 15J and FIG. 15K, the first power supply line VDD may be in a polyline type, at least part of the first power supply line VDD may extend along the first direction Y, and first power supply lines VDD electrically connected with adjacent first type pixel circuits located in a same column may be disposed at intervals. A first power supply line is electrically connected with a first electrode of a fifth transistor of a first type pixel circuit electrically connected through the nineteenth via, and is electrically connected with a shield electrode through the twenty-eighth via. Exemplarily, first power supply lines VDD disposed at intervals and electrically connected with two adjacent first type pixel circuits in a same column may be directly electrically connected through a tenth connection electrode, or may be electrically connected through the tenth connection electrode, a twelfth connection electrode, and the tenth connection electrode respectively. A first power supply line VDD and the twelfth connection electrode electrically connected with a first type pixel circuit may be electrically connected with the tenth connection electrode through the thirtieth via.

In an exemplary implementation mode, the first anode connection line AL1 to the fourth anode connection line AL4 may be in a polyline type.

In an exemplary implementation mode, as shown in FIG. 15J and FIG. 15K, the first anode connection line AL1 is located between first power supply lines disposed at intervals, at least part of the first anode connection line AL1 extends along the second direction X, and the first anode connection line AL1 is electrically connected with a second electrode of a sixth transistor of a first type pixel circuit electrically connected through the twentieth via.

In an exemplary implementation mode, as shown in FIG. 15J and FIG. 15K, the second anode connection line AL2 is located between first power supply lines disposed at intervals, at least part of the second anode connection line AL2 extends along the second direction X, and the second anode connection line AL2 is electrically connected with a second electrode of a sixth transistor of a first type pixel circuit electrically connected through the twentieth via, and is electrically connected with the eleventh connection electrode through the thirty-first via.

In an exemplary implementation mode, as shown in FIG. 15J and FIG. 15K, the third anode connection line AL3 is located between a data signal line Data and a first power supply line VDD electrically connected with an electrically connected first type pixel circuit, and at least part of the third anode connection line AL3 extends along the second direction X. The third anode connection line AL3 is electrically connected with a second electrode of a sixth transistor of the electrically connected first type pixel circuit through the twentieth via.

In an exemplary implementation mode, as shown in FIG. 15J and FIG. 15K, the fourth anode connection line AL4 is located between a data signal line Data and a first power supply line VDD electrically connected with an electrically connected first type pixel circuit, and at least part of the fourth anode connection line AL4 extends along the second direction X. The fourth anode connection line AL4 is electrically connected with a second electrode of a sixth transistor of the electrically connected first type pixel circuit through the twentieth via.

In an exemplary implementation mode, as shown in FIG. 15J and FIG. 15K, at least part of the thirteenth connection electrode VL13 extends along the second direction X and is electrically connected with the eleventh connection electrode through the thirty-first via. The second anode connection line AL1 is electrically connected with an electrically connected first type pixel circuit, the eleventh connection electrode, and the thirteenth connection electrode respectively.

In an exemplary implementation mode, as shown in FIG. 15J and FIG. 15K, two sub-signal lines INIT_1 and INIT_2 of the initial signal line may be in a polyline type, at least parts of the two sub-signal lines INIT_1 and INIT_2 of the initial signal line may extend along the second direction X, a sub-signal line INIT_1 of the initial signal line is electrically connected with the eighth connection electrode through the twenty-seventh via, and a sub-signal line INIT_2 of the initial signal line is electrically connected with the first electrode of the first transistor through the seventeenth via. The sub-signal line INIT_1 of the initial signal line is electrically connected with the first connection electrode through the eighth connection electrode. The sub-signal line INIT_2 of the initial signal line is electrically connected with the first connection electrode through the first electrode of the first transistor.

In an exemplary implementation mode, as shown in FIG. 15J and FIG. 15K, two sub-signal lines RST_1 and RST_2 of the reset signal line may be in a polyline type, at least parts of the two sub-signal lines RST_1 and RST_2 of the reset signal line may extend along the second direction X, a sub-signal line RST_1 of the reset signal line is electrically connected with the second connection electrode through the twenty-first via, and a sub-signal line RST_2 of the reset signal line is electrically connected with the third connection electrode through the twenty-second via. The sub-signal line RST_1 of the reset signal line is electrically connected with the control electrode of the first transistor through the second connection electrode, and the sub-signal line RST_2 of the reset signal line is electrically connected with the control electrode of the first transistor through the third connection electrode.

In an exemplary implementation mode, as shown in FIG. 15J and FIG. 15K, two sub-signal lines Gate_1 and Gate_2 of the scan signal line may be in a polyline type, at least parts of the two sub-signal lines Gate_1 and Gate_2 of the scan signal line may extend along the second direction X, a sub-signal line Gate_1 of the scan signal line is electrically connected with the fourth connection electrode through the twenty-third via, and a sub-signal line Gate_2 of the scan signal line is electrically connected with the fifth connection electrode through the twenty-fourth via. The sub-signal line Gate_1 of the scan signal line is electrically connected with the control electrode of the fourth transistor through the fourth connection electrode, and the sub-signal line Gate_2 of the scan signal line is electrically connected with the control electrode of the fourth transistor through the fifth connection electrode.

In an exemplary implementation mode, as shown in FIG. 15J and FIG. 15K, two sub-signal lines EM_1 and EM_2 of the light emitting signal line may be in a polyline type, at least parts of the two sub-signal lines EM_1 and EM_2 of the light emitting signal line may extend along the second direction X, a sub-signal line EM_1 of the light emitting signal line is electrically connected with the sixth connection electrode through the twenty-fifth via, and a sub-signal line EM_1 of the light emitting signal line is electrically connected with the seventh connection electrode through the twenty-sixth via. The sub-signal line EM_1 of the light emitting signal line is electrically connected with the control electrode of the fifth transistor through the sixth connection electrode, and the sub-signal line EM_2 of the light emitting signal line is electrically connected with the control electrode of the fifth transistor through the seventh connection electrode.

(8) A pattern of a first planarization layer is formed. In an exemplary implementation mode, forming the pattern of the first planarization layer may include: depositing a first planarization thin film on the base substrate on which the aforementioned patterns are formed, and forming the pattern of the first planarization layer disposed on the transparent conductive layer, wherein the pattern of the first planarization layer includes multiple vias, as shown in FIG. 15L, wherein FIG. 15L is a schematic diagram of the light-transmitting display region provided in FIG. 12 after the first planarization layer is formed.

In an exemplary implementation mode, as shown in FIG. 15L, the pattern of the first planarization layer may include a thirty-second via V32 and a thirty-eighth via V38. Among them, the thirty-second via V32 exposes the first anode connection line, the thirty-third via V33 exposes the second anode connection line, the thirty-fourth via V34 exposes the third anode connection line, the thirty-fifth via V35 exposes the fourth anode connection line, the thirty-sixth via V36 exposes the thirteenth connection electrode, the thirty-seventh via V37 exposes the first power supply line VDD, and the thirty-eighth via V38 exposes the twelfth connection electrode.

In an exemplary implementation mode, as shown in FIG. 15L, a quantity of thirty-second vias V32 may be two, which are located at both ends of the first anode connection line respectively. A quantity of thirty-third vias V33 may be two, which are located at both ends of the second anode connection line respectively. A quantity of thirty-fourth vias V34 may be two, which are located at both ends of the third anode connection line respectively. A quantity of thirty-fifth vias V35 may be two, which are located at both ends of the fourth anode connection line respectively.

(9) A pattern of a fourth conductive layer is formed. In an exemplary implementation mode, forming the pattern of the fourth conductive layer may include: depositing a fourth conductive thin film on the base substrate on which the aforementioned patterns are formed and patterning the fourth conductive thin film using a patterning process to form the fourth conductive layer disposed on the first planarization layer, as shown in FIG. 15M and FIG. 15N, wherein FIG. 15M is a schematic diagram of the pattern of the fourth conductive layer of the light-transmitting display region provided in FIG. 12, and FIG. 15N is a schematic diagram of the light-transmitting display region provided in FIG. 12 after the pattern of the fourth conductive layer is formed. In an exemplary implementation mode, the fourth conductive layer may be referred to as a second source-drain metal (SD2) layer.

In an exemplary implementation mode, as shown in FIG. 15M and FIG. 15N, the pattern of the fourth conductive layer may include a fourteenth connection electrode VL14 to a twenty-first connection electrode VL21, a first signal connection line VDL1, and a second signal connection line VDL2.

In an exemplary implementation mode, as shown in FIG. 15M and FIG. 15N, the fourteenth connection electrode VL14 to the twenty-first connection electrode VL21 are of a block structure. The first signal connection line VDL1 and the second signal connection line VDL2 may be in a polyline type, and at least parts of the first signal connection line VDL1 and the second signal connection line VDL2 extend along the first direction Y.

In an exemplary implementation mode, as shown in FIG. 15M and FIG. 15N, the fourteenth connection electrode VL14 and the fifteenth connection electrode VL15 are electrically connected with the first anode connection line through the thirty-second via, the sixteenth connection electrode VL1 is electrically connected with the second anode connection line through the thirty-third via, the seventeenth connection electrode VL17 is electrically connected with the thirteenth connection electrode through the thirty-sixth via, the eighteenth connection electrode VL18 and the nineteenth connection electrode VL19 are electrically connected with the third anode connection line through the thirty-fourth via, and the twentieth via V20 and the twenty-first via V21 are electrically connected with the fourth anode connection line through the thirty-fifth via. The first signal connection line VDL1 is electrically connected with a first power supply line VDD electrically connected with a first type pixel circuit through the thirty-seventh via, and the second signal connection line VDL2 is electrically connected with the twelfth connection electrode through the thirty-eighth via and is electrically connected with the first power supply line through the thirty-seventh via.

In an exemplary implementation mode, first power supply lines electrically connected with first type pixel circuits located in a same column are communicated through a first power supply connection line, the tenth connection electrode, and a second power supply connection line. Data signal lines electrically connected with first type pixel circuits located in a same column are communicated through the ninth connection electrode.

In an exemplary embodiment, as shown in FIG. 15N, the fourteenth connection electrode VL14 is electrically connected with the fifteenth connection electrode VL15 through the first anode connection line, the sixteenth connection electrode VL16 is electrically connected with the seventeenth connection electrode VL17 through the second anode connection line, the eleventh connection electrode, and the thirteenth connection electrode, the eighteenth connection electrode VL18 is electrically connected with the nineteenth connection electrode VL19 through the third anode connection line, and the twentieth connection electrode VL20 is electrically connected with the twenty-first connection electrode VL21 through the fourth anode connection line.

In an exemplary implementation mode, multiple connection electrodes play a role of undertaking, which may avoid unreliability of a connection caused by opening a relatively deep via and improve reliability of a display panel.

(10) A pattern of a second planarization layer is formed. In an exemplary implementation mode, forming the pattern of the second planarization layer may include: coating a second planarization thin film on the base substrate on which the aforementioned patterns are formed, and patterning the second planarization thin film using a patterning process to form the second planarization layer covering the fourth conductive layer, wherein multiple vias are disposed on the second planarization layer, as shown in FIG. 15O, wherein FIG. 15O is a schematic diagram of the light-transmitting display region provided in FIG. 12 after the pattern of the second planarization layer is formed.

In an exemplary implementation mode, as shown in FIG. 15O, the multiple vias of the pattern of the second planarization layer may each include a thirty-ninth via V39 to a forty-sixth via V46. Among them, the thirty-ninth via V39 exposes the fourteenth connection electrode, the fortieth via V40 exposes the fifteenth connection electrode, the forty-first via V41 exposes the sixteenth connection electrode, the forty-second via V42 exposes the seventeenth connection electrode, the forty-third via V43 exposes the eighteenth connection electrode, the forty-fourth via V44 exposes the nineteenth connection electrode, the forty-fifth via V45 exposes the twentieth connection electrode, and the forty-sixth via V46 exposes the twenty-first connection electrode.

So far, preparation of a drive circuit layer on the base substrate is completed. On a plane parallel to the display substrate, the drive circuit layer may include the multiple first type pixel circuits, the scan signal line, the reset signal line, the light emitting signal line, the data signal line, the initial signal line, and the first anode connection line to the fourth anode connection line. On a plane perpendicular to the display panel, the drive circuit layer may include the semiconductor layer, the first insulation layer, the first conductive layer, the second insulation layer, the second conductive layer, the third insulation layer, the third conductive layer, the fourth insulation layer, the transparent conductive layer, the first planarization layer, the fourth conductive layer, and the second planarization layer which are stacked sequentially on the base substrate.

In an exemplary implementation mode, the base substrate may be a flexible base substrate, or a rigid base substrate. The rigid base substrate may be, but is not limited to, one or more of glass and quartz. The flexible base substrate may be, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the first conductive layer, the second conductive layer, the third conductive layer, the fourth conductive layer, and the fifth conductive layer may be made of a metal material, such as any one or more of Argentum (Ag), Copper (Cu), Aluminum (Al), and Molybdenum (Mo), or an alloy material of the aforementioned metals, such as an Aluminum-Neodymium alloy (AlNd) or a Molybdenum-Niobium alloy (MoNb), and may be of a single-layer structure, or a multi-layer composite structure such as Mo/Cu/Mo.

In an exemplary embodiment, for the transparent conductive layer, such as Indium Tin Oxide (ITO) or Indium Zinc Oxide (IZO) may be adopted, or a multi-layer composite structure, such as ITO/Ag/ITO, may be adopted.

In an exemplary implementation mode, the first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first insulation layer may be referred to as a buffer layer, the second insulation layer may be referred to as a Gate Insulator (GI) layer, the third insulation layer may be referred to as an Interlayer Dielectric (ILD) layer, and the fourth insulation layer may be referred to as a Passivation (PVX) layer. The first planarization layer and the second planarization layer may be made of an organic material, such as resin. The semiconductor layer may be made of a material, such as an amorphous Indium Gallium Zinc Oxide material (a-IGZO), Zinc Oxynitride (ZnON), Indium Zinc Tin Oxide (IZTO), amorphous Silicon (a-Si), polycrystalline Silicon (p-Si), sexithiophene, or polythiophene, that is, the present disclosure is applicable to a transistor manufactured based on an oxide technology, a silicon technology, or an organic matter technology.

In an exemplary implementation mode, after preparation of the drive circuit layer is completed, a light emitting structure layer is prepared on the drive circuit layer, and a preparation process of the light emitting structure layer may include following operations.

(11) A pattern of an anode conductive layer is formed. In an exemplary implementation mode, forming the pattern of the anode conductive layer may include: depositing an anode conductive thin film on the base substrate on which the aforementioned patterns are formed and patterning the anode conductive thin film using a patterning process to form the pattern of the anode conductive layer disposed on the second planarization layer, as shown in FIG. 15P and FIG. 15Q, wherein FIG. 15P is a schematic diagram of the pattern of the anode conductive layer of the light-transmitting display region provided in FIG. 12, and FIG. 15Q is a schematic diagram of the light-transmitting display region provided in FIG. 12 after the pattern of the anode conductive layer is formed.

In an exemplary implementation mode, the anode conductive layer may be of a single-layer structure, such as Indium Tin Oxide (ITO) or Indium Zinc Oxide (IZO), or may be of a multi-layer composite structure, such as ITO/Ag/ITO.

In an exemplary implementation mode, the pattern of the anode conductive layer may include anodes 110 of first light emitting elements 11a and 11b, anodes 120 of a second light emitting element, and anodes 130 of third light emitting elements 13a to 13d.

In an exemplary implementation mode, an anode of a first light emitting element 11a is electrically connected with the fourteenth connection electrode through the thirty-ninth via, an anode of a first light emitting element 11b is electrically connected with the fifteenth connection electrode through the fortieth via, an anode of a second light emitting element 12b is electrically connected with the sixteenth connection electrode through the forty-first via, an anode of a second light emitting element 12a is electrically connected with the seventeenth connection electrode through the forty-second via, an anode of a third light emitting element 13a is electrically connected with the eighteenth connection electrode through the forty-third via, an anode of a third light emitting element 13b is electrically connected with the nineteenth connection electrode through the forty-fourth via, an anode of a third light emitting element 13c is electrically connected with the twentieth connection electrode through the forty-fifth via, and an anode of a third light emitting element 13d is electrically connected with the twenty-first connection electrode through the forty-sixth via.

In an exemplary implementation mode, the anode of the first light emitting element 11a is electrically connected with the anode of the first light emitting element 11b through the fourteenth connection electrode, the first anode connection line, and the fifteenth connection electrode. The anode of the second light emitting element 12a is electrically connected with the anode of the second light emitting element 12b through the sixteenth connection electrode, the eleventh connection electrode, the thirteenth connection electrode, and the seventeenth connection electrode. The anode of the third light emitting element 13a is electrically connected with the anode of the third light emitting element 13b through the eighteenth connection electrode, the third anode connection line, and the nineteenth connection electrode. The anode of the third light emitting element 13c is electrically connected with the anode of the third light emitting element 13d through the twentieth connection electrode, the fourth anode connection line, and the twenty-first connection electrode.

In an exemplary implementation mode, at least one of the anodes 110 of the first light emitting elements 11a and 11b, the anode 120 of the second light emitting element, and the anodes 130 of the third light emitting elements 13a to 13d may include a main body portion and a connection portion connected with each other, a shape of the main body portion may be a rectangular shape, arc-shaped chamfers may be disposed at corners of the rectangular shape, and a shape of the connection portion may be a strip shape extending along a direction away from the main body portion.

In an exemplary implementation mode, a subsequent preparation process may include: forming a pattern of a pixel definition layer at first, then forming an organic emitting layer using an evaporation process or an inkjet printing process, then forming a cathode on the organic emitting layer, and then forming an encapsulation structure layer, wherein the encapsulation structure layer may include a first encapsulation layer, a second encapsulation layer, and a third encapsulation layer which are stacked, the first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

In an exemplary implementation mode, a preparation process of the light-transmitting display region provided in FIG. 13 may include following operations.

(1) A pattern of a semiconductor layer is formed. In an exemplary implementation mode, forming the pattern of the semiconductor layer may include: depositing sequentially a semiconductor thin film on a base substrate, and patterning the semiconductor thin film through a patterning process to form the pattern of the semiconductor layer, as shown in FIG. 16A, wherein FIG. 16A is a schematic diagram of the light-transmitting display region provided in FIG. 13 after a pattern of a semiconductor is formed.

In an exemplary implementation mode, the pattern of the semiconductor layer provided in FIG. 16A is the same as the pattern of the semiconductor layer provided in FIG. 15A, and will not be repeated herein.

(2) A pattern of a first conductive layer is formed. In an exemplary implementation mode, forming the pattern of the first conductive layer may include: depositing sequentially a first insulation thin film and a first conductive thin film on the base substrate on which the aforementioned pattern is formed and patterning the first conductive thin film through a patterning process to form a first insulation layer covering the pattern of the semiconductor layer and form the pattern of the first conductive layer disposed on the first insulation layer, as shown in FIG. 16B and FIG. 16C, wherein FIG. 16B is a schematic diagram of the pattern of the first conductive layer of the light-transmitting display region provided in FIG. 13, and FIG. 16C is a schematic diagram of the light-transmitting display region provided in FIG. 13 after the pattern of the first conductive layer is formed. In an exemplary implementation mode, the first conductive layer may be referred to as a first gate metal (GATE1) layer.

In an exemplary implementation mode, the pattern of the first conductive layer provided in FIG. 16B and FIG. 16C is the same as the pattern of the first conductive layer provided in FIG. 15B and FIG. 15C, and will not be repeated herein.

(3) A pattern of a second conductive layer is formed. In an exemplary implementation mode, forming the pattern of the second conductive layer may include: depositing a second insulation layer thin film and a second conductive thin film on the base substrate on which the aforementioned patterns are formed and patterning the second conductive thin film using a patterning process to form the pattern of the second conductive layer on a second insulation layer. As shown in FIG. 16D and FIG. 16E, FIG. 16D is a schematic diagram of the pattern of the second conductive layer of the light-transmitting display region provided in FIG. 13, and FIG. 16E is a schematic diagram of the light-transmitting display region provided in FIG. 13 after the pattern of the second conductive layer is formed. In an exemplary implementation mode, the second conductive layer may be referred to as a second gate metal (GATE2) layer.

In an exemplary implementation mode, the pattern of the second conductive layer provided in FIG. 16D and FIG. 16E is the same as the pattern of the second conductive layer provided in FIG. 15D and FIG. 15E, and will not be repeated herein.

(4) A pattern of a third insulation layer is formed. In an exemplary implementation mode, forming the pattern of the third insulation layer may include: depositing a third insulation thin film on the base substrate on which the aforementioned patterns are formed, and patterning the third insulation thin film using a patterning process to form the third insulation layer covering the second conductive layer, wherein multiple vias are disposed on the third insulation layer, as shown in FIG. 16F, wherein FIG. 16F is a schematic diagram of the light-transmitting display region provided in FIG. 13 after the pattern of the third insulation layer is formed.

In an exemplary implementation mode, the pattern of the third insulation layer provided in FIG. 16F is the same as the pattern of the third insulation layer provided in FIG. 15F, and will not be repeated herein.

(5) A pattern of a third conductive layer is formed. In an exemplary implementation mode, forming the pattern of the third conductive layer may include: depositing a third conductive thin film on the base substrate on which the aforementioned patterns are formed, and patterning the third conductive thin film using a patterning process to form the third conductive layer disposed on the third insulation layer, as shown in FIG. 16G to FIG. 16H, wherein FIG. 16G is a schematic diagram of the pattern of the third conductive layer of the light-transmitting display region provided in FIG. 13, and FIG. 16H is a schematic diagram of the light-transmitting display region provided in FIG. 13 after the pattern of the third conductive layer is formed. In an exemplary implementation mode, the third conductive layer may be referred to as a first source-drain metal (SD1) layer.

In an exemplary implementation mode, as shown in FIG. 16G and FIG. 16H, the pattern of the third conductive layer may include a first electrode T13 and a second electrode T14 of a first transistor, a first electrode T23 of a second transistor, a first electrode T43 of a fourth transistor, a first electrode T53 of a fifth transistor, a second electrode T64 of a sixth transistor, a first electrode T73 and a second electrode T74 of a seventh transistor, a second connection electrode VL2 to a tenth connection electrode VL10, a shield electrode SL, and a power supply connection line VCL.

In an exemplary implementation mode, the first electrode T13 and the second electrode T14 of the first transistor, the first electrode T23 of the second transistor, the first electrode T43 of the fourth transistor, the first electrode T53 of the fifth transistor, the second electrode T64 of the sixth transistor, the first electrode T73 and the second electrode T74 of the seventh transistor, the second connection electrode VL2 to the eighth connection electrode VL8, and the shield electrode provided in FIG. 16G and FIG. 16H have same patterns as the first electrode T13 and the second electrode T14 of the first transistor, the first electrode T23 of the second transistor, the first electrode T43 of the fourth transistor, the first electrode T53 of the fifth transistor, the second electrode T64 of the sixth transistor, the first electrode T73 and the second electrode T74 of the seventh transistor, the second connection electrode VL2 to the eighth connection electrode VL8, and the shield electrode provided in FIG. 15G and FIG. 15H, and will not be repeated herein.

In an exemplary implementation mode, as shown in FIG. 16G and FIG. 16H, at least parts of the ninth connection electrode VL9 and the tenth connection electrode VL10 extend along a second direction X. The power supply connection line VCL extends along the second direction X.

(6) A fourth insulation layer is formed. In an exemplary implementation mode, forming the pattern of the fourth insulation layer may include: depositing a fourth insulation thin film on the base substrate on which the aforementioned patterns are formed, and patterning the fourth insulation thin film using a patterning process to form a fourth insulation layer covering the third conductive layer, wherein multiple vias are disposed on the fourth insulation layer, as shown in FIG. 16I. FIG. 16I is a schematic diagram of the light-transmitting display region provided in FIG. 13 after the pattern of the fourth insulation layer is formed.

In an exemplary implementation mode, as shown in FIG. 16I, the multiple vias of the pattern of the fourth insulation layer may each include a seventeenth via V17 to a thirty-first via V31. The seventeenth via V17 to the twenty-eighth via V28 in FIG. 16I are the same as the seventeenth via V17 to the twenty-eighth via V28 in FIG. 15I, except that the twenty-ninth via V29 exposes the ninth connection electrode, the thirtieth via V30 exposes the tenth connection electrode, and the thirty-first via V31 exposes the power supply connection line VCL.

In an exemplary implementation mode, a quantity of twenty-ninth vias V29 may be two, and two twenty-ninth vias may be arranged along the second direction X and are respectively located at both ends of the ninth connection electrode.

In an exemplary implementation mode, a quantity of thirtieth vias V30 may be two, and two thirtieth vias V30 may be arranged along the second direction X and are respectively located at both ends of the tenth connection electrode.

In an exemplary implementation mode, a quantity of thirty-first vias V31 may be two, and two thirty-first vias V31 may be arranged along the second direction X and are respectively located at both ends of the electrode connection line.

(7) A pattern of a transparent conductive layer is formed. In an exemplary implementation mode, forming the pattern of the transparent conductive layer may include: depositing a transparent conductive thin film on the base substrate on which the aforementioned patterns are formed, and patterning the transparent conductive thin film using a patterning process to form a transparent conductive layer disposed on the fourth insulation layer, as shown in FIG. 16J and FIG. 16K, wherein FIG. 16J is a schematic diagram of the pattern of the transparent conductive layer of the light-transmitting display region provided in FIG. 13, and FIG. 16K is a schematic diagram of the light-transmitting display region provided in FIG. 13 after the pattern of the transparent conductive layer is formed.

In an exemplary implementation mode, as shown in FIG. 16J and FIG. 16K, the pattern of the transparent conductive layer may each include a data signal line Data, a first power supply line VDD, a first anode connection line AL1, a second anode connection line AL2, a third anode connection line AL3, a fourth anode connection line AL4, two sub-signal lines INIT_1 and INIT_2 of an initial signal line, two sub-signal lines RST_1 and RST_2 of a reset signal line, two sub-signal lines Gate_1 and Gate_2 of a scan signal line, two sub-signal lines EM_1 and EM_2 of a light emitting signal line, an eleventh connection electrode VL11, and a twelfth connection electrode VL12.

In an exemplary implementation mode, as shown in FIG. 16J and FIG. 16K, the data signal line Data and the first power supply line VDD may be located between two sub-signal lines of multiple first signal lines electrically connected with a first type pixel circuit with which the data signal line Data and the first power supply line VDD are electrically connected, and orthographic projections of the data signal line Data and the first power supply line VDD on the base substrate are overlapped with an orthographic projection of the first type pixel circuit on the base substrate.

In an exemplary implementation mode, as shown in FIG. 16J and FIG. 16K, the data signal line Data is in a polyline type, at least part of the data signal line Data extends along a first direction Y, and data signal lines Data electrically connected with adjacent first type pixel circuits located in a same column may be a same signal line. The data signal line is electrically connected with a first electrode of a fourth transistor of an electrically connected first type pixel circuit through the eighteenth via.

In an exemplary implementation mode, as shown in FIG. 16J and FIG. 16K, the first power supply line VDD is in a polyline type, at least part of the first power supply line VDD extends along the first direction Y, and first power supply lines VDD electrically connected with adjacent first type pixel circuits located in a same column may be disposed at intervals. The first power supply line is electrically connected with a first electrode of a fifth transistor of an electrically connected first type pixel circuit through the nineteenth via, and is electrically connected with the shield electrode through the twenty-eighth via.

In an exemplary implementation mode, as shown in FIG. 16J and FIG. 16K, the first power supply line VDD includes a power supply main body portion VDDM extending along the first direction Y and a power supply connection portion VDDS extending at least partially along the second direction X.

In an exemplary implementation mode, as shown in FIG. 16J and FIG. 16K, at least part of the power supply connection line VCL extends along the second direction X and is electrically connected with the first power supply line VDD electrically connected with adjacent first type pixel circuits located in a same row. Among them, a power supply connection portion of a first power supply line electrically connected with one first type pixel circuit in adjacent first type pixel circuits located in a same row is electrically connected with the power supply connection line VCL through the thirty-first via and a power supply main body of a first power supply line electrically connected with the other first type pixel circuit in adjacent first type pixel circuits located in the same row is electrically connected with the power supply connection line VCL through the thirty-first via. Disposition of the power supply connection line VCL may be matched with the first power supply line to form a mesh structure, so as to achieve display uniformity of the display substrate.

In an exemplary implementation mode, as shown in FIG. 16J and FIG. 16K, the first anode connection line AL1 to the fourth anode connection line AL4 may be in a polyline type.

In an exemplary implementation mode, as shown in FIG. 16J and FIG. 16K, the first anode connection line AL1 is located between a first power supply line VDD electrically connected with an electrically connected first type pixel circuit and a data signal line Data of a first type pixel circuit in an adjacent column, at least part of the first anode connection line AL1 extends along the second direction X, and the first anode connection line AL1 is electrically connected with a second electrodes of a sixth transistor of the electrically connected first type pixel circuit through the twentieth via, and is electrically connected with the ninth connection electrode through the twenty-ninth via.

In an exemplary implementation mode, as shown in FIG. 16J and FIG. 16K, the second anode connection line AL2 is located between a first power supply line VDD electrically connected with an electrically connected first type pixel circuit and a data signal line Data of a first type pixel circuit in an adjacent column, at least part of the second anode connection line AL2 extends along the second direction X, and the second anode connection line AL2 is electrically connected with a second electrode of a sixth transistor of the electrically connected first type pixel circuit through the twentieth via, and is electrically connected with the tenth connection electrode through the thirtieth via.

In an exemplary implementation mode, as shown in FIG. 16J and FIG. 16K, the third anode connection line AL3 is located between a first power supply line VDD electrically connected with an electrically connected first type pixel circuit and a data signal line Data electrically connected with an adjacent first type pixel circuit located in a same row. At least part of the third anode connection line AL3 extends along the first direction Y, and the third anode connection line AL3 is electrically connected with a second electrode of a sixth transistor of the electrically connected first type pixel circuit through the twentieth via.

In an exemplary implementation mode, as shown in FIG. 16J and FIG. 16K, the fourth anode connection line AL4 is located between a first power supply line VDD electrically connected with an electrically connected first type pixel circuit and a data signal line Data electrically connected with an adjacent first type pixel circuit located in a same row. At least part of the fourth anode connection line AL4 extends along the first direction Y, and the fourth anode connection line AL4 is electrically connected with a second electrode of a sixth transistor of the electrically connected first type pixel circuit through the twentieth via.

In an exemplary implementation mode, as shown in FIG. 16J and FIG. 16K, the two sub-signal lines INIT_1 and INIT_2 of the initial signal line may be in a polyline type, at least parts of the two sub-signal lines INIT_1 and INIT_2 of the initial signal line may extend along the first direction Y, a sub-signal line INIT_1 of the initial signal line is electrically connected with the eighth connection electrode through the twenty-seventh via, and a sub-signal line INIT_2 of the initial signal line is electrically connected with the first electrode of the first transistor through the seventeenth via. The sub-signal line INIT_1 of the initial signal line is electrically connected with the first connection electrode through the eighth connection electrode. The sub-signal line INIT_2 of the initial signal line is electrically connected with the first connection electrode through the first electrode of the first transistor.

In an exemplary implementation mode, as shown in FIG. 16J and FIG. 16K, the two sub-signal lines RST_1 and RST_2 of the reset signal line may be in a polyline type, at least parts of the two sub-signal lines RST_1 and RST_2 of the reset signal line may extend along the second direction Y, a sub-signal line RST_1 of the reset signal line is electrically connected with the second connection electrode through the twenty-first via, and a sub-signal line RST_2 of the reset signal line is electrically connected with the third connection electrode through the twenty-second via. The sub-signal line RST_1 of the reset signal line is electrically connected with a control electrode of the first transistor through the second connection electrode, and the sub-signal line RST_2 of the reset signal line is electrically connected with the control electrode of the first transistor through the third connection electrode.

In an exemplary implementation mode, as shown in FIG. 16J and FIG. 16K, the two sub-signal lines Gate_1 and Gate_2 of the scan signal line may be in a polyline type, at least parts of the two sub-signal lines Gate_1 and Gate_2 of the scan signal line may extend along the second direction Y, a sub-signal line Gate_1 of the scan signal line is electrically connected with the fourth connection electrode through the twenty-third via, and a sub-signal line Gate_2 of the scan signal line is electrically connected with the fifth connection electrode through the twenty-fourth via. The sub-signal line Gate_1 of the scan signal line is electrically connected with a control electrode of the fourth transistor through the fourth connection electrode, and the sub-signal line Gate_2 of the scan signal line is electrically connected with the control electrode of the fourth transistor through the fifth connection electrode.

In an exemplary implementation mode, as shown in FIG. 16J and FIG. 16K, the two sub-signal lines EM_1 and EM_2 of the light emitting signal line may be in a polyline type, at least parts of the two sub-signal lines EM_1 and EM_2 of the light emitting signal line may extend along the second direction Y, a sub-signal line EM_1 of the light emitting signal line is electrically connected with the sixth connection electrode through the twenty-fifth via, and a sub-signal line EM_1 of the light emitting signal line is electrically connected with the seventh connection electrode through the twenty-sixth via. The sub-signal line EM_1 of the light emitting signal line is electrically connected with a control electrode of the fifth transistor through the sixth connection electrode, and the sub-signal line EM_2 of the light emitting signal line is electrically connected with the control electrode of the fifth transistor through the seventh connection electrode.

(8) A pattern of a first planarization layer is formed. In an exemplary implementation mode, forming the pattern of the first planarization layer may include: depositing a first planarization thin film on the base substrate on which the aforementioned patterns are formed, and forming the pattern of the first planarization layer disposed on the transparent conductive layer, wherein the pattern of the first planarization layer includes multiple vias, as shown in FIG. 16L, wherein FIG. 16L is a schematic diagram of the light-transmitting display region provided in FIG. 13 after the first planarization layer is formed.

In an exemplary implementation mode, as shown in FIG. 16L, the pattern of the first planarization layer may include a thirty-second via V32 and a thirty-eighth via V38. Among them, the thirty-second via exposes the first power supply line, the thirty-third via V33 exposes the first anode connection line, the thirty-fourth via V34 exposes the second anode connection line, the thirty-fifth via V35 exposes the third anode connection line, the thirty-sixth via V36 exposes the fourth anode connection line, the thirty-seventh via V37 exposes the eleventh connection electrode, and the thirty-eighth via V38 exposes the twelfth connection electrode.

In an exemplary implementation mode, as shown in FIG. 16L, a quantity of thirty-third vias V33 may be two, which are located at both ends of the first anode connection line respectively. A quantity of thirty-fourth vias V34 may be two, which are located at both ends of the second anode connection line respectively. A quantity of thirty-fifth vias V35 may be two, which are located at both ends of the third anode connection line respectively. A quantity of thirty-sixth vias V36 may be two, which are located at both ends of the fourth anode connection line respectively.

(9) A pattern of a fourth conductive layer is formed. In an exemplary implementation mode, forming the pattern of the fourth conductive layer may include: depositing a fourth conductive thin film on the base substrate on which the aforementioned patterns are formed, and patterning the fourth conductive thin film using a patterning process to form the fourth conductive layer disposed on the first planarization layer, as shown in FIG. 16M and FIG. 16N, wherein FIG. 16M is a schematic diagram of the pattern of the fourth conductive layer of the light-transmitting display region provided in FIG. 13, and FIG. 16N is a schematic diagram of the light-transmitting display region provided in FIG. 13 after the pattern of the fourth conductive layer is formed. In an exemplary implementation mode, the fourth conductive layer may be referred to as a second source-drain metal (SD2) layer.

In an exemplary implementation mode, as shown in FIG. 16M and FIG. 16N, the pattern of the fourth conductive layer may include a thirteenth connection electrode VL13 to a twentieth connection electrode VL20 and a signal connection line VDL.

In an exemplary implementation mode, as shown in FIG. 16M and FIG. 16N, the thirteenth connection electrode VL13 to the twentieth connection electrode VL20 are of a block structure. The signal connection line VDL may be in a polyline type and at least part of the signal connection line VDL may extend along the first direction Y.

In an exemplary implementation mode, as shown in FIG. 16M and FIG. 16N, the thirteenth connection electrode VL13 is electrically connected with the first anode connection line through the thirty-third via, the fourteenth connection electrode VL14 is electrically connected with the second anode connection line through the thirty-fourth via, the fifteenth connection electrode VL15 and the sixteenth connection electrode VL16 are electrically connected with the third anode connection line through the thirty-fifth via, the seventeenth connection electrode VL17 and the eighteenth connection electrode VL18 are electrically connected with the fourth anode connection line through the thirty-sixth via, the nineteenth connection electrode VL19 is electrically connected with the eleventh connection electrode through the thirty-seventh via, and the twentieth connection electrode VL20 is electrically connected with the twelfth connection electrode through the thirty-eighth via. The signal connection line VDL is electrically connected with a first power supply line electrically connected with a first type pixel circuit through the thirty-second via.

In an exemplary implementation mode, first power supply lines electrically connected with first type pixel circuits located in a same column are electrically connected through the signal connection line.

In an exemplary embodiment, as shown in FIG. 16N, the thirteenth connection electrode VL13 is electrically connected with the nineteenth connection electrode VL19 through the first anode connection line, the ninth anode connection electrode, and the eleventh anode connection electrode, the fourteenth connection electrode VL14 is electrically connected with the twentieth connection electrode VL20 through the second anode connection line, the tenth anode connection electrode, and the twelfth anode connection electrode, the fifteenth connection electrode VL15 is electrically connected with the sixteenth connection electrode VL16 through the third anode connection line, and the seventeenth connection electrode VL17 is electrically connected with the eighteenth connection electrode VL18 through the fourth anode connection line.

In an exemplary implementation mode, multiple connection electrodes play a role of undertaking, which may avoid unreliability of a connection caused by opening a relatively deep via and improve reliability of the display panel.

(10) A pattern of a second planarization layer is formed. In an exemplary implementation mode, forming the pattern of the second planarization layer may include: coating a second planarization thin film on the base substrate on which the aforementioned patterns are formed, and patterning the second planarization thin film using a patterning process to form the second planarization layer covering the fourth conductive layer, wherein multiple vias are disposed on the second planarization layer, as shown in FIG. 16O, wherein FIG. 16O is a schematic diagram of the light-transmitting display region provided in FIG. 13 after the pattern of the second planarization layer is formed.

In an exemplary implementation mode, as shown in FIG. 16O, the multiple vias of the pattern of the second planarization layer may each include a thirty-ninth via V39 to a forty-sixth via V46. Among them, the thirty-ninth via V39 exposes the thirteenth connection electrode, the fortieth via V40 exposes the fourteenth connection electrode, the forty-first via V41 exposes the fifteenth connection electrode, the forty-second via V42 exposes the sixteenth connection electrode, the forty-third via V43 exposes the seventeenth connection electrode, the forty-fourth via V44 exposes the eighteenth connection electrode, the forty-fifth via V45 exposes the nineteenth connection electrode, and the forty-sixth via V46 exposes the twentieth connection electrode.

So far, preparation of a drive circuit layer on the base substrate is completed. On a plane parallel to the display substrate, the drive circuit layer may include multiple first type pixel circuits, the scan signal line, the reset signal line, the light emitting signal line, the data signal line, the initial signal line, and the first anode connection line to the fourth anode connection line. On a plane perpendicular to the display panel, the drive circuit layer may include the semiconductor layer, the first insulation layer, the first conductive layer, the second insulation layer, the second conductive layer, the third insulation layer, the third conductive layer, the fourth insulation layer, the transparent conductive layer, the first planarization layer, the fourth conductive layer, and the second planarization layer which are stacked sequentially on the base substrate.

In an exemplary implementation mode, the base substrate may be a flexible base substrate, or may be a rigid base substrate. The rigid base substrate may be, but is not limited to, one or more of glass and quartz. The flexible base substrate may be, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the first conductive layer, the second conductive layer, the third conductive layer, the fourth conductive layer, and the fifth conductive layer may be made of a metal material, such as any one or more of Argentum (Ag), Copper (Cu), Aluminum (Al), and Molybdenum (Mo), or an alloy material of the aforementioned metals, such as an Aluminum-Neodymium alloy (AlNd) or a Molybdenum-Niobium alloy (MoNb), and may be of a single-layer structure, or a multi-layer composite structure such as Mo/Cu/Mo.

In an exemplary embodiment, for the transparent conductive layer, such as Indium Tin Oxide (ITO) or Indium Zinc Oxide (IZO) may be adopted, or a multi-layer composite structure, such as ITO/Ag/ITO, may be adopted.

In an exemplary implementation mode, the first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first insulation layer may be referred to as a buffer layer, the second insulation layer may be referred to as a Gate Insulator (GI) layer, the third insulation layer may be referred to as an Interlayer Dielectric (ILD) layer, and the fourth insulation layer may be referred to as a Passivation (PVX) layer. The first planarization layer and the second planarization layer may be made of an organic material, such as resin. The semiconductor layer may be made of a material, such as an amorphous Indium Gallium Zinc Oxide material (a-IGZO), Zinc Oxynitride (ZnON), Indium Zinc Tin Oxide (IZTO), amorphous Silicon (a-Si), polycrystalline Silicon (p-Si), sexithiophene, or polythiophene, that is, the present disclosure is applicable to a transistor manufactured based on an oxide technology, a silicon technology, or an organic matter technology.

In an exemplary implementation mode, after preparation of the drive circuit layer is completed, a light emitting structure layer is prepared on the drive circuit layer, and a preparation process of the light emitting structure layer may include following operations.

(11) A pattern of an anode conductive layer is formed. In an exemplary implementation mode, forming the pattern of the anode conductive layer may include: depositing an anode conductive thin film on the base substrate on which the aforementioned patterns are formed, and patterning the anode conductive thin film using a patterning process to form the pattern of the anode conductive layer disposed on the second planarization layer, as shown in FIG. 16P and FIG. 16Q, wherein FIG. 16P is a schematic diagram of the pattern of the anode conductive layer of the light-transmitting display region provided in FIG. 13 and FIG. 16Q is a schematic diagram of the light-transmitting display region provided in FIG. 13 after the pattern of the anode conductive layer is formed.

In an exemplary implementation mode, for the anode conductive layer, a single-layer structure, such as Indium Tin Oxide (ITO) or Indium Zinc Oxide (IZO), may be adopted, or a multi-layer composite structure, such as ITO/Ag/ITO, may be adopted.

In an exemplary implementation mode, the pattern of the anode conductive layer provided in FIG. 16P is the same as the pattern of the anode conductive layer provided in FIG. 15P, and will not be repeated herein.

In an exemplary implementation mode, an anode of a first light emitting element 11a is electrically connected with the thirteenth connection electrode through the thirty-ninth via, an anode of a first light emitting element 11b is electrically connected with the nineteenth connection electrode through the forty-fifth via, an anode of a second light emitting element 12a is electrically connected with the fourteenth connection electrode through the fortieth via, an anode of a second light emitting element 12b is electrically connected with the twentieth connection electrode through the forty-sixth via, an anode of a third light emitting element 13a is electrically connected with the fifteenth connection electrode through the forty-first via, an anode of a third light emitting element 13b is electrically connected with the sixteenth connection electrode through the forty-second via, an anode of a third light emitting element 13c is electrically connected with the seventeenth connection electrode through the forty-third via, and an anode of a third light emitting element 13d is electrically connected with the eighteenth connection electrode through the forty-fourth via.

In an exemplary implementation mode, the anode of the first light emitting element 11a is electrically connected with the anode of the first light emitting element 11b through the thirteenth connection electrode, the first anode connection line, the ninth connection electrode, the eleventh connection electrode, and the nineteenth connection electrode. The anode of the second light emitting element 12a is electrically connected with the anode of the second light emitting element 12b through the fourteenth connection electrode, the second anode connection line, the tenth connection electrode, the twelfth connection electrode, and the twentieth connection electrode. The anode of the third light emitting element 13a is electrically connected with the anode of the third light emitting element 13b through the fifteenth connection electrode, the third anode connection line, and the sixteenth connection electrode. The anode of the third light emitting element 13c is electrically connected with the anode of the third light emitting element 13d through the seventeenth connection electrode, the fourth anode connection line, and the eighteenth connection electrode.

In an exemplary implementation mode, a subsequent preparation process may include: forming a pattern of a pixel definition layer at first, then forming an organic emitting layer using an evaporation process or an inkjet printing process, then forming a cathode on the organic emitting layer, and then forming an encapsulation structure layer, wherein the encapsulation structure layer may include a first encapsulation layer, a second encapsulation layer, and a third encapsulation layer which are stacked, the first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

In an exemplary implementation mode, a preparation process of the light-transmitting display region provided in FIG. 14 may include following operations.

(1) A pattern of a semiconductor layer is formed. In an exemplary implementation mode, forming the pattern of the semiconductor layer may include: depositing sequentially a semiconductor thin film on a base substrate, and patterning the semiconductor thin film through a patterning process to form the pattern of the semiconductor layer, as shown in FIG. 17A, wherein FIG. 17A is a schematic diagram of the light-transmitting display region provided in FIG. 14 after a pattern of a semiconductor is formed.

In an exemplary implementation mode, the pattern of the semiconductor layer provided in FIG. 17A is the same as the pattern of the semiconductor layer provided in FIG. 15A, and will not be repeated herein.

(2) A pattern of a first conductive layer is formed. In an exemplary implementation mode, forming the pattern of the first conductive layer may include: depositing sequentially a first insulation thin film and a first conductive thin film on the base substrate on which the aforementioned pattern is formed and patterning the first conductive thin film through a patterning process to form a first insulation layer covering the pattern of the semiconductor layer and form the pattern of the first conductive layer disposed on the first insulation layer, as shown in FIG. 17B and FIG. 17C, wherein FIG. 17B is a schematic diagram of the pattern of the first conductive layer of the light-transmitting display region provided in FIG. 14, and FIG. 17C is a schematic diagram of the light-transmitting display region provided in FIG. 14 after the pattern of the first conductive layer is formed. In an exemplary implementation mode, the first conductive layer may be referred to as a first gate metal (GATE1) layer.

In an exemplary implementation mode, the pattern of the first conductive layer provided in FIG. 17B and FIG. 17C is the same as the pattern of the first conductive layer provided in FIG. 15B and FIG. 15C, and will not be repeated herein.

(3) A pattern of a second conductive layer is formed. In an exemplary implementation mode, forming the pattern of the second conductive layer may include: depositing a second insulation layer thin film and a second conductive thin film on the base substrate on which the aforementioned patterns are formed and patterning the second conductive thin film using a patterning process to form the pattern of the second conductive layer on the second insulation layer. As shown in FIG. 17D and FIG. 17E, FIG. 17D is a schematic diagram of the pattern of the second conductive layer of the light-transmitting display region provided in FIG. 14, and FIG. 17E is a schematic diagram of the light-transmitting display region provided in FIG. 14 after the pattern of the second conductive layer is formed. In an exemplary implementation mode, the second conductive layer may be referred to as a second gate metal (GATE2) layer.

In an exemplary implementation mode, the pattern of the second conductive layer provided in FIG. 17D and FIG. 17E is the same as the pattern of the second conductive layer provided in FIG. 15D and FIG. 15E, and will not be repeated herein.

(4) A pattern of a third insulation layer is formed. In an exemplary implementation mode, forming the pattern of the third insulation layer may include: depositing a third insulation thin film on the base substrate on which the aforementioned patterns are formed, and patterning the third insulation thin film using a patterning process to form the third insulation layer covering the second conductive layer, wherein multiple vias are disposed on the third insulation layer, as shown in FIG. 17F, wherein FIG. 17F is a schematic diagram of the light-transmitting display region provided in FIG. 14 after the pattern of the third insulation layer is formed.

In an exemplary implementation mode, the pattern of the third insulation layer provided in FIG. 17F is the same as the pattern of the third insulation layer provided in FIG. 15F, and will not be repeated herein.

(5) A pattern of a third conductive layer is formed. In an exemplary implementation mode, forming the pattern of the third conductive layer may include: depositing a third conductive thin film on the base substrate on which the aforementioned patterns are formed, and patterning the third conductive thin film using a patterning process to form the third conductive layer disposed on the third insulation layer, as shown in FIG. 17G to FIG. 17H, wherein FIG. 17G is a schematic diagram of the pattern of the third conductive layer of the light-transmitting display region provided in FIG. 14, and FIG. 17H is a schematic diagram of the light-transmitting display region provided in FIG. 14 after the pattern of the third conductive layer is formed. In an exemplary implementation mode, the third conductive layer may be referred to as a first source-drain metal (SD1) layer.

In an exemplary implementation mode, as shown in FIG. 17G and FIG. 17H, the pattern of the third conductive layer may include a first electrode T13 and a second electrode T14 of a first transistor, a first electrode T23 of a second transistor, a first electrode T43 of a fourth transistor, a first electrode T53 of a fifth transistor, a second electrode T64 of a sixth transistor, a first electrode T73 and a second electrode T74 of a seventh transistor, a second connection electrode VL2 to a twelfth connection electrode VL12, and a shield electrode SL.

In an exemplary implementation mode, the first electrode T13 and the second electrode T14 of the first transistor, the first electrode T23 of the second transistor, the first electrode T43 of the fourth transistor, the first electrode T53 of the fifth transistor, the second electrode T64 of the sixth transistor, the first electrode T73 and the second electrode T74 of the seventh transistor, the second connection electrode VL2 to the eighth connection electrode VL8, and the shield electrode provided in FIG. 17G and FIG. 17H have same patterns as the first electrode T13 and the second electrode T14 of the first transistor, the first electrode T23 of the second transistor, the first electrode T43 of the fourth transistor, the first electrode T53 of the fifth transistor, the second electrode T64 of the sixth transistor, the first electrode T73 and the second electrode T74 of the seventh transistor, the second connection electrode VL2 to the eighth connection electrode VL8, and the shield electrode SL provided in FIG. 15G and FIG. 15H, and will not be repeated herein.

In an exemplary implementation mode, as shown in FIG. 17G and FIG. 17H, the ninth connection electrode VL9 and the twelfth connection electrode VL12 extend along a second direction X, and at least parts of the tenth connection electrode VL10 and the eleventh connection electrodes VL11 extend along the second direction X.

(6) A fourth insulation layer is formed. In an exemplary implementation mode, forming the pattern of the fourth insulation layer may include: depositing a fourth insulation thin film on the base substrate on which the aforementioned patterns are formed, and patterning the fourth insulation thin film using a patterning process to form the fourth insulation layer covering the second conductive layer, wherein multiple vias are disposed on the fourth insulation layer, as shown in FIG. 17I. FIG. 17I is a schematic diagram of the light-transmitting display region provided in FIG. 14 after the pattern of the fourth insulation layer is formed.

In an exemplary implementation mode, as shown in FIG. 17I, the multiple vias of the pattern of the fourth insulation layer may each include a seventeenth via V17 to a thirty-second via V32. The seventeenth via V17 to the twenty-eighth via V28 in FIG. 17I are the same as the seventeenth via V17 to the twenty-eighth via V28 in FIG. 15I except that the twenty-ninth via V29 exposes the ninth connection electrode, the thirtieth via V30 exposes the tenth connection electrode, the thirty-first via V31 exposes the eleventh connection electrode, and the thirty-second via V32 exposes the twelfth connection electrode.

In an exemplary implementation mode, a quantity of twenty-ninth vias V29 may be two, and two twenty-ninth vias may be arranged along the second direction X and are respectively located at both ends of the ninth connection electrode.

In an exemplary embodiment, a quantity of thirtieth vias V30 may be two, and two thirtieth vias V30 may be arranged along the second direction X and are respectively located at both ends of the tenth connection electrode.

In an exemplary implementation mode, a quantity of thirty-first vias V31 may be two, and the two thirty-first vias V31 may be arranged along the second direction X and are respectively located at both ends of the eleventh connection electrode.

In an exemplary implementation mode, a quantity of thirty-second vias V32 may be two, and two thirty-second vias V32 may be arranged along the second direction X and are respectively located at both ends of the twelfth connection electrode.

(7) A pattern of a transparent conductive layer is formed. In an exemplary implementation mode, forming the pattern of the transparent conductive layer may include: depositing a transparent conductive thin film on the base substrate on which the aforementioned patterns are formed, and patterning the transparent conductive thin film using a patterning process to form the transparent conductive layer disposed on the fourth insulation layer, as shown in FIG. 17J and FIG. 17K, wherein FIG. 17J is a schematic diagram of the pattern of the transparent conductive layer of the light-transmitting display region provided in FIG. 14, and FIG. 17K is a schematic diagram of the light-transmitting display region provided in FIG. 14 after the pattern of the transparent conductive layer is formed.

In an exemplary implementation mode, as shown in FIG. 17J and FIG. 17K, the pattern of the transparent conductive layer may each include a data signal line Data, a first power supply line VDD, a first anode connection line AL1, a second anode connection line AL2, a third anode connection line AL3, two sub-signal lines INIT_1 and INIT_2 of an initial signal line, two sub-signal lines RST_1 and RST_2 of a reset signal line, two sub-signal lines Gate_1 and Gate_2 of a scan signal line, two sub-signal lines EM_1 and EM_2 of a light emitting signal line, a thirteenth connection electrode VL13 to a seventeenth connection electrode VL17.

In an exemplary implementation mode, as shown in FIG. 17J and FIG. 17K, the data signal line Data and the first power supply line VDD may be located between two sub-signal lines of multiple first signal lines electrically connected with a first type pixel circuit with which the data signal line Data and the first power supply line VDD are electrically connected, and orthographic projections of the data signal line Data and the first power supply line VDD on the base substrate are overlapped with an orthographic projection of the first type pixel circuit on the base substrate.

In an exemplary implementation mode, as shown in FIG. 17J and FIG. 17K, the data signal line Data may be in a shape of a line, at least part of the data signal line Data may extend along a first direction Y, and data signal lines Data electrically connected with adjacent first type pixel circuits located in a same column may be a same signal line. A data signal line is electrically connected with a first electrode of a fourth transistor of an electrically connected first type pixel circuits through the eighteenth via.

In an exemplary implementation mode, as shown in FIG. 17J and FIG. 17K, the first power supply line VDD may be in a shape of a line, at least part of the first power supply line VDD may extend along the first direction Y, and first power supply lines VDD electrically connected with adjacent first type pixel circuits located in a same column may be disposed at intervals. A first power supply line is electrically connected with a first electrode of a fifth transistor of an electrically connected first type pixel circuit through the nineteenth via, and is electrically connected with the shield electrode through the twenty-eighth via.

In an exemplary implementation mode, as shown in FIG. 17J and FIG. 17K, the first anode connection line AL1 to the fourth anode connection line AL4 are in a polyline type.

In an exemplary implementation mode, as shown in FIG. 17J and FIG. 17K, the first anode connection line AL1 is located between a first power supply line VDD electrically connected with an electrically connected first type pixel circuit and a data signal line Data of a first type pixel circuit in an adjacent column, at least part of the first anode connection line AL1 may extend along the second direction X, and the first anode connection line AL1 is electrically connected with a second electrode of a sixth transistor of the electrically connected first type pixel circuit through the twentieth via, and is electrically connected with the tenth connection electrode through the thirtieth via.

In an exemplary implementation mode, as shown in FIG. 17J and FIG. 17K, the second anode connection line AL2 is located between a first power supply line VDD electrically connected with an electrically connected first type pixel circuit and a data signal line Data of a first type pixel circuit in an adjacent column, at least part of the second anode connection line AL2 may extend along the second direction X, and the second anode connection line AL2 is electrically connected with a second electrode of a sixth transistor of the electrically connected first type pixel circuit through the twentieth via, and is electrically connected with the ninth connection electrode through the twenty-ninth via.

In an exemplary implementation mode, as shown in FIG. 17J and FIG. 17K, the third anode connection line AL3 is located between a first power supply line VDD electrically connected with an electrically connected first type pixel circuit and a data signal line Data electrically connected with an adjacent first type pixel circuit located in a same row, and at least part of the third anode connection line AL3 may extend along the first direction Y. The third anode connection line AL3 is electrically connected with the twelfth connection electrode through the thirty-second via.

In an exemplary implementation mode, as shown in FIG. 17J and FIG. 17K, the two sub-signal lines INIT_1 and INIT_2 of the initial signal line may be in a polyline type, at least parts of the two sub-signal lines INIT_1 and INIT_2 of the initial signal line may extend along the first direction Y, a sub-signal line INIT_1 of the initial signal line is electrically connected with the eighth connection electrode through the twenty-seventh via, and a sub-signal line INIT_2 of the initial signal line is electrically connected with a first electrode of the first transistor through the seventeenth via. The sub-signal line INIT_1 of the initial signal line is electrically connected with the first connection electrode through the eighth connection electrode. The sub-signal line INIT_2 of the initial signal line is electrically connected with the first connection electrode through the first electrode of the first transistor.

In an exemplary implementation mode, as shown in FIG. 17J and FIG. 17K, the two sub-signal lines RST_1 and RST_2 of the reset signal line may be in a polyline type, at least parts of the two sub-signal lines RST_1 and RST_2 of the reset signal line may extend along the second direction Y, a sub-signal line RST_1 of the reset signal line is electrically connected with the second connection electrode through the twenty-first via, and a sub-signal line RST_2 of the reset signal line is electrically connected with the third connection electrode through the twenty-second via. The sub-signal line RST_1 of the reset signal line is electrically connected with a control electrode of the first transistor through the second connection electrode, and the sub-signal line RST_2 of the reset signal line is electrically connected with the control electrode of the first transistor through the third connection electrode.

In an exemplary implementation mode, as shown in FIG. 17J and FIG. 17K, the two sub-signal lines Gate_1 and Gate_2 of the scan signal line may be in a polyline type, at least parts of the two sub-signal lines Gate_1 and Gate_2 of the scan signal line may extend along the second direction Y, a sub-signal line Gate_1 of the scan signal line is electrically connected with the fourth connection electrode through the twenty-third via, and a sub-signal line Gate_2 of the scan signal line is electrically connected with the fifth connection electrode through the twenty-fourth via. The sub-signal line Gate_1 of the scan signal line is electrically connected with a control electrode of the fourth transistor through the fourth connection electrode, and the sub-signal line Gate_2 of the scan signal line is electrically connected with the control electrode of the fourth transistor through the fifth connection electrode.

In an exemplary implementation mode, as shown in FIG. 17J and FIG. 17K, the two sub-signal lines EM_1 and EM_2 of the light emitting signal line may be in a polyline type, at least parts of the two sub-signal lines EM_1 and EM_2 of the light emitting signal line may extend along the second direction Y, a sub-signal line EM_1 of the light emitting signal line is electrically connected with the sixth connection electrode through the twenty-fifth via, and a sub-signal line EM_1 of the light emitting signal line is electrically connected with the seventh connection electrode through the twenty-sixth via. The sub-signal line EM_1 of the light emitting signal line is electrically connected with a control electrode of the fifth transistor through the sixth connection electrode, and the sub-signal line EM_2 of the light emitting signal line is electrically connected with the control electrode of the fifth transistor through the seventh connection electrode.

In an exemplary implementation mode, as shown in FIG. 17J and FIG. 17K, the thirteenth connection electrode VL13 is electrically connected with the tenth connection electrode through the thirtieth via, and is electrically connected with the eleventh connection electrode through the thirty-first via.

In an exemplary implementation mode, as shown in FIG. 17J and FIG. 17K, the fourteenth connection electrode VL14 is electrically connected with the eleventh connection electrode through the thirty-first via. The thirteenth connection electrode is electrically connected with the fourteenth connection electrode through the first anode connection line, the tenth connection electrode, the thirteenth connection electrode, and the eleventh connection electrode.

In an exemplary implementation mode, as shown in FIG. 17J and FIG. 17K, the fifteenth connection electrode VL15 is electrically connected with a second electrode of a sixth transistor of an electrically connected first type pixel circuit through the twentieth via.

In an exemplary implementation mode, as shown in FIG. 17J and FIG. 17K, the sixteenth connection electrode VL16 is electrically connected with the ninth connection electrode through the twenty-ninth via. The sixteenth connection electrode is electrically connected with the second anode connection line AL2 through the ninth connection electrode.

In an exemplary implementation mode, as shown in FIG. 17J and FIG. 17K, the seventeenth connection electrode VL17 is electrically connected with the twelfth connection electrode through the thirty-second via. The seventeenth connection electrode VL17 is electrically connected with the third anode connection line AL3 through the twelfth connection electrode.

(8) A pattern of a first planarization layer is formed. In an exemplary implementation mode, forming the pattern of the first planarization layer may include: depositing a first planarization thin film on the base substrate on which the aforementioned patterns are formed, and forming the pattern of the first planarization layer disposed on the transparent conductive layer, wherein the pattern of the first planarization layer includes multiple vias, as shown in FIG. 17L, wherein FIG. 17L is a schematic diagram of the light-transmitting display region provided in FIG. 14 after the first planarization layer is formed.

In an exemplary implementation mode, as shown in FIG. 17L, the pattern of the first planarization layer may include a thirty-third via V33 and a fortieth via V40. The thirty-third via V33 exposes the first power supply line, the thirty-fourth via V34 exposes the first anode connection line, the thirty-fifth via V35 exposes the fourteenth connection electrode, the thirty-sixth via V36 exposes the sixteenth connection electrode, the thirty-seventh via V37 exposes the second anode connection line, the thirty-eighth via V38 exposes the fifteenth connection electrode, the thirty-ninth via V39 exposes the third anode connection line, and the fortieth via V40 exposes the seventeenth connection electrode.

(9) A pattern of a fourth conductive layer is formed. In an exemplary implementation mode, forming the pattern of the fourth conductive layer may include: depositing a fourth conductive thin film is on the base substrate on which the aforementioned patterns are formed, and patterning the fourth conductive thin film using a patterning process to form the fourth conductive layer disposed on the first planarization layer, as shown in FIG. 17M and FIG. 17N, wherein FIG. 17M is a schematic diagram of the pattern of the fourth conductive layer of the light-transmitting display region provided in FIG. 14, and FIG. 17N is a schematic diagram of the light-transmitting display region provided in FIG. 14 after the pattern of the fourth conductive layer is formed. In an exemplary implementation mode, the fourth conductive layer may be referred to as a second source-drain metal (SD2) layer.

In an exemplary implementation mode, as shown in FIG. 17M and FIG. 17N, the pattern of the fourth conductive layer may include: an eighteenth connection electrode VL18 to a twenty-third connection electrode VL23 and a signal connection line VDL.

In an exemplary implementation mode, as shown in FIG. 17M and FIG. 17N, the eighteenth connection electrode VL18 to the twenty-first connection electrode VL21 and the twenty-third connection electrode VL23 are of a block structure. The twenty-second connection electrode VL22 is of a horizontally inverted "7" shape, the signal connection line VDL may be in a polyline type, and at least part of the signal connection line VDL may extend along the first direction Y.

In an exemplary implementation mode, as shown in FIG. 17M and FIG. 17N, the signal connection line VDL is electrically connected with the first power supply line through the thirty-third via.

In an exemplary implementation mode, as shown in FIG. 17M and FIG. 17N, the eighteenth connection electrode VL18 is electrically connected with the fourteenth connection electrode through the thirty-fifth via, the nineteenth connection electrode VL19 is electrically connected with the first anode connection line through the thirty-fourth via, the twentieth connection electrode VL20 is electrically connected with the sixteenth connection electrode through the thirty-sixth via, the twenty-first connection electrode VL21 is electrically connected with the second anode connection line through the thirty-seventh via, the twenty-second connection electrode VL22 is electrically connected with the fifteenth connection electrode through the thirty-eighth via, and is electrically connected with the third anode connection line through the thirty-ninth via, and the twenty-third connection electrode VL23 is electrically connected with the seventeenth connection electrode through the fortieth via.

In an exemplary implementation mode, first power supply lines electrically connected with first type pixel circuits located in a same column are electrically connected through the signal connection line VDL.

In an exemplary embodiment, as shown in FIG. 17N, the eighteenth connection electrode VL18 is electrically connected with the nineteenth connection electrode VL19 through the fourteenth connection electrode, the eleventh connection electrode, the thirteenth connection electrode, the tenth connection electrode, and the first anode connection line. The twentieth connection electrode VL20 is electrically connected with the twenty-first connection electrode VL21 through the sixteenth connection electrode, the ninth connection electrode, and the first anode connection line. The twenty-second connection electrode VL22 is electrically connected with the twenty-third connection electrode VL23 through the third anode connection line, the twelfth connection electrode, and the seventeenth connection electrode.

In an exemplary implementation mode, multiple connection electrodes play a role of undertaking, which may avoid unreliability of a connection caused by opening a relatively deep via and improve reliability of a display panel.

(10) A pattern of a second planarization layer is formed. In an exemplary implementation mode, forming the pattern of the second planarization layer may include: coating a second planarization thin film on the base substrate on which the aforementioned patterns are formed, and patterning the second planarization thin film using a patterning process to form the second planarization layer covering the fourth conductive layer, wherein multiple vias are disposed on the second planarization layer, as shown in FIG. 17O, wherein FIG. 17O is a schematic diagram of the light-transmitting display region provided in FIG. 14 after the pattern of the second planarization layer is formed.

In an exemplary implementation mode, as shown in FIG. 17O, the multiple vias of the pattern of the second planarization layer may each include: a forty-first via V41 to a forty-sixth via V46. Among them, the forty-first via V41 exposes the eighteenth connection electrode, the forty-second via V42 exposes the nineteenth connection electrode, the forty-third via V43 exposes the twentieth connection electrode, the forty-fourth via V44 exposes the twenty-first connection electrode, the forty-fifth via V45 exposes the twenty-second connection electrode, and the forty-sixth via V46 exposes the twenty-third connection electrode.

So far, preparation of a drive circuit layer on the base substrate is completed. On a plane parallel to the display substrate, the drive circuit layer may include multiple first type pixel circuits, the scan signal line, the reset signal line, the light emitting signal line, the data signal line, the initial signal line, and the first anode connection line to the fourth anode connection line. On a plane perpendicular to the display panel, the drive circuit layer may include the semiconductor layer, the first insulation layer, the first conductive layer, the second insulation layer, the second conductive layer, the third insulation layer, the third conductive layer, the fourth insulation layer, the transparent conductive layer, the first planarization layer, the fourth conductive layer, and the second planarization layer which are stacked sequentially on the base substrate.

In an exemplary implementation mode, the base substrate may be a flexible base substrate, or may be a rigid base substrate. The rigid base substrate may be, but is not limited to, one or more of glass and quartz. The flexible base substrate may be, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the first conductive layer, the second conductive layer, the third conductive layer, the fourth conductive layer, and the fifth conductive layer may be made of a metal material, such as any one or more of Argentum (Ag), Copper (Cu), Aluminum (Al), and Molybdenum (Mo), or an alloy material of the aforementioned metals, such as an Aluminum-Neodymium alloy (AlNd) or a Molybdenum-Niobium alloy (MoNb), and may be of a single-layer structure, or a multi-layer composite structure such as Mo/Cu/Mo.

In an exemplary embodiment, for the transparent conductive layer, such as Indium Tin Oxide (ITO) or Indium Zinc Oxide (IZO) may be adopted, or a multi-layer composite structure, such as ITO/Ag/ITO, may be adopted.

In an exemplary implementation mode, the first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first insulation layer may be referred to as a buffer layer, the second insulation layer may be referred to as a Gate Insulator (GI) layer, the third insulation layer may be referred to as an Interlayer Dielectric (ILD) layer, and the fourth insulation layer may be referred to as a Passivation (PVX) layer. The first planarization layer and the second planarization layer may be made of an organic material, such as resin. The semiconductor layer may be made of a material, such as an amorphous Indium Gallium Zinc Oxide material (a-IGZO), Zinc Oxynitride (ZnON), Indium Zinc Tin Oxide (IZTO), amorphous Silicon (a-Si), polycrystalline Silicon (p-Si), sexithiophene, or polythiophene, that is, the present disclosure is applicable to a transistor manufactured based on an oxide technology, a silicon technology, or an organic matter technology.

In an exemplary implementation mode, after preparation of the drive circuit layer is completed, a light emitting structure layer is prepared on the drive circuit layer, and a preparation process of the light emitting structure layer may include following operations.

(11) A pattern of an anode conductive layer is formed. In an exemplary implementation mode, forming the pattern of the anode conductive layer may include: depositing an anode conductive thin film on the base substrate on which the aforementioned patterns are formed, and patterning the anode conductive thin film using a patterning process to form the pattern of the anode conductive layer disposed on the second planarization layer, as shown in FIG. 17P and FIG. 16Q, wherein FIG. 17P is a schematic diagram of the pattern of the anode conductive layer of the light-transmitting display region provided in FIG. 14, and FIG. 17Q is a schematic diagram of the light-transmitting display region provided in FIG. 14 after the pattern of the anode conductive layer is formed.

In an exemplary implementation mode, for the anode conductive layer, a single-layer structure, such as Indium Tin Oxide (ITO) or Indium Zinc Oxide (IZO), may be adopted, or a multi-layer composite structure, such as ITO/Ag/ITO, may be adopted.

In an exemplary implementation mode, an anode of a first light emitting element 11b is electrically connected with the eighteenth connection electrode through the forty-first via, an anode of a first light emitting element 11a is electrically connected with the nineteenth connection electrode through the forty-second via, an anode of a second light emitting element 12b is electrically connected with the twentieth connection electrode through the forty-third via, an anode of a second light emitting element 12a is electrically connected with the twenty-first connection electrode through the forty-fourth via, an anode of a third light emitting element 13a is electrically connected with the twenty-second connection electrode through the forty-fifth via, and an anode of a third light emitting element 13b is electrically connected with the twenty-third connection electrode through the forty-sixth via.

In an exemplary implementation mode, the anode of the first light emitting element 11a is electrically connected with the anode of the first light emitting element 11b through the eighteenth connection electrode, the fourteenth connection electrode, the eleventh connection electrode, the thirteenth connection electrode, the tenth connection electrode, the first anode connection line, and the nineteenth connection electrode. The anode of the second light emitting element 12a is electrically connected with the anode of the second light emitting element 12b through the twentieth connection electrode, the sixteenth connection electrode, the ninth connection electrode, the first anode connection line, and the twenty-first connection electrode. The anode of the third light emitting element 13a is electrically connected with the anode of the third light emitting element 13b through the twenty-second connection electrode VL22, the third anode connection line, the twelfth connection electrode, the seventeenth connection electrode, and the twenty-third connection electrode VL23.

In an exemplary implementation mode, a subsequent preparation process may include: forming a pattern of a pixel definition layer at first, then forming an organic emitting layer using an evaporation process or an inkjet printing process, then forming a cathode on the organic emitting layer, and then forming an encapsulation structure layer, wherein the encapsulation structure layer may include a first encapsulation layer, a second encapsulation layer, and a third encapsulation layer which are stacked, the first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

The aforementioned structure shown in the present disclosure and the preparation process thereof are merely exemplary description. In an exemplary implementation mode, corresponding structures may be changed and patterning processes may be added or reduced according to actual needs, which is not limited here in the present disclosure.

In an exemplary implementation mode, the display panel of the present disclosure may be applied to a display apparatus with a pixel circuit, such as an OLED, a Quantum dot display (QLED), a Light Emitting Diode display (Micro LED or Mini LED), or a Quantum Dot Light Emitting Diode display (QDLED), which is not limited here in the present disclosure.

FIG. 18 is a schematic diagram of a structure of a display apparatus according to an embodiment of the present disclosure and FIG. 19 is a cross-sectional view of FIG. 18 along an A-A direction. As shown in FIG. 18 and FIG. 19, an embodiment of the present disclosure also provides a display apparatus, the display apparatus includes a display substrate 1 provided in any of the aforementioned embodiments and a photosensitive sensor 2, wherein the photosensitive sensor is located in a light-transmitting display region A1 of the display substrate 1 and located on a side away from a light emission side of the display substrate 1.

In an exemplary implementation mode, the display substrate may be a flexible OLED display substrate, a QLED display substrate, a Micro-LED display substrate, or a Mini-LED display substrate. The display apparatus may be any product or component with a display function such as an OLED display, a cell phone, a tablet, a television, a display, a laptop, a digital photo frame, and a navigator, which is not limited in the embodiments of the present disclosure.

In an exemplary implementation mode, when the light-transmitting display region A1 is rectangular, an area of an orthographic projection of the photosensitive sensor 2 on the base substrate is less than or equal to an area of an inscribed circle of the light-transmitting display region A1.

In an exemplary implementation mode, the photosensitive sensor 2 may include at least one of a camera module (e.g., a front camera module), a 3D structured light module (e.g., a 3D structured light sensor), a time of flight 3D imaging module (e.g., a time of flight sensor), an infrared sensing module (e.g., an infrared sensing sensor), and the like.

In an exemplary implementation mode, the front camera module is typically enabled when a user takes a selfie or makes a video call, and a display region of the display apparatus displays an image obtained by the selfie for the user to view. The front camera module includes, for example, a lens, an image sensor, an image processing chip, and the like. An optical image of a scene generated by the lens is projected onto a surface of the image sensor (the image sensor includes a Charge Coupled Device (CCD) and a Complementary Metal Oxide Semiconductor (CMOS)) and converted into electrical signals, which are converted into digital image signals through analog-to-digital conversion by the image processing chip, and then sent to a processor for processing, and the image of the scene is output on a display screen.

In an exemplary implementation mode, a 3D structured light sensor and a Time of Flight (ToF) sensor may be used for face recognition to unlock the display apparatus.

The display apparatus provided by the embodiment of the present disclosure may display an image in a light-transmitting display region to maintain display integrity of the whole display apparatus.

The accompanying drawings of the present disclosure only involve structures involved in the embodiments of the present disclosure, and other structures may be referred to conventional designs.

For the sake of clarity, a thickness and a size of a layer or a micro structure are enlarged in the accompanying drawings used for describing the embodiments of the present disclosure. It may be understood that when an element such as a layer, a film, a region, or a substrate is described as being "on" or "under" another element, the element may be "directly" located "on" or "under" the another element, or there may be an intermediate element.

Although implementation modes of the present disclosure are disclosed above, contents disclosed above are only implementation modes adopted for convenience of understanding the present disclosure, and are not intended to limit the present disclosure. Any of those skilled in the art of the present disclosure may make any modification and variation in a form and details of implementation without departing from the spirit and scope of the present disclosure. However, the scope of patent protection of the present disclosure shall still be subject to the scope defined in the appended claims.

**Claims**

1. A display substrate, comprising: a display region and a peripheral region at least partially surrounding the display region, wherein the display region comprises a light-transmitting display region and a conventional display region located on at least one side of the light-transmitting display region, and a light transmittance of the light-transmitting display region is greater than a light transmittance of the conventional display region;

   the display substrate comprises a base substrate and a plurality of light emitting elements and a plurality of pixel circuits located on one side of the base substrate, the plurality of light emitting elements comprise a plurality of first type light emitting elements located in the light-transmitting display region, the plurality of pixel circuits comprise a plurality of first type pixel circuits located in the light-transmitting display region, at least one first type pixel circuit among the plurality of first type pixel circuits is electrically connected with at least two first type light emitting elements emitting light of a same color, and the first type pixel circuit is configured to drive the at least two first type light emitting elements to emit light;
   an orthographic projection of the at least one first type pixel circuit on the base substrate is overlapped with an orthographic projection of the at least one first type light emitting element on the base substrate.

2. The display substrate according to claim 1, wherein the orthographic projection of the at least one first type pixel circuit on the base substrate is overlapped with an orthographic projection of at least partial first type light emitting element in at least two first type light emitting elements electrically connected with the at least one first type pixel circuit on the base substrate.

3. The display substrate according to claim 1 or 2, further comprising: a plurality of first signal lines, wherein the at least one first type pixel circuit is electrically connected with at least one first signal line;
   the plurality of first signal lines comprise at least one of following: a scan signal line, a reset signal line, an initial signal line, and a light emitting signal line.

4. The display substrate according to claim 3, wherein the first signal line comprises: a plurality of sub-signal lines; adjacent sub-signal lines of the first signal line are electrically connected through the first type pixel circuit electrically connected.

5. The display substrate according to claim 3 or 4, further comprising: a plurality of second signal lines, wherein the at least one first type pixel circuit is electrically connected with at least one second signal line;
   the plurality of second signal lines comprise at least one of following: a data signal line and a first power supply line; the plurality of data signal lines and the plurality of first power supply lines extend along a first direction; a data signal line and a first power supply line electrically connected with the first type pixel circuit are located between adjacent sub-signal lines of the first signal line, and orthographic projections of the data signal line and the first power supply line electrically connected with the first type pixel circuit on the base substrate are overlapped with an orthographic projection of the first type pixel circuit on the base substrate.

6. The display substrate according to claim 5, wherein an orthographic projection of at least one of the scan signal line, the reset signal line, the initial signal line, the light emitting signal line, the data signal line, and the first power supply line on the base substrate is partially overlapped with an orthographic projection of the first type light emitting element on the base substrate.

7. The display substrate according to claim 5 or 6, wherein the plurality of first type light emitting elements at least comprise a plurality of first light emitting elements emitting light of a first color, a plurality of second light emitting elements emitting light of a second color, and a plurality of third light emitting elements emitting light of a third color;

   an anode area of at least one first light emitting element among the plurality of first light emitting elements is greater than an anode area of at least one third light emitting element among the plurality of third light emitting elements, an anode area of at least one second light emitting element among the plurality of second light emitting elements is greater than the anode area of the at least one third light emitting element, and an anode area of at least one second light emitting element among the plurality of second light emitting elements is greater than an anode area of at least one first light emitting element among the plurality of first light emitting elements;
   the light of the first color is red light, the light of the second color is blue light, and the light of the third color is green light.

8. The display substrate according to claim 7, wherein the first type pixel circuit comprises: a plurality of transistors and at least one capacitor; on a direction perpendicular to the display substrate, the light-transmitting display region at least comprises a semiconductor layer, a first insulation layer, a first conductive layer, a second insulation layer, a second conductive layer, a third insulation layer, a third conductive layer, a fourth insulation layer, a transparent conductive layer, a first planarization layer, a fourth conductive layer, and a second planarization layer disposed on the base substrate;

the semiconductor layer at least comprises: active layers of the plurality of transistors of the first type pixel circuit;
the first conductive layer at least comprises: control electrodes of the plurality of transistors and a first electrode plate of the capacitor of the first type pixel circuit;
the second conductive layer at least comprises: a second electrode plate of the capacitor of the first type pixel circuit;
the third conductive layer at least comprises: first electrodes and second electrodes of the plurality of transistors of the first type pixel circuit and a plurality of connection electrodes;
the transparent conductive layer at least comprises: a plurality of first signal lines, a plurality of second signal lines, and a plurality of anode connection lines, and at least one anode connection line among the plurality of anode connection lines is electrically connected with at least one first type pixel circuit and anodes of at least two first type light emitting elements emitting light of a same color; and
the fourth conductive layer at least comprises: a plurality of signal connection lines.

9. The display substrate according to claim 8, wherein the plurality of first type light emitting elements are arranged in a following manner:
the plurality of third light emitting elements are arranged in an i-th row at a certain interval, the second light emitting elements and the first light emitting elements are alternately arranged in an adjacent row of the i-th row, the first light emitting elements and the second light emitting elements are alternately arranged in a j-th column, the plurality of third light emitting elements are arranged in an adjacent column of the j-th column at a certain interval, the first light emitting elements and the third light emitting elements are alternately arranged along a third direction, the second light emitting elements and the third light emitting elements are alternately arranged along a fourth direction, the third direction and the fourth direction intersect with the first direction and the second direction respectively, the first direction is a column direction, and the second direction is a row direction.

10. The display substrate according to claim 9, wherein the plurality of first type pixel circuits comprise: at least one first pixel circuit, at least one second pixel circuit, at least one third pixel circuit, and at least one fourth pixel circuit; the first pixel circuit is electrically connected with two of the first light emitting elements, the second pixel circuit is electrically connected with two of the second light emitting elements, the third pixel circuit is electrically connected with two of the third light emitting elements, the fourth pixel circuit is electrically connected with two of the third light emitting elements, and third light emitting elements electrically connected with the third pixel circuit and the fourth pixel circuit are different.

11. The display substrate according to claim 10, wherein the two of the first light emitting elements electrically connected with the first pixel circuit are located in a same row, the two of the second light emitting elements electrically connected with the second pixel circuit are located in a same row, the two of the third light emitting elements electrically connected with the third pixel circuit are located in a same row, and the two of the third light emitting elements electrically connected with the fourth pixel circuit are located in a same row.

12. The display substrate according to claim 11, wherein an orthographic projection of the first pixel circuit on the base substrate is partially overlapped with an orthographic projection of one of the first light emitting elements electrically connected on the base substrate;

an orthographic projection of the second pixel circuit on the base substrate is partially overlapped with an orthographic projection of a first light emitting element located between two of the second light emitting elements electrically connected on the base substrate;
an orthographic projection of the third pixel circuit on the base substrate is partially overlapped with an orthographic projection of a second light emitting element on the base substrate, the second light emitting element overlapped with the third pixel circuit is located in an adjacent row of a row where two of the third light emitting elements electrically connected with the third pixel circuit are located, and is located in a middle column of columns where two of the third light emitting elements electrically connected with the third pixel circuit are located; and

an orthographic projection of the fourth pixel circuit on the base substrate is partially overlapped with an orthographic projection of a second light emitting element on the base substrate, the second light emitting element overlapped with the fourth pixel circuit is located in an adjacent row of a row where two of the third light emitting elements electrically connected with the fourth pixel circuit are located, and is located in a middle column of columns where two of the third light emitting elements electrically connected with the fourth pixel circuit are located, and the second light emitting element overlapped with the third pixel circuit and the second light emitting element overlapped with the fourth pixel circuit are different light emitting elements.

13. The display substrate according to any one of claims 10 to 12, wherein the anode connection lines comprise: a first anode connection line, a second anode connection line, a third anode connection line, and a fourth anode connection line;

the first anode connection line is electrically connected with the first pixel circuit and the first light emitting element respectively, and at least part of the first anode connection line extends along the second direction; the second anode connection line is electrically connected with the second pixel circuit and the second light emitting element respectively, and at least part of the second anode connection line extends along the second direction; the third anode connection line is electrically connected with the third pixel circuit and the third light emitting element respectively, at least part of the third anode connection line extends along the second direction, and the third anode connection line is located between a data signal line and a first power supply line electrically connected with the third pixel circuit; the fourth anode connection line is electrically connected with the fourth pixel circuit and the third light emitting element respectively, at least part of the fourth anode connection line extends along the second direction, and the fourth anode connection line is located between a data signal line and a first power supply line electrically connected with the fourth pixel circuit.

14. The display substrate according to claim 13, wherein first power supply lines electrically connected with at least two adjacent first type pixel circuits located in a same column are disposed at intervals, and the first power supply lines disposed at intervals located in the same column are electrically connected through at least one signal connection line located in the fourth conductive layer;

data signal lines electrically connected with at least two adjacent first type pixel circuits located in a same column are disposed at intervals, and the data signal lines disposed at intervals located in the same column are electrically connected through at least one signal connection line located in the fourth conductive layer.

15. The display substrate according to claim 10, wherein the two of the first light emitting elements electrically connected with the first pixel circuit are arranged along the third direction, the two of the second light emitting elements electrically connected with the second pixel circuit are arranged along the fourth direction, the two of the third light emitting elements electrically connected with the third pixel circuit are located in a same column, and the two of the third light emitting elements electrically connected with the fourth pixel circuit are located in a same column.

16. The display substrate according to claim 15, wherein an orthographic projection of the first pixel circuit on the base substrate is partially overlapped with an orthographic projection of one of the first light emitting elements electrically connected on the base substrate;

an orthographic projection of the second pixel circuit on the base substrate is partially overlapped with an orthographic projection of one of the second light emitting elements electrically connected on the base substrate; an orthographic projection of the third pixel circuit on the base substrate is partially overlapped with an orthographic projection of one of the third light emitting elements electrically connected on the base substrate; and an orthographic projection of the fourth pixel circuit on the base substrate is partially overlapped with an orthographic projection of one of the third light emitting elements electrically connected on the base substrate, and the third light emitting element overlapped with the third pixel circuit and the third light emitting element overlapped with the fourth pixel circuit are different light emitting elements.

17. The display substrate according to claim 15 or 16, wherein the anode connection lines comprise: a first anode connection line, a second anode connection line, a third anode connection line, and a fourth anode connection line; the first anode connection line is electrically connected with the first pixel circuit and the first light emitting element respectively, and at least part of the first anode connection line extends along the first direction; the second anode connection line is electrically connected with the second pixel circuit and the second light emitting element respectively, and at least part of the second anode connection line extends along the first direction; the third anode connection line is electrically connected with the third pixel circuit and the third light emitting element respectively, at least part of the third anode connection line extends along the first direction, and the third anode connection line is located on a side of a first power supply line that is electrically connected with the third pixel circuit away from a data signal line; the fourth anode connection line is electrically connected with the fourth pixel circuit and the third light emitting element respectively, at least part of the fourth anode connection line extends along the first direction, and the fourth anode connection line is located on a side of a first power supply line that is electrically connected with the fourth pixel circuit away from a data signal line.

18. The display substrate according to claim 17, wherein data signal lines electrically connected with first type pixel circuits located in a same column are a same signal line, first power supply lines electrically connected with at least two adjacent first type pixel circuits located in a same column are disposed at intervals, and the first power supply lines disposed at intervals located in the same column are electrically connected through at least one signal connection line located in the fourth conductive layer.

19. The display substrate according to claim 18, wherein the transparent conductive layer further comprises: a power supply connection line, and at least part of the power supply connection line extends along the second direction; the power supply connection line is respectively electrically connected with first power supply lines electrically connected with two adjacent first type pixel circuits located in a same row, and the first power supply lines and the power supply connection line are electrically connected through a connection electrode located in the third conductive layer.

20. The display substrate according to claim 19, wherein for a same first type pixel circuit, the first power supply line comprises: a power supply main body portion extending along the first direction and a power supply connection portion extending along the second direction, the power supply connection portion is located on a side of the power supply main body portion away from the data signal line; the power supply connection line is electrically connected with a power supply connection portion of one first type pixel circuit and a power supply main body portion of the other first type pixel circuit in adjacent first type pixel circuits located in a same row respectively.

21. The display substrate according to claim 8, wherein the plurality of first type light emitting elements are arranged in a following manner: the plurality of second light emitting elements are arranged in a j-th column, the first light emitting elements and the third light emitting elements are alternately arranged in an adjacent column of the j-th column, the plurality of second light emitting elements are arranged in an i-th row, and the first light emitting elements and the third light emitting elements are disposed between adjacent second light emitting elements located in a same row.

22. The display substrate according to claim 21, wherein the plurality of first type pixel circuits comprise: at least one first pixel circuit, at least one second pixel circuit, and at least one third pixel circuit; wherein the first pixel circuit is electrically connected with two of the first light emitting elements, the second pixel circuit is electrically connected with two of the second light emitting elements, and the third pixel circuit is electrically connected with two of the third light emitting elements.

23. The display substrate according to claim 22, wherein the two of the first light emitting elements electrically connected with the first pixel circuit are located in a same row, the two of the second light emitting elements electrically connected with the second pixel circuit are located in a same row, and the two of the third light emitting elements electrically connected with the third pixel circuit are located in a same row.

24. The display substrate according to claim 23, wherein an orthographic projection of the first pixel circuit on the base substrate is partially overlapped with an orthographic projection of one of the first light emitting elements electrically connected on the base substrate;

an orthographic projection of the second pixel circuit on the base substrate is partially overlapped with an orthographic projection of one of the second light emitting elements electrically connected on the base substrate; and
an orthographic projection of the third pixel circuit on the base substrate is partially overlapped with an orthographic projection of one of the third light emitting elements electrically connected on the base substrate.

25. The display substrate according to claim 24, wherein at least two of the first light emitting element overlapped with the first pixel circuit, the second light emitting element overlapped with the second pixel circuit, and the third light emitting element overlapped with the third pixel circuit are adjacent.

26. The display substrate according to claim 23, wherein an orthographic projection of the first pixel circuit on the base substrate is partially overlapped with an orthographic projection of one of the first light emitting elements electrically connected on the base substrate;

an orthographic projection of the second pixel circuit on the base substrate is partially overlapped with an orthographic projection of one of the second light emitting elements electrically connected on the base substrate; and

an orthographic projection of the third pixel circuit on the base substrate is partially overlapped with an orthographic projection of the second light emitting element located between two of the third light emitting elements electrically connected with the third pixel circuit on the base substrate.

27. The display substrate according to claim 23, wherein an orthographic projection of the first pixel circuit on the base substrate is partially overlapped with an orthographic projection of a second light emitting element located between two of the first light emitting elements electrically connected with the first pixel circuit on the base substrate;

an orthographic projection of the second pixel circuit on the base substrate is partially overlapped with an orthographic projection of one of the second light emitting elements electrically connected on the base substrate; and

an orthographic projection of the third pixel circuit on the base substrate is partially overlapped with an orthographic projection of one of the third light emitting elements electrically connected on the base substrate.

28. The display substrate according to any one of claims 23 to 27, wherein the anode connection lines comprise: a first anode connection line, a second anode connection line, and a third anode connection line; the first anode connection line is electrically connected with the first pixel circuit and the first light emitting element respectively, and at least part of the first anode connection line extends along the second direction; the second anode connection line is electrically connected with the second pixel circuit and the second light emitting element respectively, and at least part of the second anode connection line extends along the second direction; the third anode connection line is electrically connected with the third pixel circuit and the third light emitting element respectively, and at least part of the third anode connection line extends along the second direction.

29. The display substrate according to claim 28, wherein data signal lines electrically connected with first type pixel circuits located in a same column are a same signal line, first power supply lines electrically connected with at least two adjacent first type pixel circuits located in a same column are disposed at intervals, and the first power supply lines disposed at intervals located in the same column are electrically connected through at least one signal connection line located in the fourth conductive layer.

30. The display substrate according to claim 1, wherein the plurality of light emitting elements further comprise a plurality of second type light emitting elements located in the conventional display region, and the plurality of pixel circuits further comprise a plurality of second type pixel circuits located in the conventional display region; at least one second type light emitting element among the plurality of second type light emitting elements is electrically connected with at least one second type pixel circuit among the plurality of second type pixel circuits, and an orthographic projection of the second type light emitting element on the base substrate is overlapped with an orthographic projection of a second type pixel circuit electrically connected on the base substrate.

31. A display apparatus, comprising a display substrate according to any one of claims 1 to 30.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15A

T12

T42  T22
T72
T32/C1

T52 T62

Y
↑
└→X

FIG. 15B

15a        15c        15b        15d

T33/
T44/        T34/
T54        T24/
T63

T1
T4 T2 T7
T3
T5 T6

Y
↑
└→X

FIG. 15C

VL1

C2

Y
X

FIG. 15D

15a          15c          15b          15d

T1
T4  T2, T7
T3
T5    T6

Y
X

FIG. 15E

15a  15c  15b  15d

V15  V1  V16
V7        V8
V3        V2  V10
V9        V6
V11  V14      V13
V4        V5  V12

T1
T4  T2  T7
T3
T5  T6

Y
X

FIG. 15F

VL9  VL10  V11

T14/T23
VL8  SL
VL2  VL3
T43  T13/T73
VL4  VL5
VL6  T64/T74
VL7
T53

Y
X

FIG. 15G

FIG. 15H

FIG. 15I

FIG. 15J

FIG. 15K

FIG. 15L

VDL1

VL14

VL17

VL15

VL16

VL18

VL19

VL20

VL21

VDL2

FIG. 15M

FIG. 15N

FIG. 15O

110 120 110 120

130 130

FIG. 15P

11a 13a 12a 13b 11b 13c 12b

13d

FIG. 15Q

15a      15b

T11

T41   T21    T71    15c

T51   T31    T61    15d

Y
└→ X

FIG. 16A

T12

T42    T22    T72
      T32/C1

T52 T62
Y
└→ X

FIG. 16B

15a      15b

     15c

T1
T4   T2    T7     15d
   T3
T5    T6

Y
└→ X

FIG. 16C

HL1

C2

Y
X

FIG. 16D

15a

15b

15c

T1
T4 T2 T7
T3
T5 T6

15d

Y
X

FIG. 16E

15a

15b

15c

V15 V1 V16
V7 V8
V9 V3 V2
V10
V6
V11 V14 V13
V4 V12
V5

15d

T1
T4 T2 T7
T3
T5 T6

Y
X

FIG. 16F

FIG. 16G

FIG. 16H

FIG. 16I

FIG. 16J

FIG. 16K

V32

V33

V35 V37

V34

V36

V38

Y
X

FIG. 16L

VDL

VL13

VL14

VL15

VL17

VL19

VL16

VL18

VL20

Y
X

FIG. 16M

FIG. 16N

V39
V41 V45
V40
V43
V46
V42
V44

Y
X

FIG. 16O

110
120
130
130

FIG. 16P

FIG. 16Q

FIG. 17A

EP 4 421 788 A1

T12

T42   T22   T72

T32/C1

T52   T62

Y
└→X

FIG. 17B

15c

15a

15b

T33/T44/T54   T34/T24/T63

Y
└→X

FIG. 17C

71

Y
X

FIG. 17D

15a

15c

15b

Y
X

FIG. 17E

15c

15a

V15  V1  V16
V7      V8
V3      V2
V9      V10
V14     V6
V11   V13  V12
15b     V4      V5

Y
└→X

**FIG. 17F**

VL12

T14/T23
VL8      SL
VL2        VL3
T43      T13/T73
VL4        VL5
VL6      T64/T74
VL9        VL7
VL11   T53
         VL10

Y
└→X

**FIG. 17G**

FIG. 17H

FIG. 17I

FIG. 17J

FIG. 17K

FIG. 17L

FIG. 17M

FIG. 17N

FIG. 17O

FIG. 17P

FIG. 17Q

FIG. 18

FIG. 19

## INTERNATIONAL SEARCH REPORT

| International application No. |
| --- |
| **PCT/CN2022/122729** |

**A. CLASSIFICATION OF SUBJECT MATTER**

G09G3/32(2016.01)i; G09F9/33(2006.01)i

According to International Patent Classification (IPC) or to both national classification and IPC

**B. FIELDS SEARCHED**

Minimum documentation searched (classification system followed by classification symbols)

IPC:G09G3 G09F9 H01L27 H01L51

Documentation searched other than minimum documentation to the extent that such documents are included in the fields searched

Electronic data base consulted during the international search (name of data base and, where practicable, search terms used)

CNABS, CNTXT, CNKI: 基板, 像素, 发光, 显示, 电路, 驱动, 同色, 颜色, 相同, 一样, 一致, 共用, 透光, 透明, 正投影, 交叠, 重叠; VEN, USTXT, WOTXT, EPTXT: display, panel, screen, substrate, pixel, light, same, color, colour, common, drive, circuit, transmitting, transparence, projection, overlap, overlay

**C. DOCUMENTS CONSIDERED TO BE RELEVANT**

| Category* | Citation of document, with indication, where appropriate, of the relevant passages | Relevant to claim No. |
| --- | --- | --- |
| E | WO 2023092351 A1 (BOE TECHNOLOGY GROUP CO., LTD. et al.) 01 June 2023 (2023-06-01)<br>  description, paragraphs 76-236, and figures 1-15 | 1-9, 21-22, 30-31 |
| X | CN 113763874 A (BOE TECHNOLOGY GROUP CO., LTD.) 07 December 2021 (2021-12-07)<br>  description, paragraphs 67-160, and figures 1-19 | 1-31 |
| X | CN 113362764 A (HEFEI VISIONOX TECHNOLOGY CO., LTD.) 07 September 2021 (2021-09-07)<br>  description, paragraphs 24-48, and figures 1-6 | 1-31 |
| X | CN 114914286 A (YUNGU (GU'AN) TECHNOLOGY CO., LTD.) 16 August 2022 (2022-08-16)<br>  description, paragraphs 54-129, and figures 1-17 | 1-31 |
| A | CN 112071887 A (HEFEI VISIONOX TECHNOLOGY CO., LTD.) 11 December 2020 (2020-12-11)<br>  entire document | 1-31 |

☑ Further documents are listed in the continuation of Box C.    ☑ See patent family annex.

| | | |
| --- | --- | --- |
| \* | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **16 June 2023** | **21 June 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2022/122729** |

**C.    DOCUMENTS CONSIDERED TO BE RELEVANT**

| Category* | Citation of document, with indication, where appropriate, of the relevant passages | Relevant to claim No. |
|---|---|---|
| A | US 2021118961 A1 (SAMSUNG DISPLAY CO., LTD.) 22 April 2021 (2021-04-22)<br>entire document | 1-31 |

Form PCT/ISA/210 (second sheet) (July 2022)

**INTERNATIONAL SEARCH REPORT**
Information on patent family members

International application No.

**PCT/CN2022/122729**

| Patent document cited in search report | | | Publication date (day/month/year) | Patent family member(s) | | | Publication date (day/month/year) |
|---|---|---|---|---|---|---|---|
| WO | 2023092351 | A1 | 01 June 2023 | None | | | |
| CN | 113763874 | A | 07 December 2021 | None | | | |
| CN | 113362764 | A | 07 September 2021 | CN | 113362764 | B | 30 August 2022 |
| CN | 114914286 | A | 16 August 2022 | None | | | |
| CN | 112071887 | A | 11 December 2020 | None | | | |
| US | 2021118961 | A1 | 22 April 2021 | US | 2022302222 | A1 | 22 September 2022 |
| | | | | US | 11387288 | B2 | 12 July 2022 |
| | | | | KR | 20210046114 | A | 28 April 2021 |

Form PCT/ISA/210 (patent family annex) (July 2022)